# EUROPÄISCHE PATENTSCHRIFT

(11) **EP 2 627 732 B1**
(45) Veröffentlichungstag und Bekanntmachung des Hinweises auf die Patenterteilung: **20.12.2017**
(21) Anmeldenummer: 11773192.7
(22) Anmeldetag: 14.10.2011
(51) Int. Cl.: C09K 11/06, H05B 33/10, C08K 5/00, C08K 5/3417, H01L 51/00, H01L 51/50

(54) **MATERIALIEN FÜR ORGANISCHE ELEKTROLUMINESZENZVORRICHTUNGEN**
MATERIALS FOR ORGANIC ELECTROLUMINESCENCE DEVICES
MATÉRIAUX POUR DES DISPOSITIFS ÉLECTROLUMINESCENTS ORGANIQUES

(30) Priorität: 14.10.2010 DE 102010048498
(43) Veröffentlichungstag der Anmeldung: 21.08.2013
(60) Teilanmeldung: 14001815.1
(73) Patentinhaber: Merck Patent GmbH, 64293 Darmstadt (DE)
(72) Erfinder: KRÜGER, Hartmut, 12163 Berlin (DE); WEDEL, Armin, 14513 Teltow (DE); SALERT, Beatrice, 14478 Potsdam (DE); KREISSL, Stefanie, 14715 Milower Land OT Jerchel (DE); THESEN, Manuel, 10627 Berlin (DE); ANEMIAN, Remi, 60316 Frankfurt (DE); EBERLE, Thomas, 76829 Landau (DE)
(86) Internationale Anmeldenummer: PCT/EP2011/005179
(87) Internationale Veröffentlichungsnummer: WO 2012/048900

(56) Entgegenhaltungen:
- US-A1- 2007 176 147
- Xiong Gong: "Electrophosphorescence from a polymer guest-host system with an iridium complex as guest: förster energy transfer and charge trapping", Adv. Funct. Mater., Bd. 13, Nr. 6 1. Januar 2003 (2003-01-01), Seiten 439-444, XP55012421, Gefunden im Internet: URL:http://onlinelibrary.wiley.com/store/1 0.1002/adfm.200304334/asset/439_ftp.pdf?v= 1&t=gv3rga3w&s=356d8a50003bf540ce6fda8966a e5509bf9860ea [gefunden am 2011-11-17]
- Xiong Gong: "High - efficiency polymer based electrophophorescent devices", Adv. Mater., Bd. 14, Nr. 8 1. Januar 2002 (2002-01-01), Seiten 581-585, XP55012454, Gefunden im Internet: URL:http://onlinelibrary.wiley.com/store/1 0.1002/1521-4095(20020418)14:8<581::AID-AD MA581>3.0.CO;2-B/asset/581_ftp.pdf?v=1&t=g v3wu3m1&s=730f2349da07902da58308c84538c9a6 516b52f7 [gefunden am 2011-11-17]
- SE YOUNG OH ET AL: "Characteristics of Polymer Light Emitting Diode Using a Phosphorescent Terpolymer Containing Perylene, Triazine and Ir(ppy)3 Moieties in the Polymer Side Chain", MOLECULAR CRYSTALS AND LIQUID CRYSTALS, TAYLOR & FRANCIS INC, US, Bd. 458, 1. Januar 2006 (2006-01-01), Seiten 227-235, XP008127257, ISSN: 1542-1406, DOI: 10.1080/15421400600932405
- BEHL M AND ZENTEL R: "Block Copolymers Build-up of Electron and Hole Transport Materials", MACROMOLECULAR CHEMISTRY AND PHYSICS, WILEY-VCH VERLAG, WEINHEIM, DE, Bd. 205, Nr. 12, 12. August 2004 (2004-08-12), Seiten 1633-1643, XP008127225, ISSN: 1022-1352, DOI: 10.1002/MACP.200400110

## Beschreibung

Die vorliegende Erfindung betrifft einen Blend umfassend
a) mindestens ein Polymer oder Copolymer oder eine Mischung mehrerer Polymere und/oder Copolymere, die eine Hauptkette sowie eine Seitenkette umfassen, wobei in mindestens einer Seitenkette eine Struktureinheit der folgenden Formel (I) enthalten ist 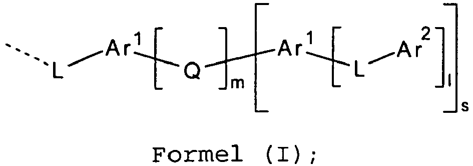 die verwendeten Symbole und Indizes sind dabei wie weiter unten stehend definiert;
b) mindestens ein Host-Molekül, das elektronen- oder lochtransportierende Funktionalität aufweist, sowie
c) mindestens ein Emittermolekül.

Die Erfindung ist ferner auf Formulierungen, enthaltend die zuvor genannten Blends, Verwendungen hiervon, polymerisierbare Verbindungen, aus denen sich die Polymere oder Copolymere des erfindungsgemäßen Blends herstellen lassen sowie elektronische Vorrichtungen oder Bauteile, insbesondere organische Elektrolumineszenzvorrichtungen gerichtet, welche den erfindungsgemäßen Blend enthalten.

Der Aufbau organischer Elektrolumineszenzvorrichtungen (OLEDs), in denen organische Halbleiter als funktionelle Materialien eingesetzt werden, ist beispielsweise in der US 4,539,507, der US 5,151,629, der EP 0 676 461 und der WO 98/27136 beschrieben. Eine Entwicklung im Bereich der organischen Elektrolumineszenzvorrichtungen sind phosphoreszierende OLEDs. Diese weisen aufgrund der höheren erreichbaren Effizienz im Vergleich zu fluoreszierenden OLEDs deutliche Vorteile auf.

Allerdings gibt es bei phosphoreszierenden OLEDs noch Verbesserungsbedarf. Dies gilt insbesondere für die Effizienz und die Lebensdauer der Vorrichtungen.

Gemäß dem Stand der Technik werden elektronenleitende Materialien, unter anderem Ketone (z.B. gemäß der WO 04/093207) oder Triazinderivate (z.B. gemäß der DE 100 2008 036 982) als Matrixmaterialien für phosphoreszierende Emitter verwendet. Insbesondere mit Ketonen werden niedrige Betriebsspannungen und lange Lebensdauern erzielt, was diese Verbindungsklasse zu einem sehr interessanten Matrixmaterial macht. Allerdings besteht bei Verwendung dieser Matrixmaterialien ebenso wie bei anderen Matrixmaterialien noch Verbesserungsbedarf, insbesondere in Bezug auf die Effizienz und die Lebensdauer der Vorrichtungen.

Aus dem Stand der Technik sind weiterhin organische Elektrolumineszenzvorrichtungen bekannt, welche einen phosphoreszierenden Emitter dotiert in eine Mischung aus zwei Matrixmaterialien enthalten.

In der US 2007/0252516 werden phosphoreszierende organische Elektrolumineszenzvorrichtungen offenbart, welche eine Mischung aus einem loch- und einem elektronenleitenden Matrixmaterial aufweisen. Für diese OLEDs wird eine verbesserte Effizienz offenbart. Ein Einfluss auf die Lebensdauer ist nicht erkennbar.

In der US 2007/0099026 werden weiß emittierende organische Elektrolumineszenzvorrichtungen offenbart, wobei die grün bzw. rot emittierende Schicht einen phosphoreszierenden Emitter und eine Mischung aus einem loch- und einem elektronenleitenden Matrixmaterial aufweist. Als lochleitende Materialien sind unter anderem Triarylamin- und Carbazolderivate angegeben.

Als elektronenleitende Materialien sind unter anderem Aluminium- und Zinkverbindungen, Oxadiazolverbindungen und Triazin- bzw. Triazolverbindungen angegeben. Auch für diese OLEDs sind noch weitere Verbesserungen wünschenswert.

Die WO 2008/086851 A1 offenbart Carbazolverbindungen sowie deren Verwendung in organischen Elektrolumineszenzvorrichtungen, insbesondere als Matrixmaterial in phosphoreszierenden Vorrichtungen, wobei ebenfalls Ketonverbindungen anwesend sein können.

Die WO 2005/040302 A1 offenbart organische Halbleiter umfassend ein Polymer, Verbindungen mit L=X-Struktureinheiten und Triplett-Emitterverbindungen. Die darin genannten Verbindungen weisen eine gute Löslichkeit auf und sind synthetisch gut zugänglich.

In Xiong Gong et al, Adv. Funct. Mater., 2003, 13, 6, 439-444 wird eine Mischung enthaltend einen Emitter, (Ir(DPPF)₃ bzw. Ir(DPF)₃), ein Elektronentransportmaterial (PBD) sowie ein Seitenkettenpolymer (PVK) beschrieben, wobei PVK eine Carbazol-Seitenkette enthält.

In Xion Gong et al, Adv. Mater., 2002, 14, 8, 581-585 wird eine Mischung enthaltend einen Emitter, (Ir(DPPF)₃ bzw. Ir(DPF)₃), ein Elektronentransportmaterial (PBD) sowie ein Seitenkettenpolymer (PVK) beschrieben, wobei PVK eine Carbazol-Seitenkette enthält.

Die US 2007/176147 A1 offenbart Mischungen enthaltend mindestens ein Polymer, mindestens eine Struktureinheit, die mindestens Silicium, Germanium, Zinn und/oder Blei enthält und mindestens einen Triplett-Emitter.

In Se Young OH et al, Mol. Cryst. Liq. Crystal, 2006, 458, 227-235 wird ein nicht-konjugiertes phosphoreszierendes Terpolymer PPPMA-co-DTPM-co-Ir(ppy)₃ beschrieben, enthaltend Perylen, Triazin und Ir(ppy)₃-Struktureinheiten in der Polymerseitenkette.

In M. Behl et al, Macromol. Chem. Phys., 2004, 205, 12, 1633-1643 wird die Synthese einiger Monomere beschrieben, die Triphenyl-1,3,5-triazin-Seitengruppen tragen sowie Block-Copolymere, diese enthaltend.

Trotzdem besteht weiterhin Verbesserungsbedarf hinsichtlich Löslichkeit für lösungsprozessierbare Systeme sowie hinsichtlich Lebensdauer und Effizienz.

Die der Erfindung zugrunde liegende technische Aufgabe war deshalb die Bereitstellung einer Mischung, welche sich einfach aus Lösung verarbeiten lässt und in einer organischen Elektrolumineszenzvorrichtung zu einer sehr hohen Lebensdauer und guten Effizienz führt.

Die Aufgabe wird erfindungsgemäß gelöst durch einen Blend enthaltend
a) mindestens ein Polymer oder Copolymer oder eine Mischung mehrerer Polymere und/oder Copolymere, wobei das mindestens eine Polymer oder Copolymer in den Seitenketten mindestens eine Struktureinheit der folgenden Formel (I) enthält 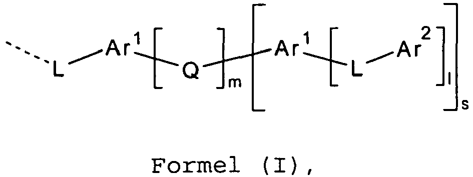 wobei die gestrichelte Linie die Verbindung zum Grundgerüst des Polymers oder Copolymers darstellt, und die übrigen verwendeten Symbole und Indices die folgenden Bedeutungen aufweisen:
   - L: ist bei jedem Auftreten gleich oder verschieden eine kovalente Einfachbindung oder eine geradkettige Alkylengruppe mit 1 bis 20 C-Atomen oder eine verzweigte oder cyclische Alkylengruppe mit 3 bis 20 C-Atomen, die jeweils mit einem oder mehreren Resten R¹ substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, vorzugsweise eine kovalente Einfachbindung;
   - Ar¹: ist bei jedem Auftreten gleich oder ver-schieden, ein bivalentes, mono- oder polycyclisches, aromatisches oder heteroaromatisches Ringsystem mit 5 bis 60 aromatischen Ringatomen, welches mit einem oder mehreren Resten R¹ substituiert sein kann;
   - Ar²: ist bei jedem Auftreten gleich oder verschieden, ein mono- oder polycyclisches, aromatisches oder heteroaromatisches Ringsystem mit 5 bis 60 aromatischen Ringatomen, welches mit einem oder mehreren Resten R¹ substituiert sein kann;
   - Q: ist eine Einheit, ausgewählt aus der Gruppe bestehend aus einer Gruppe -X(=A)-, mit A = O, S, Se oder Te, sowie mono- oder polycyclischen aromatischen Ringsystemen mit 6 bis 60 aromatischen Kohlenstoffatomen oder mono- oder polycyclischen heteroaromatischen Ringsystemen mit 2 bis 50 aromatischen Kohlenstoffatomen;
   - m: ist 0, 1, 2 oder 3, vorzugsweise 0 oder 1;
   - l: ist 0, 1, 2 oder 3;
   - s: ist 1 im Falle von Q = -X(=A)-; ist 1 bis 5, bevorzugt 1 bis 3 für den Fall, dass Q ausgewählt ist aus der Gruppe bestehend aus mono- oder polycyclischen aromatischen Ringsystemen mit 6 bis 60 aromatischen Kohlenstoffatomen oder mono- oder polycyclischen heteroaromatischen Ringsystemen mit 2 bis 50 aromatischen Kohlenstoffatomen; und ist 1 oder 2 im Falle m = 0;
   - R¹: ist bei jedem Auftreten gleich oder verschieden D, F, Cl, Br, I, N(Ar³)₂, CN, NO₂, Si(R)₃, B(OR²)₂, C(=O)Ar³, P(=O)(Ar³)₂, S(=O)Ar³, S(=O)₂Ar³, -CR²=CR²(Ar³), ein mono- oder polycyclisches, aromatisches oder heteroaromatisches Ringsystem mit 5 bis 60 aromatischen Ringatomen, Tosylat, Triflat, OSO₂R², eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, oder eine Kombination dieser Systeme; wobei auch zwei oder mehrere benachbarte Substituenten R¹ miteinander über eine kovalente Einfachbindung oder eine bivalente Gruppe Z verknüpft sein können;
   - X: ist aus der Gruppe ausgewählt, die aus C, P(Ar⁴), S und SO besteht, vorzugsweise C oder P(Ph);
   - R²: ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei eine oder mehrere nicht benachbarte CH₂-Gruppen durch NH, O oder S ersetzt sein können und wobei ein oder mehrere H-Atome durch F ersetzt sein können, oder ein mono- oder polycylisches, aromatisches oder heteroaromatisches Ringsystem mit 5 bis 20 aromatischen Ringatomen, das jeweils durch einen oder mehrere Reste R³ substituiert sein kann; wobei auch zwei oder mehrere Substituenten R² miteinander über eine kovalente Einfachbindung oder eine bivalente Gruppe Z verknüpft sein können;
   - R³: ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei eine oder mehrere nicht benachbarte CH₂-Gruppen durch NH, O oder S ersetzt sein können und wobei ein oder mehrere H-Atome durch F ersetzt sein können; wobei auch zwei oder mehrere Substituenten R³ miteinander über eine kovalente Einfachbindung oder eine bivalente Gruppe Z verknüpft sein können;
   - Ar³: und Ar⁴ sind bei jedem Auftreten gleich oder verschieden ein mono- oder polycyclisches, aromatisches oder heteroaromatisches Ringsystem mit 5 bis 60 aromatischen Ringatomen, welches mit einem oder mehreren Resten R³ substituiert sein kann;
   - Z: stellt eine bivalente Gruppe -(CR⁴₂)_{q}- dar;
   - q: ist gleich 1, 2, 3, 4 oder 5;
   - R⁴: ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei eine oder mehrere nicht benachbarte CH₂-Gruppen durch NH, O oder S ersetzt sein können und wobei ein oder mehrere H-Atome durch F ersetzt sein können.
b) mindestens ein Host-Molekül, das elektronen- oder lochtransportierende Funktionalität aufweist, sowie
c) mindestens ein Emittermolekül.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt.

Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1, 2, 5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Für den Fall, dass L eine kovalente Einfachbindung darstellt, sind beispielsweise die Reste Ar¹ und Ar² gemäß Formel I direkt miteinander verbunden. Alternativ oder zusätzlich hierzu kann im Falle, dass L eine kovalente Einfachbindung darstellt, auch der Rest Ar¹ gemäß Formel I direkt an das Grundgerüst des Polymers angebunden sein. Für den Fall, dass m = 0 ist, erfolgt ebenso eine direkt kovalente Verknüpfung der beiden Gruppen Ar¹ gemäß Formel I.

Mit den neuen Blends aus den Polymeren bzw. Copolymeren mit als Seitengruppe angebundener Elektronen- oder Lochtransportstruktur und den korrespondierenden, löslichen kleinen Molekülen mit Loch- oder Elektronentransporteigenschaften können gegenüber reinen Polymerblends aus Seitengruppenpolystyrenen mit einer bevorzugt elektronentransportierenden oder lochtransportierenden Seitengruppe, die den Stand der Technik darstellen, überraschenderweise deutliche Zuwächse in Performance, wie z.B. Stromeffizienz, und Lebensdauer erzielt werden. Die genannten Matrixmaterialien werden dabei jeweils mit einem Emitter bestehend aus einem Übergangsmetallkomplex dotiert. Gegenüber reinen Blends aus loch- und elektronentransportierenden kleinen Molekülen werden deutliche Vorteile hinsichtlich einer deutlich verbesserten Verfilmung erzielt. Weiterhin führt der Blend aus Polymer und kleinem Molekül dazu, dass der Übergangsmetallkomplex in einer günstigen Morphologie, bevorzugt in einer Komponente des Blends, angeordnet wird, so dass Quenching-Prozesse deutlich unterdrückt und somit die Lichtausbeute der Device gesteigert werden kann. Durch das Einmischen von kleinen Molekülen in beispielsweise ein Polystyrenseitengruppenpolymer wird die Kristallisationstendenz Ersterer zuverlässig unterdrückt.

Die Struktureinheit der Formel (I) ist vorzugsweise eine elektronen- oder lochtransportierende Einheit.

In der vorliegenden Anmeldung sind unter dem Begriff Polymer bzw. Copolymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 20 bis 5000 und insbesondere 50 bis 2000 Struktureinheiten auf. Die erfindungsgemäßen oligomeren Verbindungen weisen vorzugsweise 3 bis 9 Struktureinheiten auf.

Der Verzweigungs-Faktor der Polymere liegt dabei zwischen 0 (lineares Polymer, ohne Verzweigungsstellen) und 1 (vollständig verzweigtes Dendrimer).

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, S. 885) beschrieben ist.

Unter einem elektronischen Bauteil, insbesondere einer organischen Elektrolumineszenzvorrichtung, wird eine Vorrichtung verstanden, welche Anode, Kathode und mindestens eine emittierende Schicht, welche zwischen der Anode und der Kathode angeordnet ist, enthält, wobei mindestens eine Schicht zwischen der Anode und der Kathode mindestens eine organische bzw. metallorganische Verbindung enthält. Dabei enthält vorzugsweise die emittierende Schicht mindestens ein erfindungsgemäßes Polymer, das in den Seitenketten mindestens eine Struktureinheit der Formel (I) enthält, entweder als Matrixmaterial oder, sofern das Polymer auch emittierende Einheiten aufweist, als emittierendes Material. Eine organische Elektrolumineszenzvorrichtung muss nicht notwendigerweise nur Schichten enthalten, welche aus organischen oder metallorganischen Materialien aufgebaut sind. So ist es auch möglich, dass eine oder mehrere Schichten anorganische Materialien enthalten oder ganz aus anorganischen Materialien aufgebaut sind.

Eine fluoreszierende Verbindung im Sinne der vorliegenden Anmeldung ist eine Verbindung, welche bei Raumtemperatur Lumineszenz aus einem angeregten Singulett-Zustand zeigt. Im Sinne der vorliegenden Anmeldung sollen insbesondere alle lumineszierenden Verbindungen, welche keine Schweratome enthalten, also keine Atome mit einer Ordnungszahl größer 36, als fluoreszierende Verbindungen angesehen werden.

Eine phosphoreszierende Verbindung im Sinne der vorliegenden Anmeldung ist eine Verbindung, welche bei Raumtemperatur Lumineszenz aus einem angeregten Zustand mit höherer Spinmultiplizität zeigt, also aus einem Zustand mit einer Spinquantenzahl S größer oder gleich 1. Bevorzugt ist unter einer phosphoreszierenden Verbindung im Sinne der vorliegenden Erfindung eine Verbindung zu verstehen, die Licht und/oder Strahlung aus einem angeregten Triplett (S=1, (2S+1)=3) und/oder aus einem angeregten Quintett (S=2, (2S+1)=5) Zustand emittiert, ganz bevorzugt aus einem angeregten Triplett-Zustand. Im Sinne der vorliegenden Anmeldung sollen insbesondere alle lumineszierenden Verbindungen, welche ein Übergangsmetall enthalten, vorzugsweise Verbindungen enthaltend Cu oder andere Übergangsmetalle mit einer Ordnungszahl größer als 36 und besonders bevorzugt Verbindungen enthaltend Cu, Pt oder Ir als phosphoreszierende Verbindungen angesehen werden.

Im Rahmen der vorliegenden Anmeldung wird unter einer geradkettigen, verzweigten oder cyclischen Alkylgruppe eine Alkyl-, Alkenyl- und Alkinylgruppen mit vorzugsweise 1 bis 40 C-Atomen, besonders bevorzugt 1 bis 20 C-Atomen, bzw. 3 bis 40 C-Atomen, insbesondere 3 bis 20 C-Atomen verstanden. Cyclische Alkylgruppen können mono-, bi- oder polycyclische Alkylgruppen sein. Einzelne -CH- oder -CH₂-Gruppen können durch N, NH, O oder S ersetzt sein. Bevorzugt sind die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl und Octinyl.

Unter einer Alkylengruppe versteht man in der vorliegenden Anmeldung eine wie oben definierte Alkylgruppe, bei der zwei Wasserstoffreste nicht vorhanden sind und an deren Stelle die weitere Bindung ist.

Bevorzugte aromatische Ringsysteme sind z. B. Benzol, Biphenyl, Terphenyl, Naphthalin, Anthracen, Binaphthyl, Phenanthren, Benzanthracen, Dihydrophenanthren, Pyren, Dihydropyren, Chrysen, Perylen, Tetracen, Pentacen, Benzpyren, Fluoren, Spirobifluoren und Inden.

Unter einem mono- oder polycyclischen, heteroaromatischen Ringsystem versteht man im Sinne der vorliegenden Anmeldung vorzugsweise ein heteroaromatisches Ringsystem mit 5 bis 40 Ringatomen, besonders bevorzugt 5 bis 30, insbesondere 5 bis 14 Ringatomen. Das heteroaromatische Ringsystem enthält mindestens ein Heteroatom ausgewählt aus N, 0 und S (die verbleibenden Atome sind Kohlenstoff). Unter einem heteroaromatischen Ringsystem soll zudem ein System verstanden werden, das nicht notwendigerweise nur aromatische oder heteroaromatische Gruppen enthält, sondern in dem auch mehrere aromatische bzw. heteroaromatische Gruppen durch eine kurze nicht-aromatische Einheit (< 10 % der von H verschiedenen Atome, vorzugsweise < 5 % der von H verschiedenen Atome), wie beispielsweise sp³-hybridisierter C, O, N, etc., oder eine CO-Gruppe unterbrochen sein können. Diese heteroaromatischen Ringsysteme können monocyclisch oder polycyclisch sein, d.h. sie können einen Ring (z. B. Pyridyl) oder zwei oder mehr Ringe aufweisen, welche auch kondensiert oder kovalent verknüpft sein können, oder eine Kombination von kondensierten und verknüpften Ringen beinhalten.

Bevorzugte heteroaromatische Ringsysteme sind z. B. 5-gliedrige Ringe, wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder kondensierte Gruppen wie Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno-[3,2b]thiophen, Dithienothiophen, Isobenzothiophen, Dibenzothiophen, Benzothiadiazothiophen oder Kombinationen dieser Gruppen. Besonders bevorzugt sind Imidazol, Benzimidazol und Pyridin.

Unter einem bivalenten mono- oder polycyclischen, aromatischen oder heteroaromatischen Ringsystem versteht man ein wie oben definiertes mono- oder polycyclisches, aromatisches oder heteroaromatisches Ringsystem bei dem ein Wasserstoffrest nicht vorhanden ist und an dieser Stelle die weitere Bindung sitzt.

Unter einer Aryloxy- bzw. Heteroaryloxygruppe mit 5 bis 60 aromatischen Ringatomen versteht man eine Gruppe, die über ein O-Atom ein wie oben definiertes mono- oder polycylisches, aromatisches oder heteroaromatisches Ringsystem mit 5 bis 60 aromatischen Ringatomen trägt.

In einer weiteren Ausführungsform der vorliegenden Erfindung ist L in der Struktureinheit der Formel (I) vorzugsweise eine kovalente Einfachbindung im Sinne der oben angegebenen Definition.

In einer bevorzugten Ausführungsform der vorliegenden Erfindung Q ausgewählt aus der Gruppe bestehend aus - X(=O)-; 1,3,5-Triazylen und/oder Resten, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol, wobei das 1,3,5-Triazylen oder die Reste jeweils an beliebiger Position mit einem oder mehreren Resten R¹, R² und/oder R³ substituiert sein können und/oder über beliebige Positionen am Aromaten bzw. Heteroaromaten verknüpft sein können; und s ist 1 im Falle von Q =-X(=O)-; ist 1 oder 2 im Falle Q = 1,3,5-Triazylen; oder ist 1, 2, 3, 4 oder 5 für den Fall, dass Q ausgewählt ist aus den oben angegebenen Resten. Besonders bevorzugte Reste Q sind dabei -C(=O)- und 1,3,5-Triacylen bzw. die zuvor genannten Reste.

In einer weiteren bevorzugten Ausführungsform der vorliegenden Erfindung sind bei jedem Auftreten unabhängig voneinander Ar¹ oder Ar² oder Ar¹ und Ar² ausgewählt sind aus der Gruppe bestehend aus Resten, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol, die jeweils an beliebiger Position mit einem oder mehreren Resten R¹, R² und/oder R³ substituiert sein können und/oder über beliebige Positionen am Aromaten bzw. Heteroaromaten verknüpft sein können.

Dabei weisen die Reste Ar¹ je zwei Einfachbindungen zu den in der Formel I benachbart dargestellten Strukturelementen, also L und/oder Q auf; der Rest Ar² ist mit der Gruppierung L mit einer Einfachbindung verbunden. Die Einfachbindungen können von Ar¹ und/oder Ar² von beliebiger Position ausgehen.

In einer weiteren Ausführungsform der vorliegenden Erfindung ist m in der Struktureinheit der Formel (I) vorzugsweise gleich 0 oder 1.

Ebenso ist für den Fall m = 1 in einer weiteren bevorzugten Ausführungsform X in der Struktureinheit gemäß Formel (I) gleich C oder P(Ph) (Ph = Phenyl), besonders bevorzugt C.

Bevorzugte Struktureinheiten der Formel (I) sind im Folgenden abgebildet:

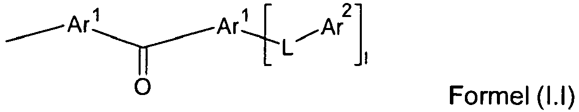

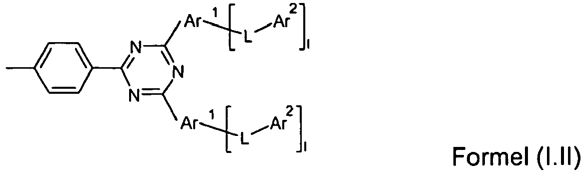

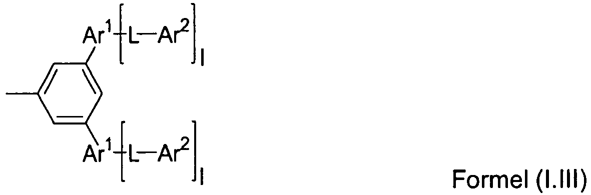

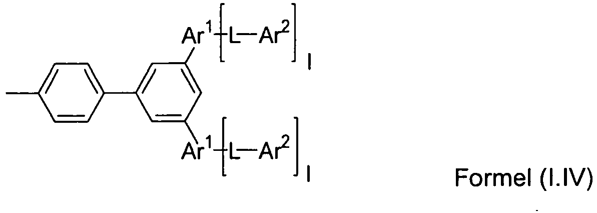

Besonders bevorzugte Struktureinheiten der Formel (I) sind im Folgenden abgebildet:

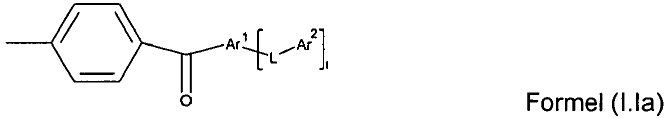

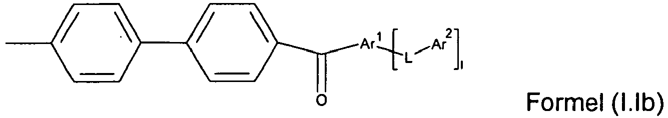

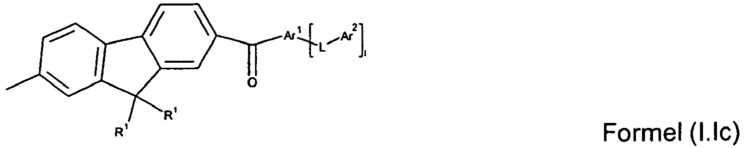

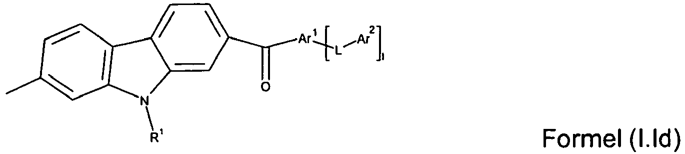

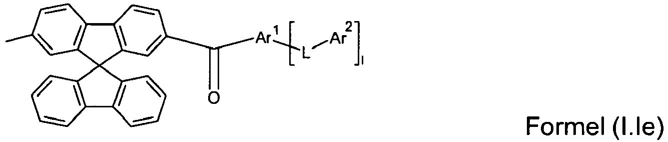

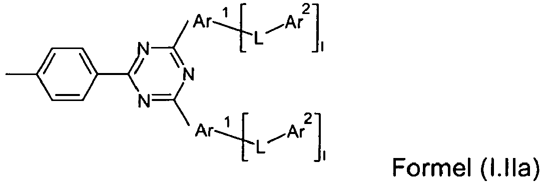

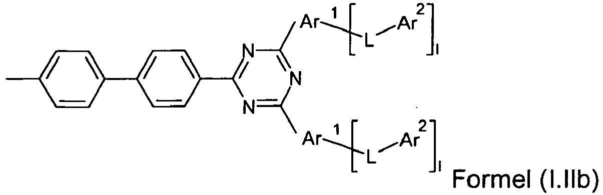

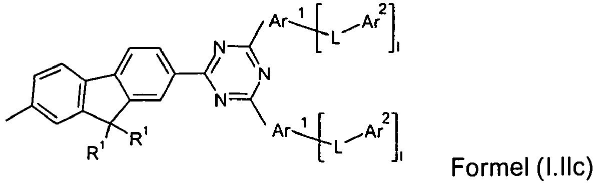

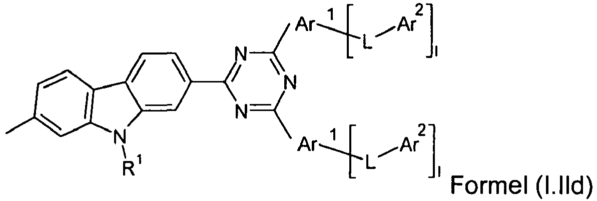

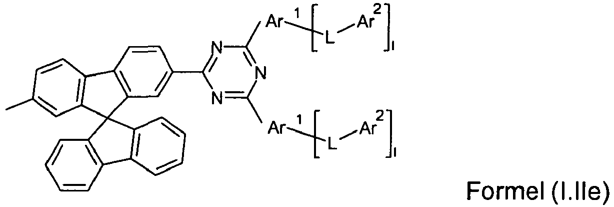

Insbesonders bevorzugte Struktureinheiten der Formel (I) sind im Folgenden abgebildet:

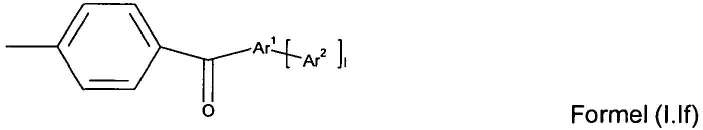

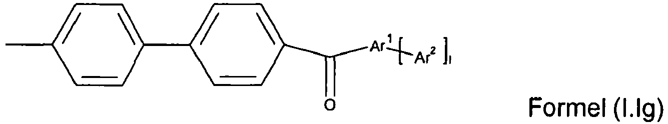

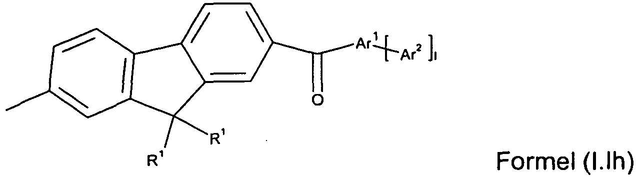

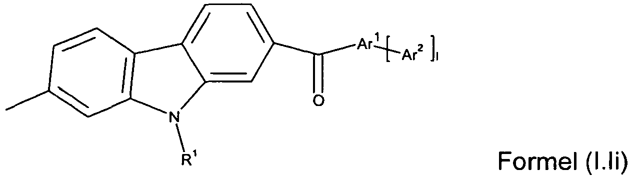

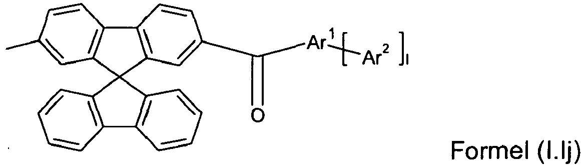

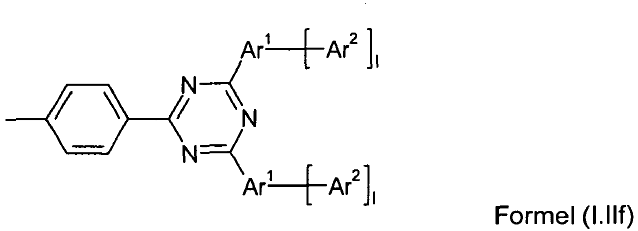

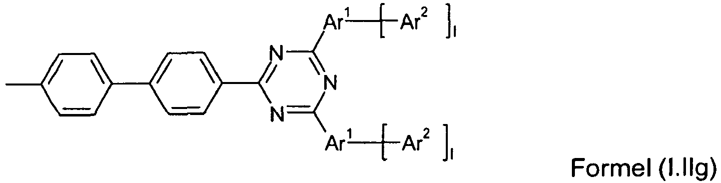

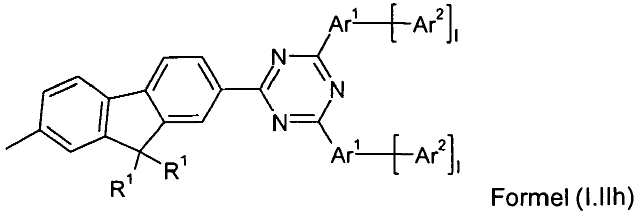

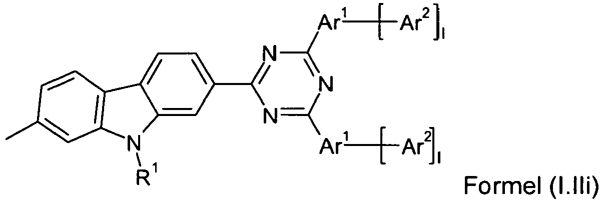

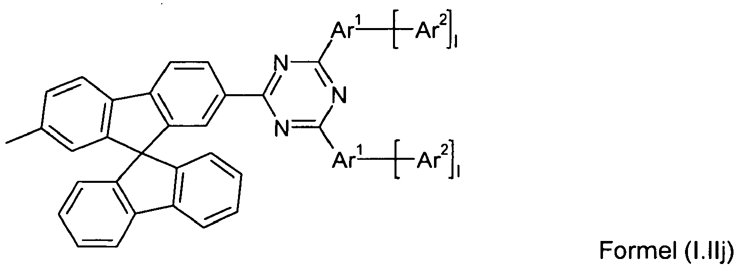

In den oben dargestellten, bevorzugten, besonders bevorzugten und insbesondere bevorzugten Struktureinheiten können neben den Gruppen Ar¹ und Ar² auch die anderen aromatischen und heteroaromatischen Ringsysteme durch einen oder mehrere Reste R¹ substituiert sein.

Insbesondere ist es bevorzugt, wenn die Struktureinheit der Formel (I) ausgewählt ist aus der Gruppe bestehend aus
a) elektronentransportierende Substituenten aufweisenden Struktureinheiten gemäß den folgenden allgemeinen Formeln (II) und/oder (III) 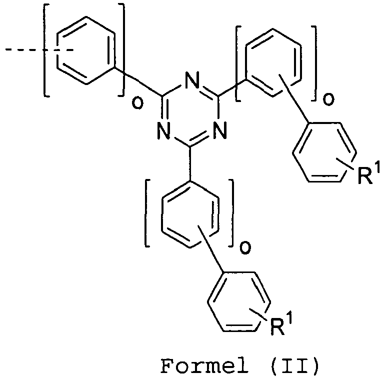 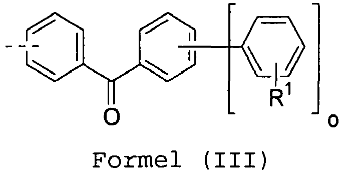
b) und/oder lochtransportierende Substituenten aufweisende Struktureinheiten gemäß den allgemeinen Formeln (IV) und/oder (V) 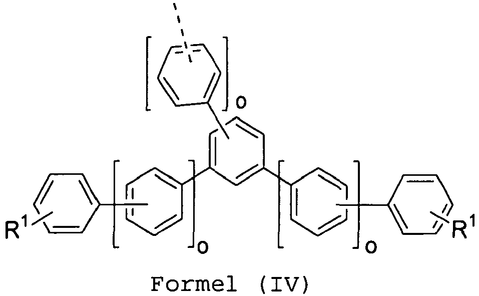 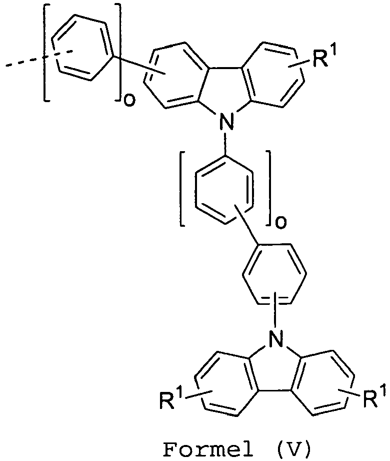
wobei die gestrichelte Linie die Verbindung zum Grundgerüst des Polymers oder Copolymers darstellt, R¹ die zuvor genannte Bedeutung aufweist und jeweils unabhängig voneinander o = 0 oder 1 bis 10 ist.

Besonders bevorzugte elektronentransportierende Substituenten aufweisende Struktureinheiten sind dabei ausgewählt aus der Gruppe bestehend aus den nachfolgenden Struktureinheiten:

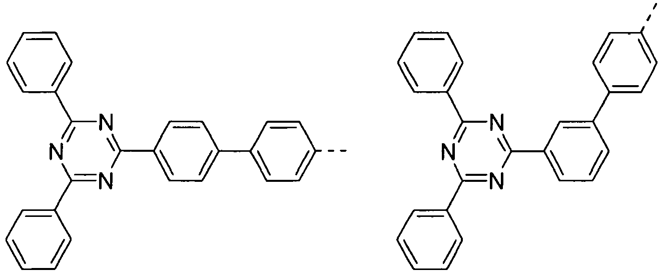

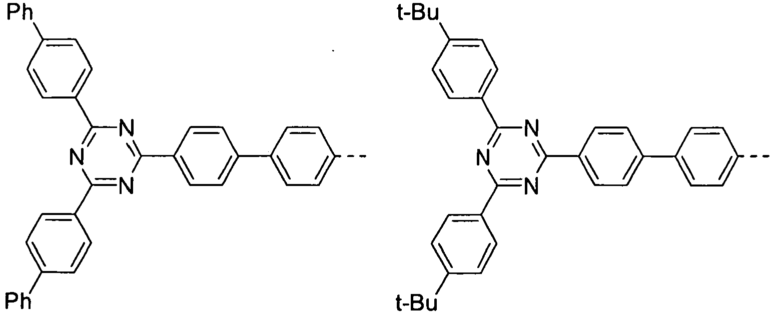

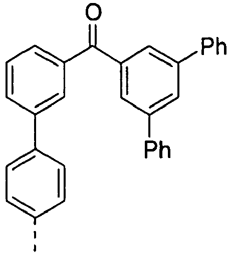

Besonders bevorzugte lochtransportierende Substituenten aufweisende Struktureinheiten sind dabei ausgewählt aus der Gruppe bestehend aus den nachfolgenden Struktureinheiten: 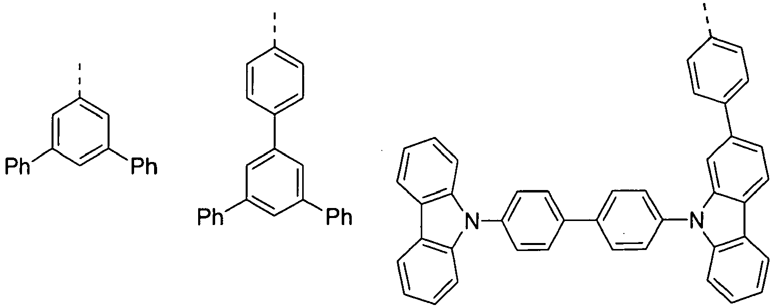 wobei die gestrichelte Linie jeweils die Verbindung zum Grundgerüst des Polymers oder Copolymers darstellt.

Die erfindungsgemäßen Polymere können neben den Seitenketten mit der Struktureinheit der Formel (I) eine oder mehrere weitere Seitenketten umfassen, die mindestens eine weitere Struktureinheit enthalten.

Es ist im Sinne der vorliegenden Erfindung auch denkbar, dass die erfindungsgemäßen Polymere neben der Struktureinheiten der Formel (I) mehrere weitere Seitenketten umfassen, die verschiedene weitere Struktureinheiten enthalten. Diese weitere(n) Struktureinheit(en) sind vorzugsweise ausgewählt aus der Gruppe, die aus elektronentransportierenden Einheiten, lochtransportierenden Einheiten, ladungsneutralen Einheiten und emittierenden Einheiten besteht.

In einer weiteren Ausführungsform der vorliegenden Erfindung enthalten die erfindungsgemäßen Polymere vorzugsweise neben einer oder mehreren Struktureinheiten der Formel (I) noch mindestens eine weitere Struktureinheit, die von der Struktureinheit der Formel (I) verschieden ist. Dies sind unter anderem solche, wie sie in der WO 02/077060 A1 und in der WO 2005/014689 A2 offenbart und umfangreich aufgelistet sind. Diese werden via Zitat als Bestandteil der vorliegenden Erfindung betrachtet. Die weiteren Struktureinheiten können beispielsweise aus den folgenden Klassen stammen:
- Gruppe 1:: Einheiten, welche die Lochinjektions- und/oder Lochtransporteigenschaften der Polymere beeinflussen;
- Gruppe 2:: Einheiten, welche die Elektroneninjektions- und/oder Elektronentransporteigenschaften der Polymere beeinflussen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom so genannten Singulett- zum Triplettzustand verbessern;
- Gruppe 6:: Einheiten, welche die Emissionsfarbe der resultierenden Polymere beeinflussen;
- Gruppe 7:: Einheiten, welche typischerweise als Backbone verwendet werden;
- Gruppe 8:: Einheiten, welche die Filmmorphologie und/oder die rheologischen Eigenschaften der resultierenden Polymere beeinflussen.

Bevorzugte erfindungsgemäße Polymere sind solche, bei denen mindestens eine Struktureinheit Ladungstransporteigenschaften aufweist, d. h. die Einheiten aus der Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital). Vorzugsweise führen diese Arylamine und Heterocyclen zu einem HOMO im Polymer von mehr als -5,8 eV (gegen Vakuumlevel), besonders bevorzugt von mehr als -5,5 eV.

Eine Struktureinheit aus der Gruppe 1, die als Seitenkette im erfindungsgemäßen Polymer vorliegen kann, ist eine Einheit der folgenden Formel (VI) 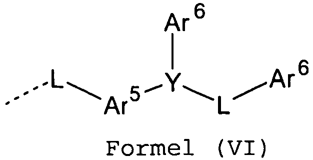 wobei die gestrichelte Linie die Verbindung zum Grundgerüst des Polymers darstellt, und das Symbol L die gleichen Bedeutungen wie in Bezug auf Formel (I) hat, und die übrigen verwendeten Symbole die folgenden Bedeutungen aufweisen:
- Y: ist eine trivalente Einheit, die aus der Gruppe ausgewählt ist, die aus N, B, Si(Ar⁴), SiR⁵, Ge(Ar⁴), GeR⁵, P und As besteht;
- Ar⁵: ist ein bivalentes mono- oder polycyclisches, aromatisches oder heteroaromatisches Ringsystem mit 5 bis 60 aromatischen Ringatomen, welches mit einem oder mehreren Resten R¹ substituiert sein kann;
- Ar⁶: ist ein mono- oder polycyclisches, aromatisches oder.heteroaromatisches Ringsystem mit 5 bis 60 aromatischen Ringatomen, welches mit einem oder mehreren Resten R¹ substituiert sein kann;
- R⁵: ist bei jedem Auftreten gleich oder verschieden H, D, F, Cl, Br, I, N(Ar³)₂, CN, NO₂, Si(R²)₃, B(OR²)₂, C(=O)Ar³, P(=O)(Ar³)₂, S(=O)Ar³, S(=O)₂Ar³, -CR²=CR²(Ar³), Tosylat, Triflat, OSO₂R², eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, oder eine Aryloxy- oder Heteroaryloxy-gruppe mit 5 bis 60 aromatischen Ringatomen, die durch einen oder mehrere Reste R² substituiert sein kann, oder eine Kombination dieser Systeme; wobei auch
zwei oder mehrere benachbarte Substituenten R⁵ miteinander über eine kovalente Einfachbindung oder eine bivalente Gruppe Z verknüpft sein können;
wobei R¹, R², Ar³, Ar⁴ und Z die gleichen Bedeutungen haben, wie oben in Bezug auf Formel (I) definiert.

Beispiele für eine Struktureinheit der Formel (VI) sind die Folgenden:

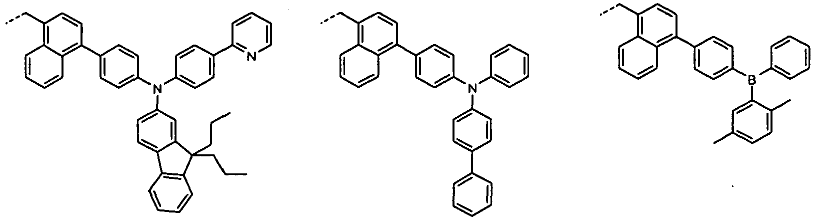

Eine weitere Struktureinheit aus der Gruppe 1, die als Seitenkette im erfindungsgemäßen Polymer vorliegen kann, ist eine Einheit der folgenden Formel (VII) 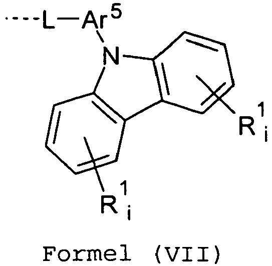 wobei die gestrichelte Linie die Verbindung zum Grundgerüst des Polymers darstellt,
die unspezifischen Bindungen, die in der Mitte der aromatischen Ringe enden, andeuten sollen, dass der Rest R¹ an jeder der Positionen 1 bis 8 des Carbazols sitzen kann,
die Symbole L, R¹ und Ar⁵ die gleichen Bedeutungen wie in Bezug auf Formel (I) haben, und der Index i gleich 0, 1, 2, 3 oder 4 ist.

Ein Beispiel für eine Struktureinheit der Formel (VIII) ist die Folgende:

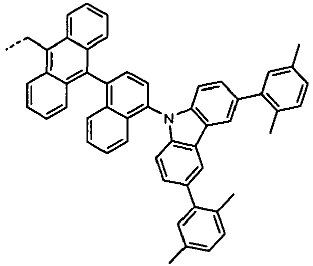

Eine weitere Struktureinheit aus der Gruppe 1, die als Seitenkette im erfindungsgemäßen Polymer vorliegen kann, ist eine Einheit der folgenden Formel (VIII) 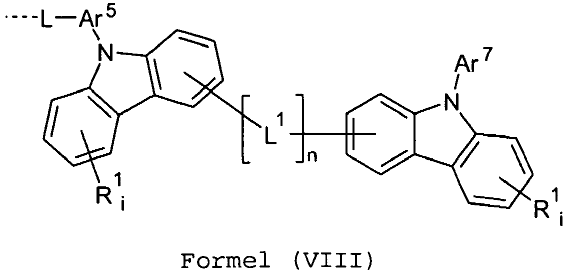 wobei die gestrichelte Linie die Verbindung zum Grundgerüst des Polymers darstellt,
die unspezifischen Bindungen, die in der Mitte der aromatischen Ringe enden, andeuten sollen, dass die Symbole R¹ und L¹ jeweils an jeder der entsprechenden Positionen 1 bis 8 des Carbazols sitzen können, die Symbole L, R¹ und Ar⁵ und der Index i die gleichen Bedeutungen wie in Bezug auf Formel (I) bzw. (VII) haben, und die übrigen verwendeten Symbole und Indices die folgenden Bedeutungen aufweisen:
- L¹: ist bei jedem Auftreten gleich oder verschieden eine kovalente Einfachbindung oder eine geradkettige Alkylengruppe mit 1 bis 20 C-Atomen oder eine verzweigte oder cyclische Alkylengruppe mit 3 bis 20 C-Atomen, die jeweils mit einem oder mehreren Resten R¹ substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können;
- n: ist gleich 0, 1, 2 oder 3, mit der Maßgabe, dass, wenn n > 1 ist, maximal ein L¹ ein aromatisches oder heteroaromatisches Ringsystem sein kann;
- Ar⁷: ist ein mono- oder polycyclisches, aromatisches oder heteroaromatisches Ringsystem mit 5 bis 60 aromatischen Ringatomen, welches mit einem oder mehreren Resten R¹ substituiert sein kann.

Ein Beispiel für eine Struktureinheit der Formel (VIII) ist die Folgende:

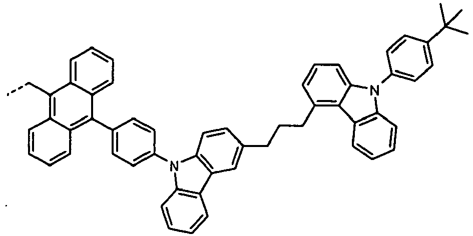

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital). Vorzugsweise führen diese Einheiten im Polymer zu einem LUMO von weniger als -2,5 eV (gegen Vakuumlevel), besonders bevorzugt von weniger als -2,7 eV.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o. g. Bedingung erfüllen. Besonders bevorzugt sind hier entsprechende Struktureinheiten, welche Elemente der Gruppe 8 bis 10 (Ru, Os, Rh, Ir, Pd, Pt) enthalten. Als Struktureinheiten für die erfindungsgemäßen Polymere kommen hier z.B. verschiedene Komplexe in Frage, wie sie z.B. in der WO 02/068435 A1, der WO 02/081488 A1, der EP 1 239 526 A2 und der WO 2004/026886 A2 beschrieben werden. Entsprechende Monomere werden in der WO 02/068435 A1 und in der WO 2005/042548 A1 beschrieben.

Eine Struktureinheit aus der Gruppe 4, die als Seitenkette im erfindungsgemäßen Polymer vorliegen kann, ist eine Einheit der folgenden Formel (IX) 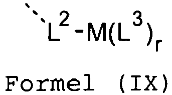 wobei die gestrichelte Linie die Verbindung zum Grundgerüst des Polymers darstellt, und die verwendeten Symbole und Indices die folgenden Bedeutungen aufweisen:
- L² und L³: sind unabhängig voneinander bei jedem Auftreten gleich oder verschieden ein ein- oder mehrzähniger Ligand;
- M: ist vorzugsweise ein Übergangsmetall, ein Hauptgruppenmetall, ein Lanthanoid oder ein Actinoid;
- r: ist je nach Zähnigkeit der Liganden L² und L³ und der Koordinationszahl des Metalls M gleich 0, 1, 2, 3, 4, 5, 6 oder 7.

Unter einem ein- oder mehrzähnigen Ligand versteht man eine Verbindung, die mit einem Metall eine oder mehrere Koordinationsbindung(en) eingehen kann. Vorzugsweise bildet der Ligand mit dem Zentralmetall eine metallorganische Verbindungseinheit. Die metallorganische Verbindungseinheit ist vorzugsweise eine metallorganische Koordinationsverbindung. Unter einer metallorganischen Koordinationsverbindung versteht man eine Verbindung mit einem Metallatom oder -ion im Zentrum der Verbindung umgeben von einer organischen Verbindung als Ligand. Eine metallorganische Koordinationsverbindung ist zudem dadurch charakterisiert, dass ein Kohlenstoffatom des Liganden über eine Koordinationsbindung an das Zentralmetall bindet.

Des Weiteren bevorzugt ist, dass der organische Ligand ein Chelatligand ist. Unter einem Chelatligand versteht man einen zwei- oder mehrzähnigen Liganden, der entsprechend über zwei oder mehr Atome an das Zentralmetall binden kann.

Vorzugsweise ist der Ligand L² und L³ ein organischer Ligand, der eine Einheit (im Folgenden als Ligandeinheit bezeichnet) umfasst, die durch die folgende Formel (X) dargestellt ist: 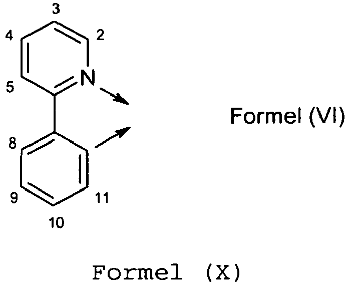 wobei die Atome, von denen die Pfeile wegdeuten, an das Metallatom koordiniert sind, und die Ziffern 2 bis 5 und 8 bis 11 lediglich eine Nummerierung zur Unterscheidung der C-Atome darstellt. Die organische Ligandeinheit der Formel (X) kann anstelle von Wasserstoff an den Positionen 2, 3, 4, 5, 8, 9, 10 und 11 unabhängig voneinander einen Substituenten aufweisen, der aus der Gruppe ausgewählt ist, die aus C₁₋₆-Alkyl, C₆₋₂₀-Aryl, 5- bis 14-gliedrigem Heteroaryl und weiteren Substituenten besteht.

Der hierin verwendete Ausdruck "C₁₋₆-Alkyl" bezeichnet eine lineare oder verzweigte Alkylgruppe mit 1 bis 6 Kohlenstoffatomen. Beispiele solcher Kohlenstoffatome sind Methyl, Ethyl, n-Propyl, iso-Propyl, n-Butyl, iso-Butyl, sec-Butyl (1-Methylpropyl), tert-Butyl, iso-Pentyl, n-Pentyl, tert-Pentyl (1,1- Dimethylpropyl), 1,2-Dimethylpropyl, 2,2-Dimethylpropyl (neopentyl), 1-Ethylpropyl, 2-Methylbutyl, n-Hexyl, isoHexyl, 1,2-Dimethylbutyl, 1-Ethyl-1-methylpropyl, 1-Ethyl-2-methylpropyl, 1,1,2-Trimethylpropyl, 1,2,2-Trimethylpropyl, 1-Ethylbutyl, 1-Methylbutyl, 1,1-Dimethylbutyl, 2,2-Dimethylbutyl, 1,3-Dimethylbutyl, 2,3-Dimethylbutyl, 3,3-Dimethylbutyl, 2-Ethylbutyl, 1-Methylpentyl, 2-Methylpentyl, 3-Methylpentyl und dergleichen, wobei Methyl und Ethyl bevorzugt sind.

Der Ausdruck "C₆₋₂₀-Aryl" bezeichnet ein aromatisches Ringsystem mit 6 bis 20 Kohlenstoffatomen. Unter einem aromatischen bzw. heteroaromatischen Ringsystem im Sinne der vorliegenden Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nicht-aromatische Einheit (< 10 % der von H verschiedenen Atome, vorzugsweise < 5 % der von H verschiedenen Atome), wie beispielsweise sp³-hybridisierter C, O, N, etc., unterbrochen sein können.

Aromatische Gruppen können monocyclisch oder polycyclisch sein, d.h. sie können einen Ring (z.B. Phenyl) oder zwei oder mehr Ringe aufweisen, welche auch kondensiert (z.B. Naphthyl) oder kovalent verknüpft sein können (z.B. Biphenyl), oder eine Kombination von kondensierten und verknüpften Ringen beinhalten. Bevorzugt sind vollständig konjugierte aromatische Gruppen.

Bevorzugte aromatische Ringsysteme sind z.B. Phenyl, Biphenyl, Triphenyl, Naphthyl, Anthracen, Binaphthyl, Phenanthren, Dihydrophenanthren, Pyren, Dihydropyren, Chrysen, Perylen, Tetracen, Benzpyren, Fluoren, Inden, Indenofluoren und Spirobifluoren.

Unter "5- bis 14-gliedrigem Heteroaryl" versteht man eine aromatische Gruppe, in der ein oder mehrere Kohlenstoffatom(e) gegen ein N, 0 oder S ausgetauscht ist/sind. Beispiele hierfür schließen die folgenden ein: 5-gliedrige Ringe, wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe, wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder kondensierte Gruppen wie Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen. Die Heteroarylgruppen können auch mit Alkyl, Alkoxy, Thioalkyl, Fluor, Fluoralkyl oder weiteren Aryl- oder Heteroarylgruppen substituiert sein.

Weitere mögliche Substituenten an der Ligandeinheit der Formel (X) sind vorzugsweise ausgewählt aus der Gruppe bestehend aus Silyl, Sulfo, Sulfonyl, Formyl, Amin, Imin, Nitril, Mercapto, Nitro, Halogen, Hydroxy oder Kombinationen dieser Gruppen. Bevorzugte Substituenten sind beispielsweise löslichkeitsfördernde Gruppen, wie Alkyl oder Alkoxy, elektronenziehende Gruppen, wie Fluor, Nitro oder Nitril, oder Substituenten zur Erhöhung der Glastemperatur (Tg) im Polymer. Besonders bevorzugte Substituenten sind z.B. F, Cl, Br, I, -CN, -NO₂, -NCO, -NCS, -OCN, -SCN, -C(=O)N(R)₂, -C(=O)R, -C(=O)R und -N(R)₂, worin R ein Wasserstoff, Alkyl oder Aryl ist, optional substituiertes Silyl, Aryl mit 4 bis 40, vorzugsweise 6 bis 20 C-Atomen, und geradkettiges oder verzweigtes Alkyl, Alkoxy, Alkylcarbonyl, Alkoxycarbonyl, Alkylcarbonyloxy oder Alkoxycarbonyloxy mit 1 bis 22 C-Atomen, worin ein oder mehrere H-Atome gegebenenfalls durch F oder Cl ersetzt sein können.

Des Weiteren ist es bevorzugt, dass zwei benachbarte Kohlenstoffatome an dem Phenylring oder Pyridylring der Ligandeinheit der Formel (X) über eine Gruppe -CH=CH-CH=CH- verbrückt sind, wobei im Fall des Phenylrings eine Naphtyleinheit und im Fall des Pyridylrings eine Azanaphtyleinheit entsteht. Diese können wiederum über eine weitere Gruppe über zwei benachbarte Kohlenstoffatome verbrückende Gruppe -CH=CH-CH=CH- tragen. In einer weiteren bevorzugten Ausführungsform sind die Kohlenstoffatome an den Positionen 5 und 8 über eine Gruppe -CH=CH- verbrückt. Weitere Brücken zwischen Phenyleinheiten der Ligandeinheit können bivalente (CH₃)C-Einheiten sein, die vorzugsweise so verknüpft sind, dass ein weiterer 6-gliedriger Ring entsteht.

Bevorzugte Beispiele der Liganden gemäß Formel (X) sind die folgenden Verbindungen (X-1) bis (X-10):

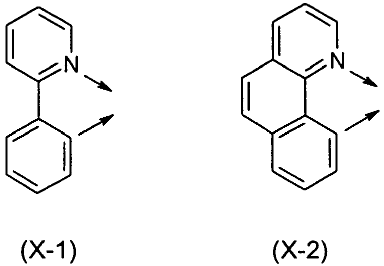

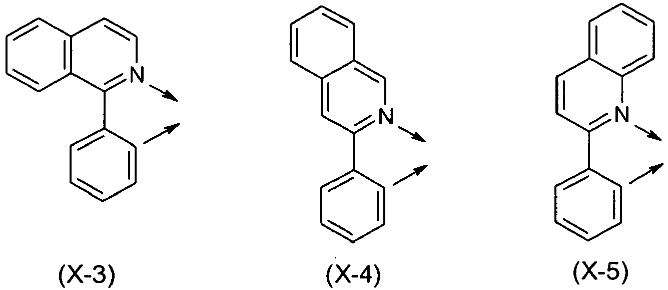

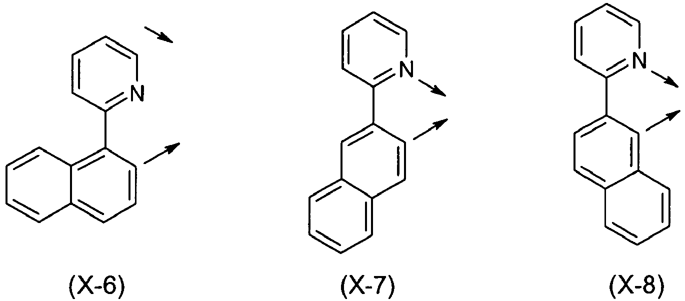

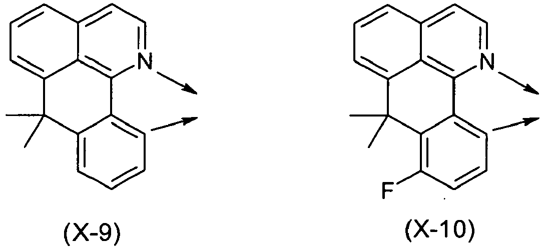

Besonders bevorzugt im Sinne der vorliegenden Erfindung sind die Verbindungen (X-1), (X-3) und (X-10).

Des Weiteren ist der Ligand L² vorzugsweise über ein C-Atom in der 2-, 3-, 4-, 5-, 8-, 9-, 10- oder 11-Position an das Grundgerüst des Polymers gebunden. Besonders bevorzugt ist der Ligand über die Position 9 oder 11 an das Grundgerüst des Polymers gebunden, insbesondere über die Position 9.

Neben der oben genannten Ligandeinheit L², die an das Grundgerüst des Polymers gebunden ist, kann die Koordinationsverbindung weitere Liganden L³ umfassen, die nicht an das Grundgerüst des Polymers gebunden sind. Diese weiteren Liganden sind ebenso definiert wie der oben aufgeführte Ligand L², mit dem Unterschied, dass keines der H-Atome durch eine Bindung zum Polymer ersetzt ist. In anderen Worten weist dieser Ligand statt der Bindung zum Polymer an der entsprechenden Stelle vorzugsweise einen Wasserstoffrest auf. Bevorzugte Beispiele des weiteren Liganden sind die gleichen wie oben genannt. Besonders bevorzugte Beispiele sind Liganden der oben genannten Formeln (X-1) bis (X-10). Besonders bevorzugt ist der weitere Ligand ein Ligand der Formeln (X-1), (X-3) und (X-10).

Das Metall der Metall-Ligand-Koordinationsverbindung ist vorzugsweise ein Übergangsmetall, ein Hauptgruppenmetall, ein Lanthanoid oder ein Actinoid. Wenn das Metall ein Hauptgruppenmetall ist, dann ist es vorzugsweise ein Metall der dritten, vierten oder fünften Hauptgruppe, insbesondere Zinn. Ist das Metall ein Übergangsmetall, dann ist es vorzugsweise Ir, Ru, Os, Pt, Zn, Mo, W, Rh oder Pd, insbesondere Ir und Pt. Als Lanthanoid ist Eu bevorzugt.

Bevorzugt sind Metall-Ligand-Koordinationsverbindungen, in denen das Metall ein Übergangsmetall ist, insbesondere ein tetrakoordiniertes, ein pentakoordiniertes oder ein hexakoordiniertes Übergangsmetall, besonders bevorzugt ausgewählt aus der Gruppe bestehend aus Chrom, Molybdän, Wolfram, Rhenium, Ruthenium, Osmium, Rhodium, Iridium, Nickel, Palladium, Platin, Kupfer, Silber und Gold, insbesondere Molybdän, Wolfram, Rhenium, Ruthenium, Osmium, Iridium, Platin, Kupfer und Gold. Ganz besonders bevorzugt sind Iridium und Platin. Die Metalle können dabei in verschiedenen Oxidationsstufen vorliegen. Bevorzugt sind dabei die oben genannten Metalle in den Oxidationsstufen Cr(0), Cr(II), Cr(III), Cr(IV), Cr(VI), Mo(0), Mo(II), Mo(III), Mo(IV), Mo(VI), W(0), W(II), W(III), W(IV), W(VI), Re(I), Re(II), Re(III), Re(IV), Ru(II), Ru(III), Os(II), Os(III), Os(IV), Rh(I), Rh(III), Ir(I), Ir(III), Ir(IV), Ni(0), Ni(II), Ni(IV), Pd(II), Pt(II), Pt(IV), Cu(I), Cu(II), Cu(III), Ag(I), Ag(II), Au(I), Au(III) und Au(V); ganz besonders bevorzugt sind Mo(0), W(0), Re(I), Ru(II), Os(II), Rh(III), Ir(III), Pt(II) und Cu(I), insbesondere Ir(III) und Pt(II).

In einer bevorzugten Ausführungsform der Erfindung ist das Metall ein tetrakoordiniertes Metall mit ein, zwei, drei oder vier Liganden. Auf diese Weise können die Liganden mono-, bi-, tri- oder tetradentate Liganden sein. Ist das Metall mit einem Liganden koordiniert, so ist es ein tetradentater Ligand. Ist das Metall mit zwei Liganden koordiniert, so sind entweder beide Liganden bidentate Liganden, oder einer ist ein tridentater Ligand und einer ein monodentater Ligand. Ist das Metall mit drei Liganden koordiniert, so ist ein Ligand ein bidentater und zwei sind ein monodentater Ligand. Ist das Metall mit vier Liganden koordiniert, so sind alle Liganden monodentat.

In einer weiteren bevorzugten Ausführungsform der Erfindung ist das Metall ein hexakoordiniertes Metall mit ein, zwei, drei, vier, fünf bzw. sechs Liganden. Auf diese Weise können die Liganden mono-, bi-, tri-, tetra-, penta oder hexadentate Liganden sein. Ist das Metall mit einem Liganden koordiniert, so ist es ein hexadentater Ligand. Ist das Metall mit zwei Liganden koordiniert, so sind entweder beide tridentate Liganden oder einer ein bidentater und einer ein tetradentater Ligand oder einer ein monodentater und einer ein pentadentater Ligand. Ist das Metall mit drei Liganden koordiniert, so sind entweder alle drei Liganden bidentate Liganden oder einer ein tridentater Ligand, einer ein bidentater und einer ein monodentater Ligand oder einer ein tetradentater Ligand und zwei monodentate Liganden. Ist das Metall mit vier Liganden koordiniert, so ist ein Ligand ein tridentater und drei sind ein monodentater Ligand oder zwei sind bidentate und zwei monodentate Liganden. Ist das Metall mit fünf Liganden koordiniert, so ist einer ein bidentater Ligand und vier sind monodentate Liganden. Ist das Metall mit sechs Liganden koordiniert, so sind alle Liganden monodentat.

Das Metallzentrum der organischen Koordinationsverbindung ist vorzugsweise ein Metallatom in der Oxidationsstufe 0. Und die Metall-Ligand-Koordinationsverbindung ist vorzugsweise eine ladungsneutrale Verbindung.

In einer ganz besonders bevorzugten Ausführungsform ist das Metallzentrum Pt oder Ir. Ist das Metallzentrum Pt, so weist es vorzugsweise die Koordinationszahl 4 auf. Im Fall von Ir als Metallzentrum ist die Koordinationszahl vorzugsweise 6.

Des Weiteren ist es bevorzugt, dass Pt von zwei Ligand-Einheiten der Formel (X) und Ir von drei Ligand-Einheiten der Formel (X) auf die oben angegebene Weise koordiniert ist.

Folglich ist r vorzugsweise 1, wenn die Koordinationszahl des Metalls 4 beträgt und die Liganden L² und L³ jeweils zweizähnig (d.h. bidentat) sind und r ist vorzugsweise 2, wenn die Koordinationszahl des Metalls 6 beträgt und die Liganden L² und L³ jeweils zweizähnig (d.h. bidentat) sind.

Beispiele für eine Struktureinheit der Formel (IX) sind die Folgenden:

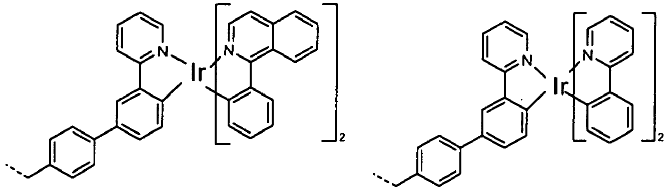

Struktureinheiten der Gruppe 5 sind solche, welche den Übergang vom Singulett- zum Triplettzustand verbessern und welche, unterstützend zu den Strukturelementen der Gruppe 4 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Struktureinheiten der Gruppe 6 sind neben den oben genannten solche, die mindestens noch eine weitere aromatische oder eine andere konjugierte Struktur aufweisen, welche nicht unter die o. g. Gruppen fallen, d. h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylarylenderivate, die jeweils mit einem oder mehreren Resten R substituiert sein können. Besonders bevorzugt ist dabei der Einbau von 1,4-Phenylen-, 1,4-Naphthylen-, 1,4- oder 9,10-Anthrylen-, 1,6-, 2,7- oder 4,9-Pyrenylen-, 3,9- oder 3,10-Perylenylen-, 4,4'-Biphenylylen-, 4,4''-Terphenylylen, 4,4'-Bi-1,1'-naphthylylen-, 4,4'-Tolanylen-, 4,4'-Stilbenylen-, 4,4''-Bisstyrylarylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme, wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis- und trans-Indenofluorenderivate.

Struktureinheiten der Gruppe 8 sind solche, die die Filmmorphologie und/oder die rheologischen Eigenschaften der Polymere beeinflussen, wie z.B. Siloxane, lange Alkylketten oder fluorierte Gruppen, aber auch besonders steife oder flexible Einheiten, wie z.B. flüssigkristallbildende Einheiten oder vernetzbare Gruppen.

Eine weitere Struktureinheit, die als Seitenkette in dem erfindungsgemäßen Polymer vorliegen kann, ist eine Einheit der folgenden Formel (XI) 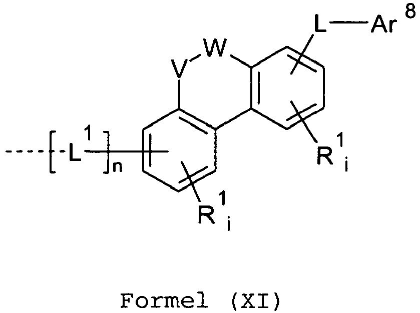 wobei die gestrichelte Linie die Verbindung zum Grundgerüst des Polymers darstellt, die unspezifischen Bindungen, die in der Mitte der aromatischen Ringe enden, andeuten sollen, dass die Symbole R¹, L und L¹ jeweils an jeder der freien Positionen der aromatischen Ringe sitzen können, die Symbole R¹, L und L¹ und die Indices i und n die gleichen Bedeutungen wie in Bezug auf Formel (I) bzw. (VII) haben, und die übrigen verwendeten Symbole die folgenden Bedeutungen haben:
- V und W: sind unabhängig voneinander ausgewählt aus der Gruppe bestehend aus C(Ar³)₂, C(R⁵)₂, Si(Ar³)₂, Si(R⁵)₂, Ge(Ar³)₂, Ge(R⁵)₂, C=O, O, S, Se, N(Ar⁴), N(R⁵), P(Ar⁹), P(R⁵), P=O(Ar³), P=O(R), Bund (R⁵)₂CO;
- Ar⁸: ist ein mono- oder polycyclisches, aromatisches oder heteroaromatisches Ringsystem mit 5 bis 60 aromatischen Ringatomen, welches mit einem oder mehreren Resten R¹ substituiert sein kann;
wobei die Symbole R⁵, Ar³ und Ar⁴ die gleichen Bedeutungen haben, wie weiter oben definiert.

Je nach Bedeutung der Reste V und W in der Struktureinheit der Formel (XI), kann die Struktureinheit eine aus der Gruppe 1, 2, 5, 6 oder 8 sein.

Beispiele für eine Struktureinheit der Formel (XI) sind die Folgenden:

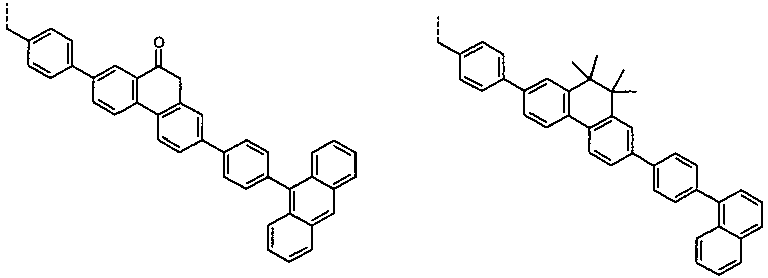

Bevorzugt sind erfindungsgemäße Polymere, die gleichzeitig neben Struktureinheiten der Formel (I) zusätzlich noch ein oder mehrere Einheiten ausgewählt aus den Gruppen 1 bis 8 enthalten. Es kann ebenfalls bevorzugt sein, wenn gleichzeitig mehr als eine weitere Struktureinheit aus einer Gruppe vorliegt.

Bevorzugt sind dabei erfindungsgemäße Polymere, die neben mindestens einer Struktureinheit der Formel (I) noch Einheiten aus der Gruppe 7 enthalten, besonders bevorzugt mindestens 50 mol-% dieser Einheiten, bezogen auf die Gesamtzahl der Struktureinheiten im Polymer.

Ebenfalls bevorzugt ist es, wenn die erfindungsgemäßen Polymere Einheiten enthalten, die den Ladungstransport oder die Ladungsinjektion verbessern, also Einheiten aus der Gruppe 1 und/oder 2; besonders bevorzugt ist ein Anteil von 0,5 bis 30 mol-% dieser Einheiten; ganz besonders bevorzugt ist ein Anteil von 1 bis 10 mol-% dieser Einheiten, bezogen auf die gesamte Wiederholeinheit, an der die funktionelle Seitenkette hängt. Zu einer Wiederholeinheit gehören alle Atome, welche durch Polymerisation eines Monomers in das Polymer eingebaut werden.

Besonders bevorzugt ist es weiterhin, wenn die erfindungsgemäßen Polymere Struktureinheiten aus der Gruppe 7 und Einheiten aus der Gruppe 1 und/oder 2 enthalten, insbesondere mindestens 50 mol-% Einheiten aus der Gruppe 7 und 0,5 bis 30 mol-% Einheiten aus der Gruppe 1 und/oder 2.

Die erfindungsgemäßen Polymere sind entweder Homopolymere oder Copolymere. Die erfindungsgemäßen Polymere können linear oder verzweigt sein. Erfindungsgemäße Copolymere können dabei neben einer oder mehreren Struktureinheiten der Formel (I) potentiell eine oder mehrere Strukturen aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Besonders bevorzugt weisen die erfindungsgemäßen Copolymere statistische oder blockartige Strukturen auf. Besonders bevorzugt sind die Copolymere statistische oder blockartige Copolymere. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Diese ist via Zitat Bestandteil der vorliegenden Anmeldung. Ebenso sei an dieser Stelle nochmals hervorgehoben, dass das Polymer auch dendritische Strukturen haben kann.

Es kann außerdem bevorzugt sein, die erfindungsgemäßen Polymere nicht als Reinsubstanz, sondern als Mischung (Blend) zusammen mit weiteren beliebigen polymeren, oligomeren, dendritischen oder niedermolekularen Substanzen zu verwenden. Diese können z.B. die elektronischen Eigenschaften verbessern oder selbst emittieren. Als "Mischung" oder "Blend" wird vor- und nachstehend eine Mischung enthaltend mindestens eine erfindungsgemäße polymere Komponente bezeichnet.

Ein weiterer Gegenstand der vorliegenden Erfindung ist somit eine Polymermischung (Blend), die ein oder mehrere erfindungsgemäße Polymere, sowie eine oder mehrere weitere polymere, oligomere, dendritische oder niedermolekulare Substanzen enthält.

Eine bevorzugte niedermolekulare Substanz in der erfindungsgemäßen Mischung ist eine emittierende Verbindung. Die emittierende Verbindung ist vorzugsweise eine Verbindung der folgenden Formel (XII)

M(L³)ₖ Formel (XII)

wobei M und L³ die gleichen Bedeutungen, wie oben in Bezug auf Formel (IX), haben, und k je nach der Zähnigkeit des Liganden L³ und der Koordinationszahl des Metalls M gleich 1, 2, 3, 4, 5, 6, 7 oder 8 ist.

Gegenstand der Erfindung sind weiterhin Lösungen und Formulierungen aus einem oder mehreren erfindungsgemäßen Polymeren oder Mischungen in einem oder mehreren Lösungsmittel(n). Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-Coating) oder durch Druckverfahren (z.B. InkJet Printing). Geeignete und bevorzugte Lösungsmittel sind beispielsweise Toluol, Anisol, Xylol, Methylbenzoat, Dimethylanisol, Mesitylen, Tetralin, Veratrol und Tetrahydrofuran sowie Gemische derselben.

Die vorliegende Erfindung betrifft zudem Verfahren zur Herstellung der erfindungsgemäßen Polymere, die dadurch gekennzeichnet sind, dass die Polymere durch kationische oder anionische, ringöffnende, radikalische oder katalytische Polymerisation hergestellt werden. Dabei können Monomere der folgenden Formeln (Ia) sowie (VIa) bis (XIa) entweder zu einem Homopolymer oder zu einem Copolymer miteinander verknüpft werden.

Die vorliegende Erfindung betrifft somit auch eine Verbindung der folgenden Formel (Ia) 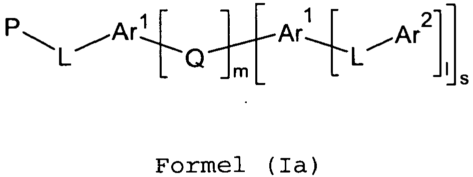 worin die verwendeten Symbole und Indices dieselben Bedeutungen wie in Bezug auf Formel (I) haben, und das Symbol P eine polymerisierbare Gruppe ist.

Die polymerisierbare Gruppe ist vorzugsweise eine Gruppe, die durch ionische, ringöffnende, radikalische und/oder katalytische Polymerisation mit weiteren polymerisierbaren Gruppen zu einem Polymer umgesetzt ist.

Die polymerisierbare Gruppe umfasst vorzugsweise eine kovalente Doppelbindung oder einen Oxiran-Ring. Folgende polymerisierbare Gruppen können hierbei eingesetzt werden: 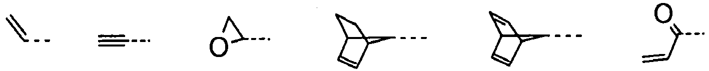 wobei die gestrichelte Linie die Verbindung zum Symbol L darstellt.

Erfindungsgemäß bevorzugte Verbindungen der Formel (Ia) sind die Folgenden:

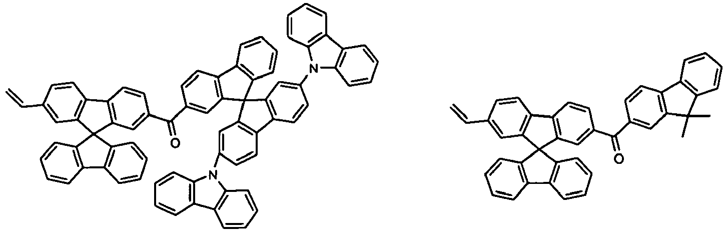

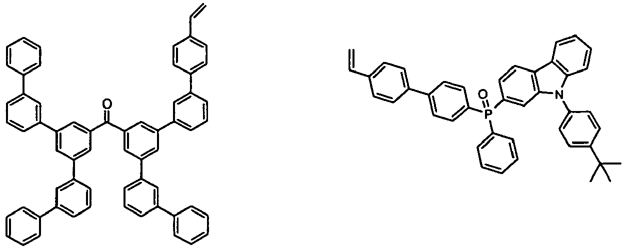

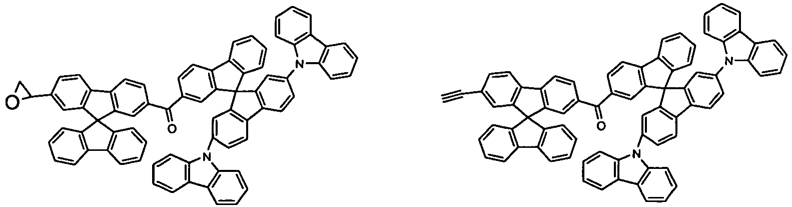

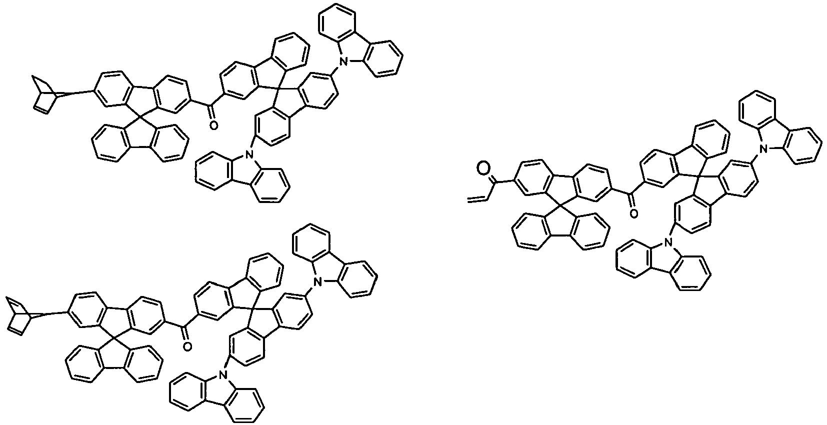

Ein weiterer Gegenstand der Erfindung ist eine Zusammensetzung, die eine Verbindung der Formel (Ia) enthält. Die erfindungsgemäße Zusammensetzung kann neben der Verbindung der Formel (Ia) noch eine oder mehrere weitere polymersierbare Verbindung(en) enthalten. Die eine oder die mehreren weitere(n) polymerisierbaren Verbindung(en) sind dabei vorzugsweise aus der Gruppe ausgewählt, die aus den folgenden Verbindungen besteht:

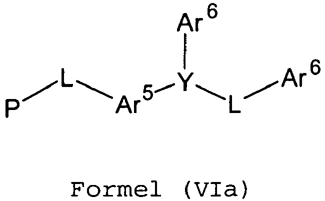

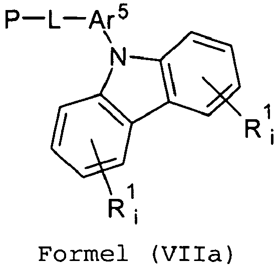

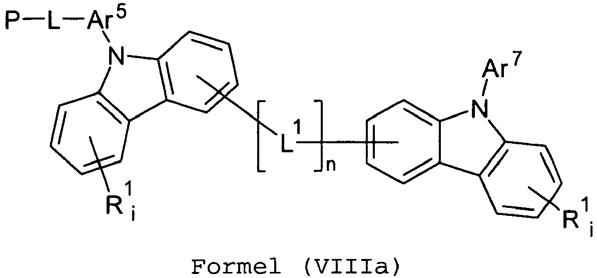

P-L²-M(L³)ᵣ Formel (IXa),

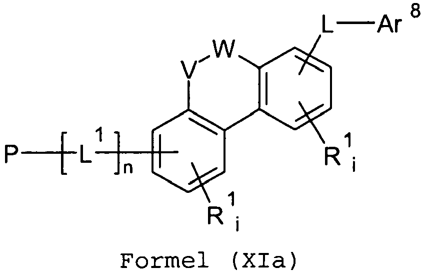

worin die verwendeten Symbole und Indices die gleichen Bedeutungen haben, wie oben definiert.

Bevorzugte Verbindungen der Formeln (IIa) sowie (VIa) bis (XIa) sind die Folgenden:

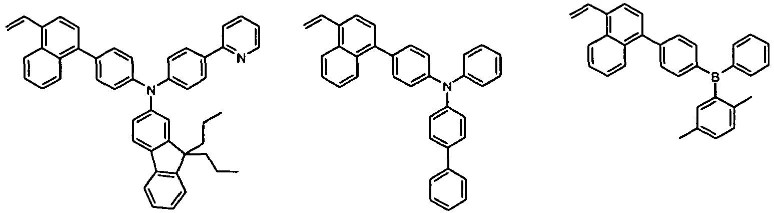

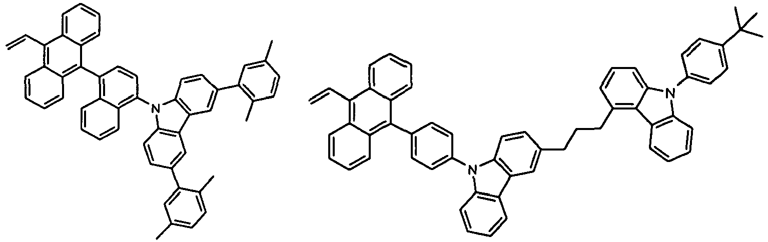

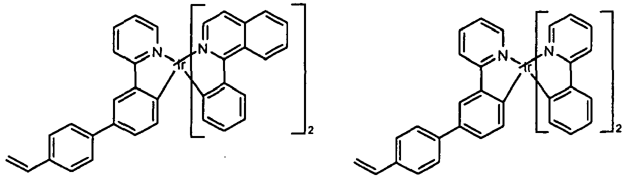

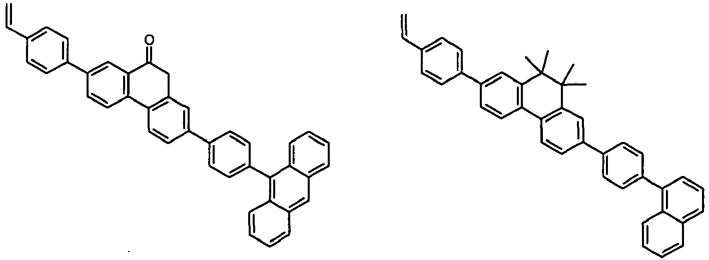

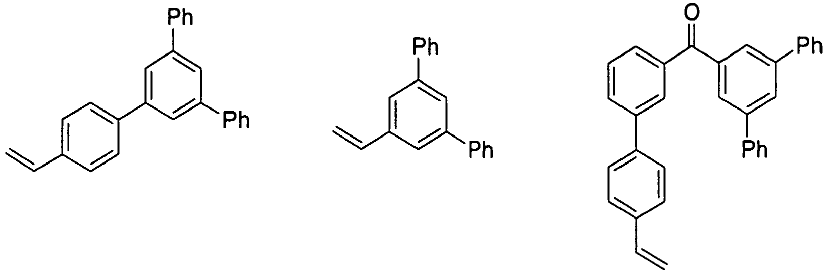

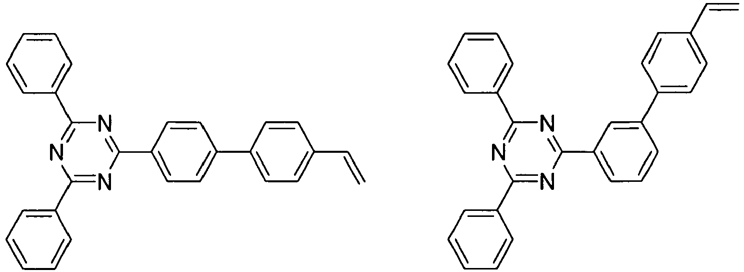

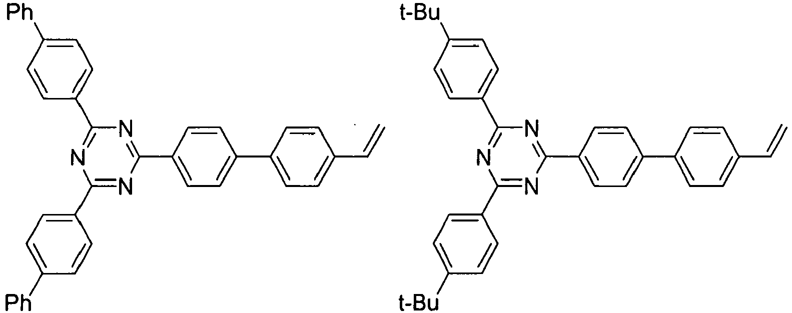

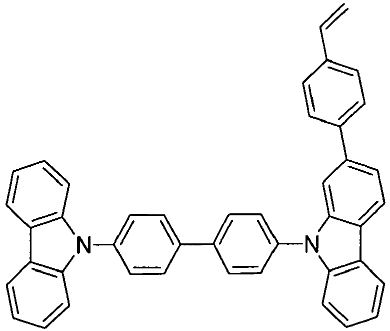

Die erfindungsgemäße Zusammensetzung kann vorzugsweise auch ein Lösungsmittel oder ein Lösungsmittelgemisch umfassen.

Die Zusammensetzung kann ferner weitere Hilfsmittel, wie Stabilisatoren, Stoffe, welche die Filmbildung unterstützen, Sensibilisatoren und dergleichen umfassen.

Die erfindungsgemäße Zusammensetzung kann zur Herstellung eines Polymers verwendet werden. Vorzugsweise erfolgt die Herstellung des Polymers durch kationische, anionische, radikalische, ringöffnende oder koordinative Polymerisation.

Das Polymer kann wiederum in einem Lösungsmittel bzw. Lösungsmittelgemisch gelöst werden, wodurch eine Formulierung erhalten wird, die zur Herstellung von elektronischen Vorrichtungen geeignet ist.

In einer bevorzugten Ausführungsform des erfindungsgemäßen Blends ist das Host-Molekül ausgewählt aus Carbazolverbindungen gemäß Formel (XIII) 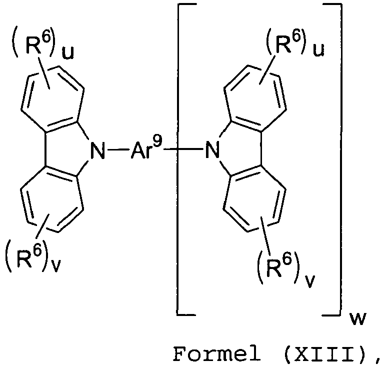 wobei für die verwendeten Symbole und Indices gilt:
- Ar⁹: ist bei jedem Auftreten ein aromatisches oder heteroaromatisches Ringsystem mit 5 bis 60 aromatischen Ringatomen, welches mit einem oder mehreren Resten R⁶ substituiert sein kann;
- R⁶: ist bei jedem Auftreten gleich oder ver-schieden H, D, F, Cl, Br, I, N(Ar¹⁰)₂, CN, NO₂, Si(R⁷)₃, B(OR⁷)₂, C(=O)Ar¹⁰, P(=O)(Ar¹⁰)₂, S(=O) Ar¹⁰, S(=O)₂Ar¹⁰, -CR⁷=CR⁷(Ar¹⁰), OSO₂R⁷, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehre-ren Resten R⁷ substituiert sein kann, wobei eine oder mehrere nicht benachbarte CH₂-Gruppen durch R⁷C=CR⁷, C≡C, Si(R⁷)₂, Ge(R⁷)₂, Sn(R⁷)₂, C=O, C=S, C=Se, C=NR⁷, P(=O)(R⁷), SO, SO₂, NR⁷, O, S oder CONR⁷ ersetzt sein können und wobei ein oder mehrere H-Atome durch F, Cl, Br, I, CN oder NO₂ ersetzt sein können, oder ein aromatisches oder hetero-aromatisches Ringsystem mit 5 bis 60 aroma-tischen Ringatomen, das jeweils mit einem oder mehreren Resten R⁷ substituiert sein kann, oder eine Aryloxy- oder Heteroaryloxygruppe mit 5 bis 60 aromati-schen Ringatomen, die mit einem oder mehre-ren Resten R⁷ substituiert sein kann, oder eine Kombination dieser Systeme; dabei kön-nen zwei oder mehrere Substituenten R⁶ und/oder R⁷ auch miteinander ein mono oder polycyclisches aliphatisches oder aromati-sches Ringsystem bilden;
- Ar¹⁰: ist bei jedem Auftreten gleich oder ver-schieden ein aromatisches oder heteroaroma-tisches Ringsystem mit 5 bis 60 aromatischen Ringatomen, welches mit einem oder mehreren Resten R⁷ substituiert sein kann;
- R⁷: ist bei jedem Auftreten gleich oder ver-schieden H, D oder ein aliphatischer, aroma-tischer und/oder heteroaromatischer Kohlen-wasserstoffrest mit 1 bis 20 C-Atomen; oder ein aromatisches oder heteroaromatisches Ringsystem mit 5 bis 60 aromatischen Ring-atomen, welches mit einem oder mehreren Res-ten R aliphatischer, aromatischer und/oder heteroaromatischer Kohlenwasserstoffrest mit 1 bis 20 C-Atomen substituiert sein kann; dabei können zwei oder mehrere Substituenten R⁷ auch miteinander ein mono- oder polycyclisches, aliphatisches, aromatisches oder heteroaromatisches Ringsystem bilden;
- R: ist bei jedem Auftreten gleich oder ver-schieden ein H, D, N(Ar¹⁰)₂, eine gerad-kettige Alkylgruppe mit 1 bis 5 C-Atomen oder verzweigte Alkylgruppe mit 3 bis 5 C-Atomen, wobei jeweils eine oder mehrere nicht benachbarte CH₂-Gruppen durch -R⁸C=CR⁸-oder -O- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen oder eine Spirobifluorengruppe, die jeweils mit einem oder mehreren Resten R⁷ substituiert sein kann, oder eine Kombinati-on aus zwei dieser Systeme steht, dabei kön-nen zwei oder mehrere Substituenten R⁷ auch miteinander ein mono- oder polycyclisches, aliphatisches, aromatisches oder heteroaro-matisches Ringsystem bilden.
- u: ist bei jedem Auftreten gleich oder ver-schieden 0, 1, 2, 3 oder 4;
- v: ist bei jedem Auftreten gleich oder ver-schieden 0, 1, 2, 3 oder 4; und
- w: ist 1, 2, 3, 4 oder 5;

Wenn der Index w gleich 1 ist, bedeutet dies, dass Ar⁹ in Verbindungen der Formel (XIII) eine bivalente Gruppe darstellt. Wenn der Index w größer als 1 ist, bedeutet dies, dass insgesamt drei oder mehr Carbazolgruppen an das aromatische Ringsystem Ar⁹ in Verbindungen der Formel (XIII) gebunden sind. In Verbindungen der Formel (XIII) ist Ar⁹ für w = 2 eine trivalente Gruppe und für w > 2 eine entsprechend höhervalente Gruppe. Bevorzugt ist der Index w = 1 oder 2, besonders bevorzugt ist w = 1.

Bevorzugt weisen die erfindungsgemäß eingesetzten Carbazolverbindungen der Formel (XIII) eine Glasübergangstemperatur Tg von mehr als 120°C auf, besonders bevorzugt von mehr als 140°C.

Die Carbazolverbindung der Formel (XIII) dient im Sinne der vorliegenden Erfindung vornehmlich als Matrixmaterial und/oder als Lochtransportmaterial. Ein lochtransportierendes Material im Sinne der vorliegenden Anmeldung ist charakterisiert durch ein HOMO von vorzugsweise mehr als -5,4 eV. Ein elektronentransportierendes Material im Sinne der vorliegenden Anmeldung ist charakterisiert durch ein LUMO von vorzugsweise weniger als -2,4 eV. Dabei erfolgt die Bestimmung der HOMO- und LUMO-Lagen und der Energielücke vorzugsweise durch Cyclovoltammetrie.

In einer bevorzugten Ausführungsform der vorliegenden Erfindung sind die Indices u in Verbindungen der Formel (XIII) bei jedem Auftreten gleich oder verschieden 0 oder 1. Besonders bevorzugt sind die Indices u = 0.

In einer Ausführungsform ist in der Verbindung gemäß Formel (XIII) der Index v vorzugsweise gleich oder verschieden bei jedem Auftreten 0, 1 oder 2, besonders bevorzugt 0 oder 1. Wenn der Index v gleich 1 ist, ist der Substituent R⁶ bevorzugt in der 5-Position oder in der 7-Position des Carbazols gebunden, besonders bevorzugt in der 5-Position. Wenn der Index v gleich 2 ist, sind die Substituenten R⁶ bevorzugt in der 5- und in der 7-Position des Carbazols gebunden.

Der Übersichtlichkeit halber ist in der folgenden Formel die Nummerierung der Positionen des Carbazols dargestellt:

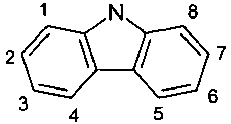

Bevorzugte Gruppen Ar⁹ und R⁷ in Formel (XIII) enthalten nur Phenyl- und/oder Naphthylgruppen oder heteroaromatische Gruppen mit nicht mehr als zwei kondensierten, aromatischen bzw. heteroaromatischen Ringen, jedoch keine größeren kondensierten aromatischen Systeme. Daher sind bevorzugte Gruppen Ar⁹ und R⁷ aromatische Ringsysteme, welche aufgebaut sind aus Phenyl- und/oder Naphthylgruppen oder Verknüpfungen dieser Systeme, wie beispielsweise Biphenyl, Fluoren und Spirobifluoren.

Besonders bevorzugte Gruppen Ar⁹ sind ausgewählt aus der Gruppe bestehend aus 1,2-Phenylen, 1,3-Phenylen, 1,4-Phenylen, 1,3,5-Benzol, 3,3'-Biphenyl, 4,4'-Biphenyl, 1,3,5-Triphenylbenzol, Triphenylamin, 2,7-Fluorenylen, welches durch einen oder mehrere Reste R⁶ substituiert sein kann, 2,7-Spirobifluorenylen, welches durch einen oder mehrere Reste R⁶ substituiert sein kann, Indenofluorenylen, welches durch einen oder mehrere Reste R⁶ substituiert sein kann, 4,4"'-(1,1':2',1",2",1"'-Quarterphenyl), 4,4'-(2,2'-Dimethylbiphenyl), 4,4'-(1,1'-Binaphthyl), 4,4'-Stilbenyl und Dihydrophenanthrenyl, welches durch einen oder mehrere Reste R⁶ substituiert sein kann.

Besonders bevorzugte Gruppen R⁷ der Carbazolverbindung sind gleich oder verschieden ausgewählt aus der Gruppe bestehend aus Phenyl, 1-Naphthyl, 2-Naphthyl, 2-Carbazolyl, 3-Carbazolyl, 9-Carbazolyl, Triphenylamin, Naphthyldiphenylamin oder Dinaphthylphenylamin, welche jeweils durch einen oder mehrere Reste R substituiert sein können. Dabei können die beiden letztgenannten Gruppen über das Naphthalin in 1- oder 2-Position oder über die Phenylgruppe gebunden sein. Eine 2- bzw. 3-Carbazolylgruppe ist dabei bevorzugt am Stickstoff durch einen aromatischen Rest Ar⁹ substituiert.

Bevorzugt sind weiterhin Verbindungen gemäß Formel (XIII), in denen das Symbol R gleich oder verschieden bei jedem Auftreten für H, D, N(Ar¹⁰)₂, eine geradkettige Alkylgruppe mit 1 bis 5 C-Atomen oder verzweigte Alkylgruppe mit 3 bis 5 C-Atomen, wobei jeweils eine oder mehrere nicht benachbarte CH₂-Gruppen durch -R⁸C=CR⁸- oder -O- ersetzt sein können und wobei ein oder mehrere H-Atome durch F ersetzt sein können, oder eine Arylgruppe mit 6 bis 16 C-Atomen oder Heteroarylgruppe mit 2 bis 16 C-Atomen oder eine Spirobifluorengruppe, die jeweils mit einem oder mehreren Resten R⁷ substituiert sein kann, oder eine Kombination aus zwei dieser Systeme steht. Besonders bevorzugte Reste R sind gleich oder verschieden bei jedem Auftreten H, D, Methyl, Ethyl, iso-Propyl, tert-Butyl, wobei jeweils ein oder mehrere H-Atome durch F ersetzt sein können, oder eine Phenyl-, Naphthyl- oder Spirobifluorenylgruppe, die jeweils mit einem oder mehreren Resten R substituiert sein kann, oder eine Kombination aus zwei dieser Systeme. Bei Verbindungen, die aus Lösung verarbeitet werden, sind insbesondere lineare oder verzweigte Alkylketten mit bis zu 10 C-Atomen bevorzugt. Brom, Boronsäure bzw. Boronsäurederivate als Substituenten sind vor allem für die Verwendung dieser Verbindung als Zwischenverbindung zur Herstellung weiterer erfindungsgemäßer Verbindungen, beispielsweise Polymere, Oligomere oder Dendrimere, bevorzugt.

Bevorzugt sind weiterhin Verbindungen gemäß Formel (XIII), in denen das Symbol R⁶ gleich oder verschieden bei jedem Auftreten entsprechend dem bevorzugten Substituenten R definiert ist oder für Ar¹⁰ oder F steht.

Beispiele für weitere bevorzugte Verbindungen gemäß Formel (XIII) sind die im Folgenden abgebildeten Strukturen (XIII-1) bis (XIII-91).

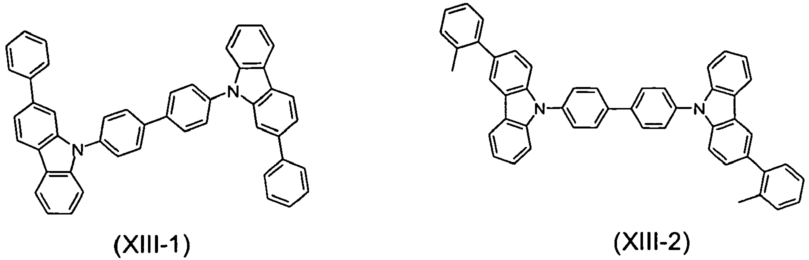

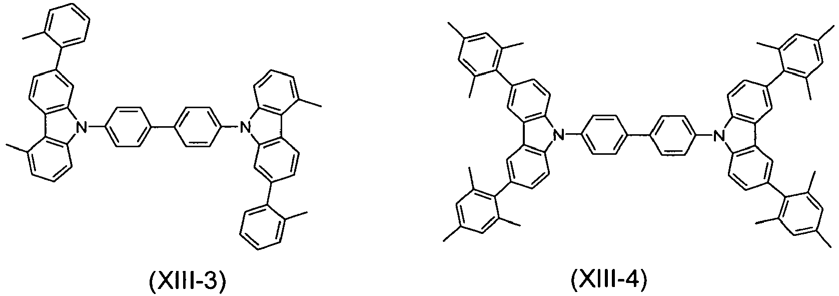

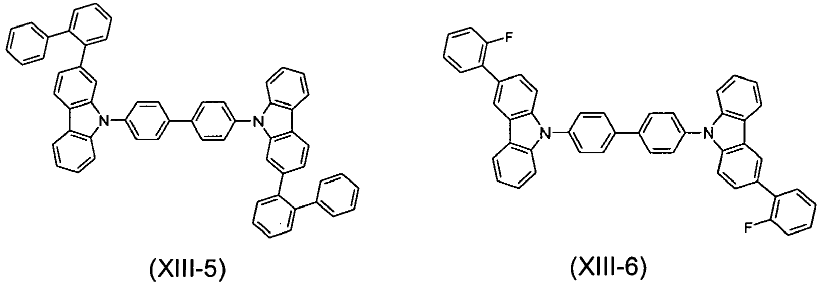

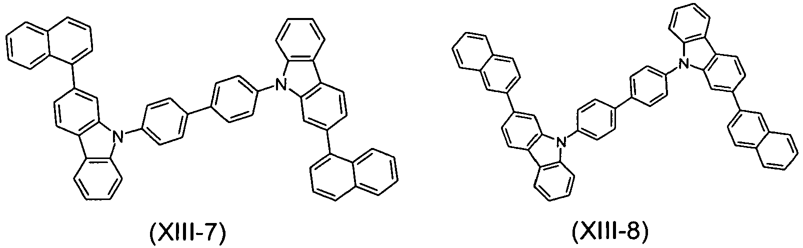

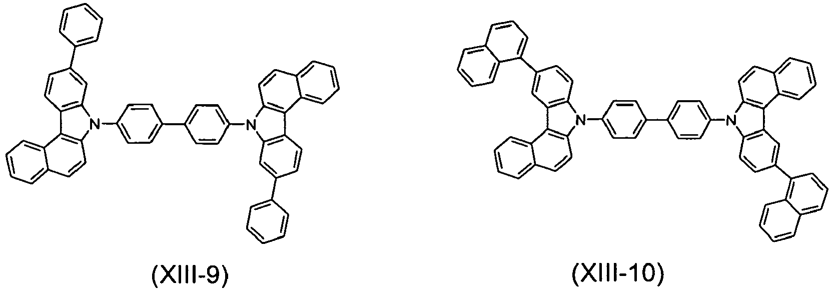

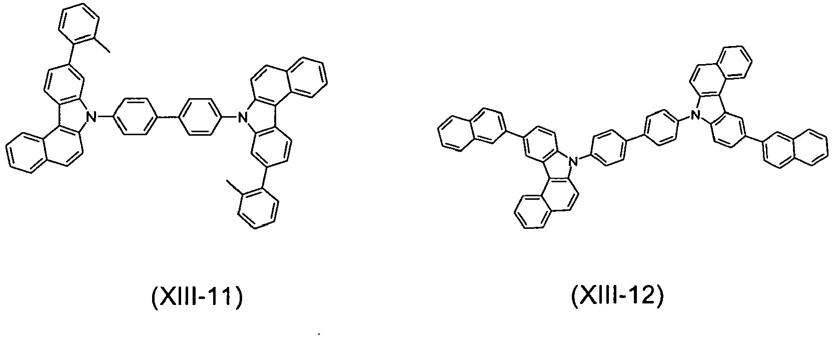

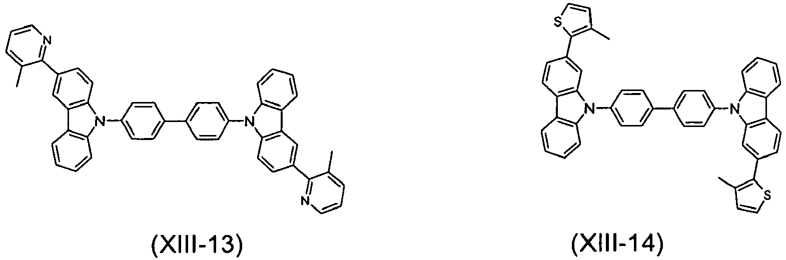

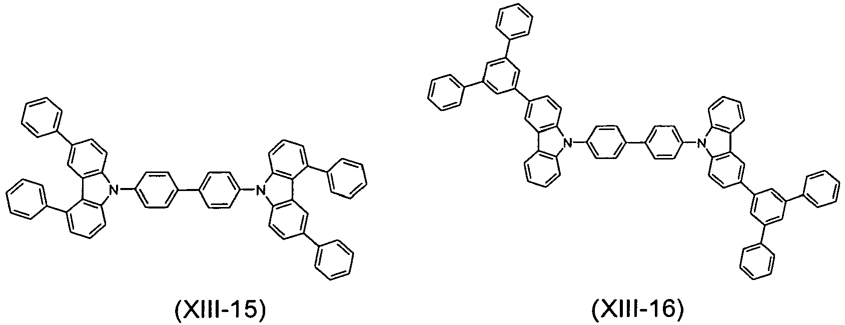

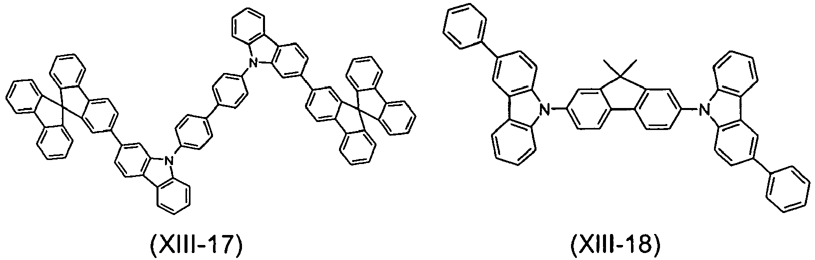

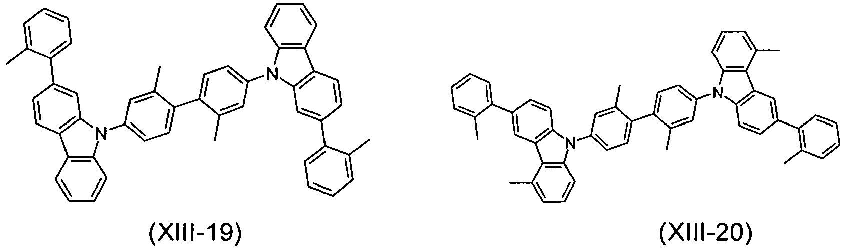

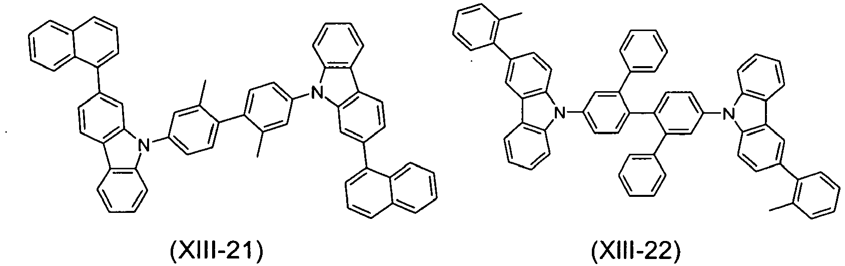

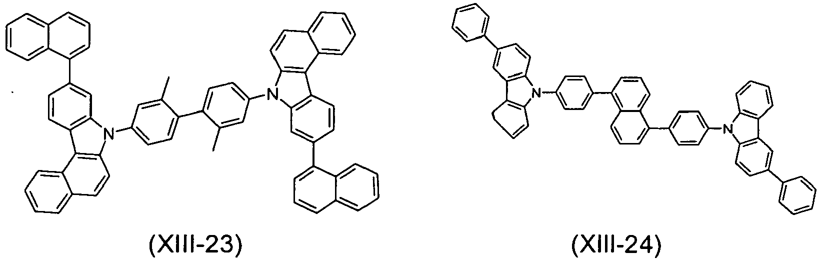

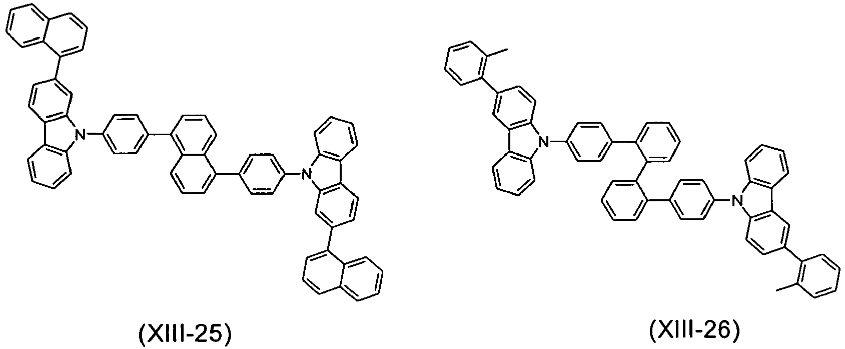

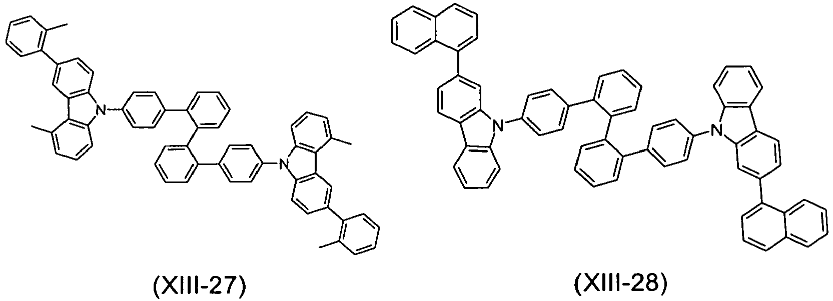

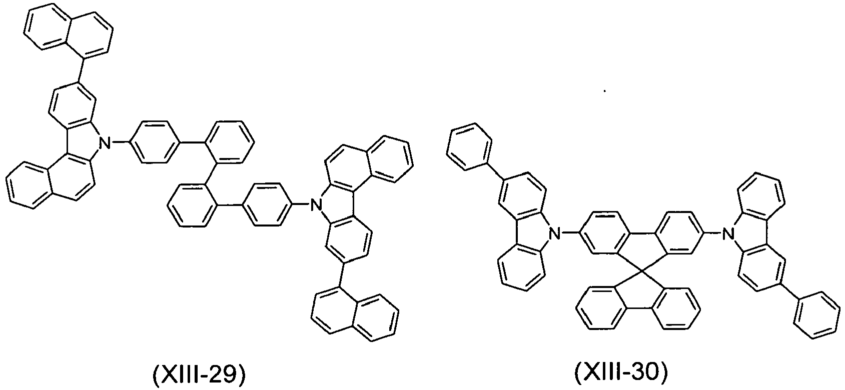

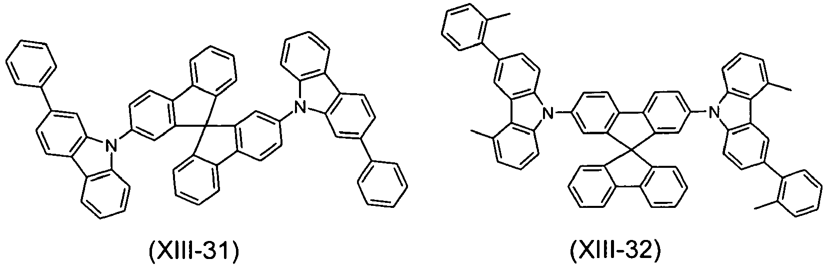

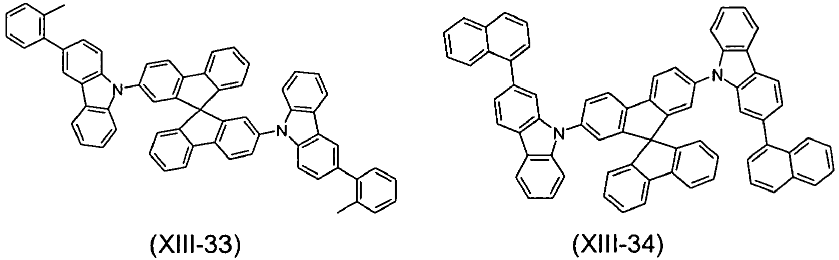

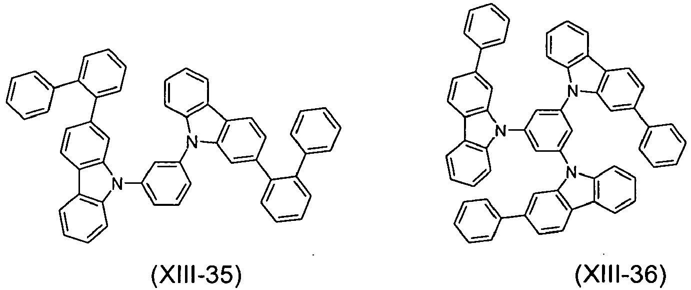

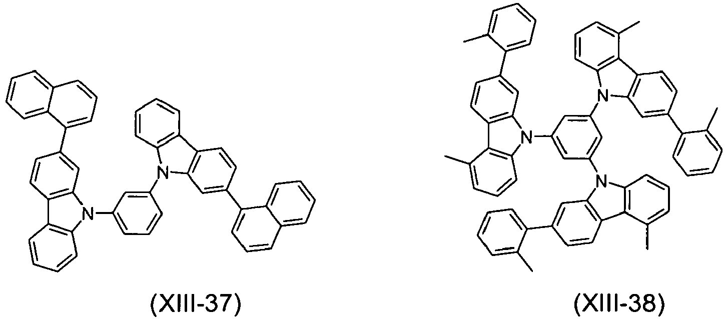

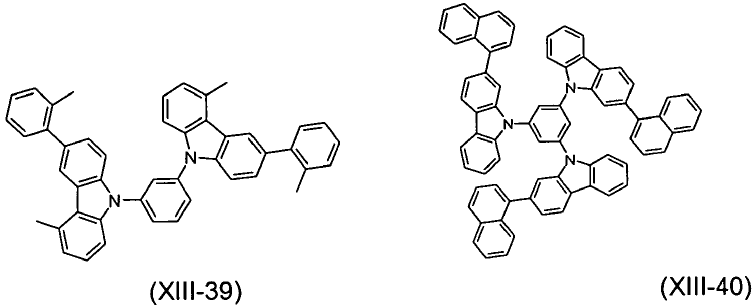

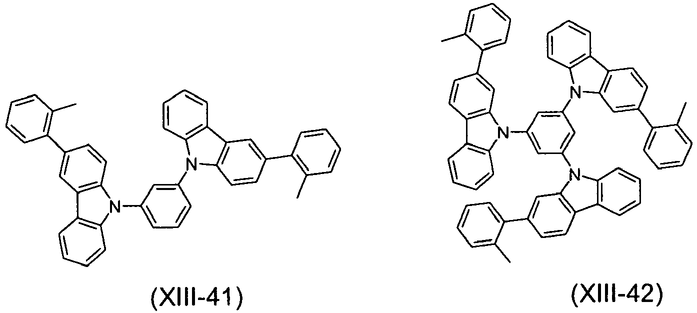

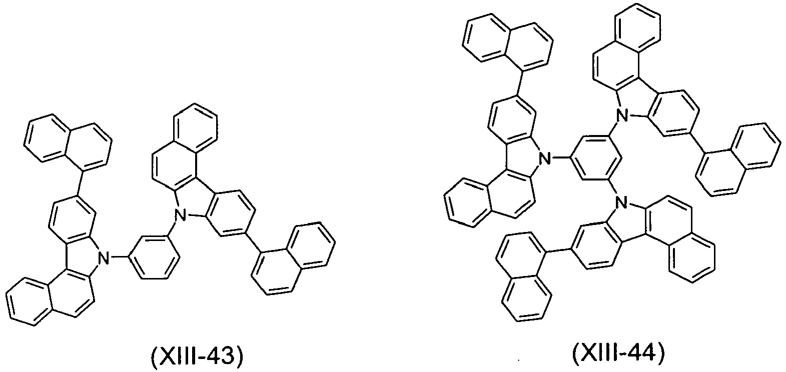

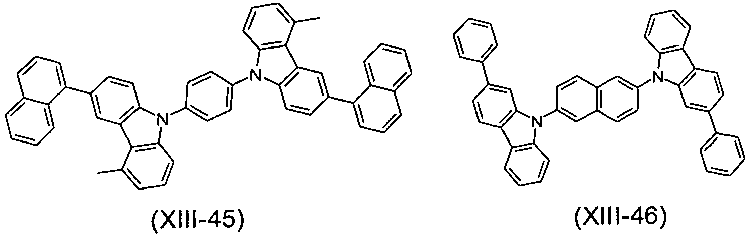

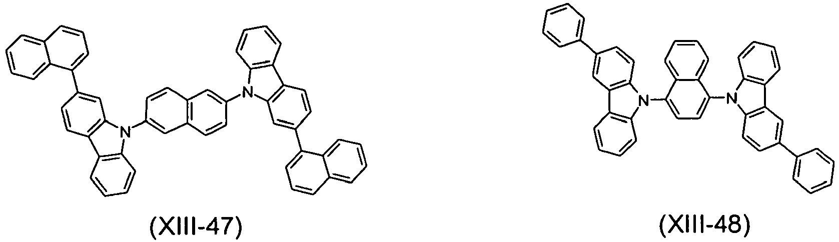

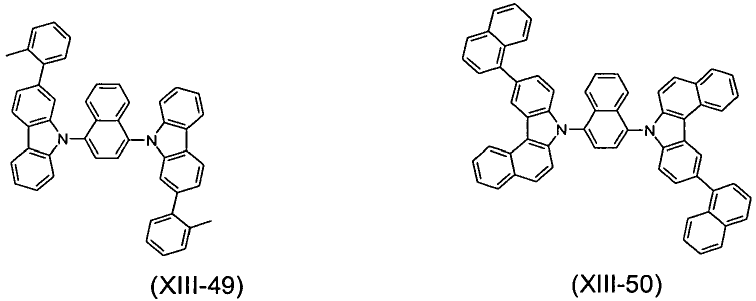

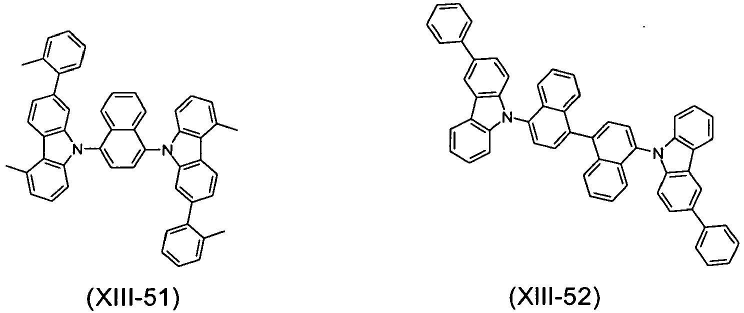

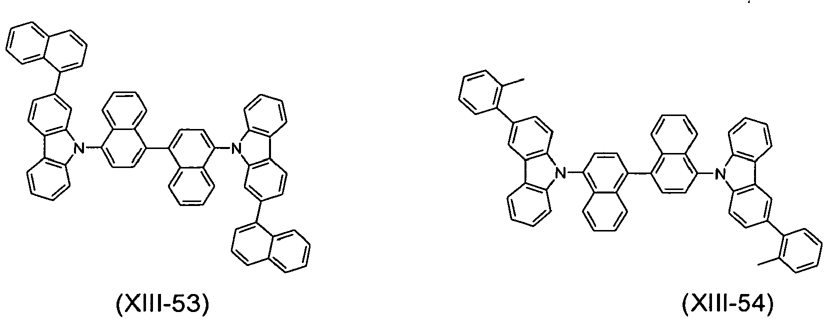

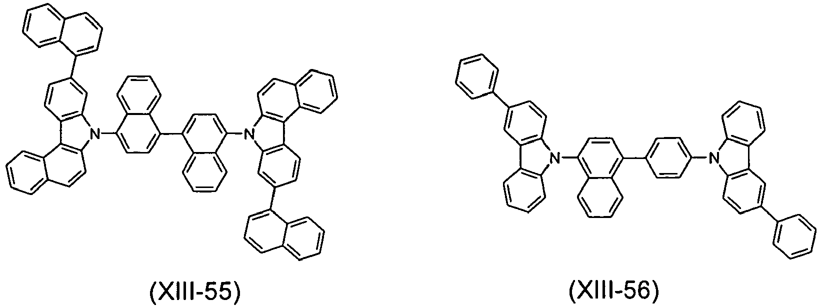

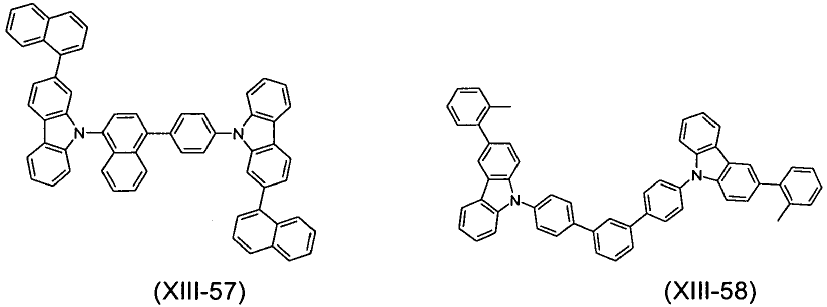

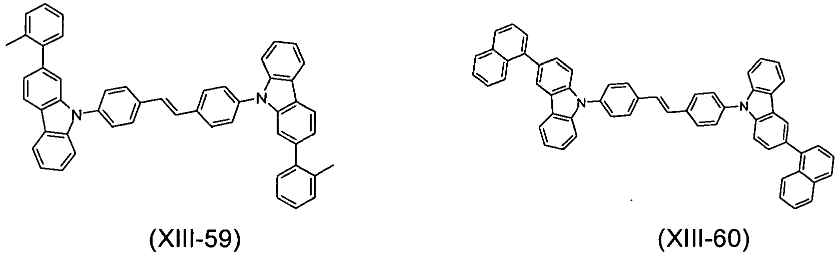

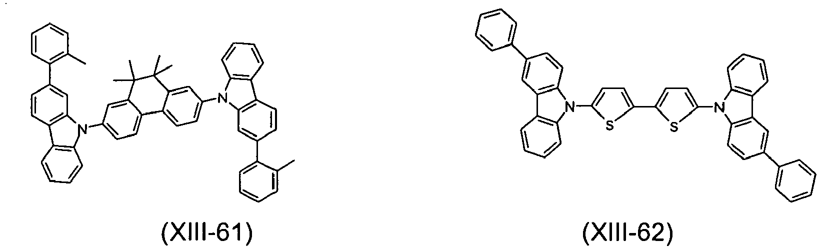

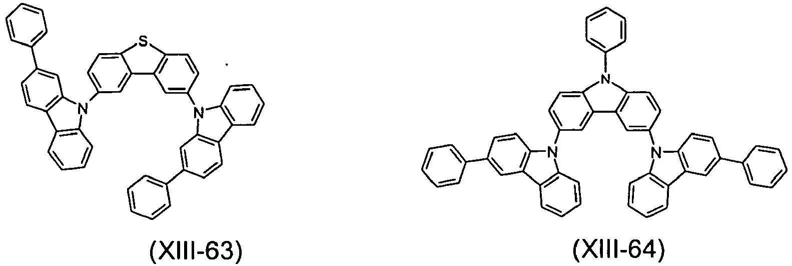

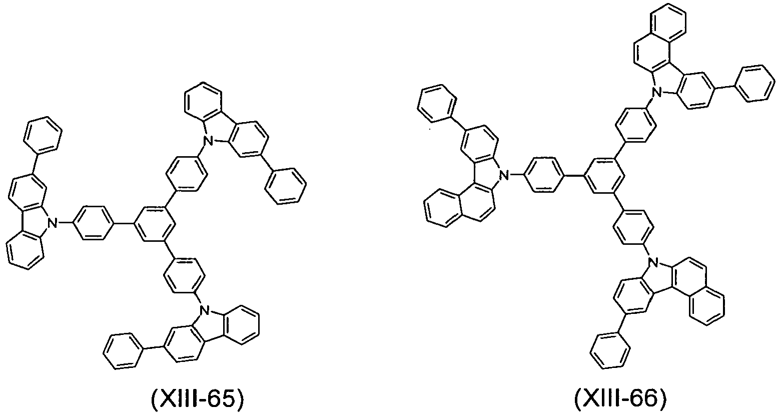

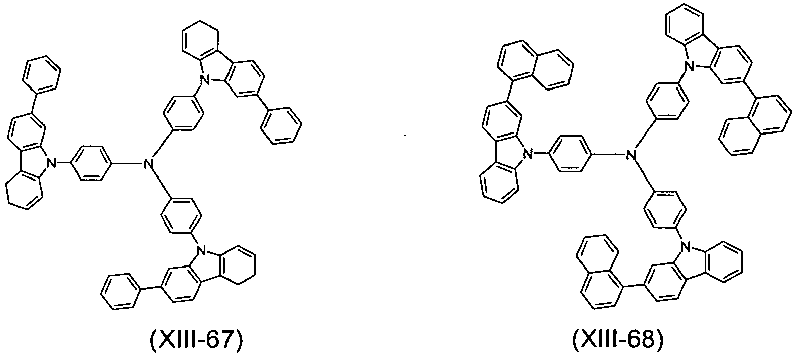

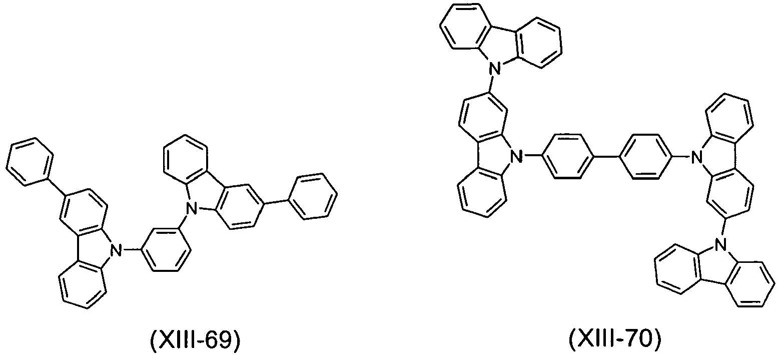

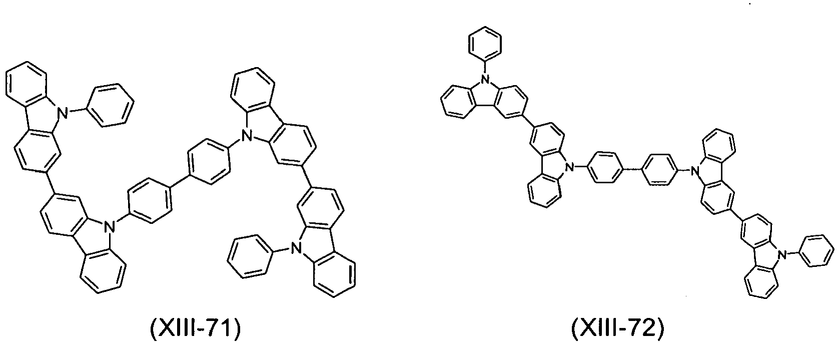

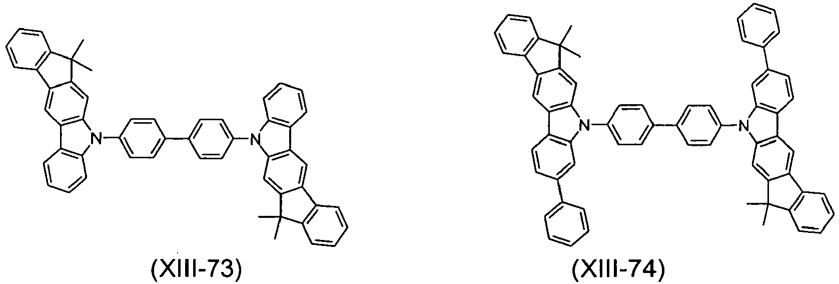

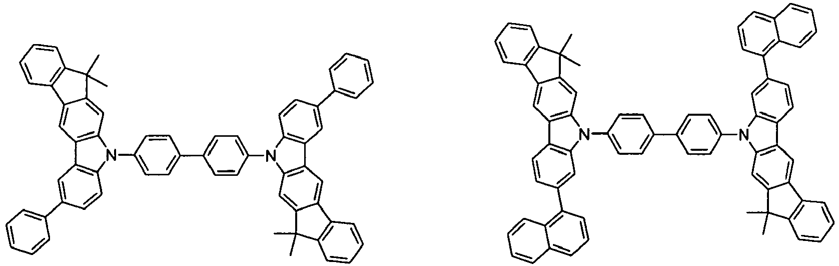

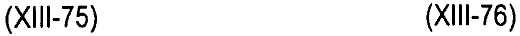

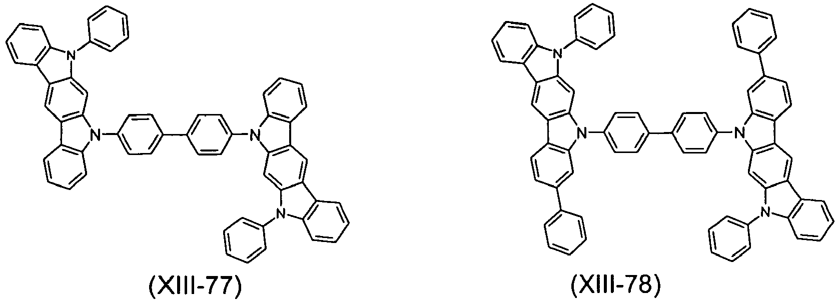

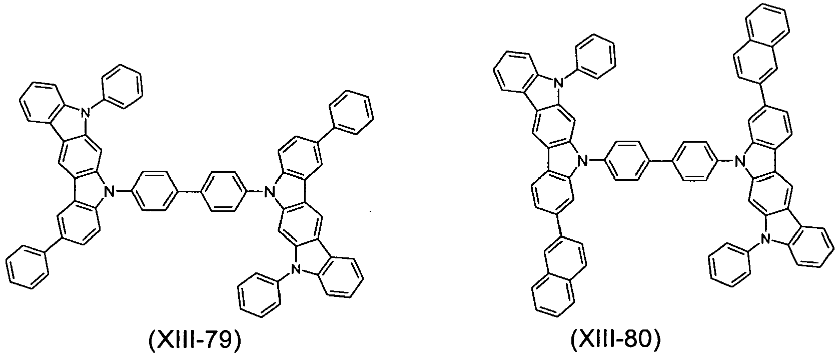

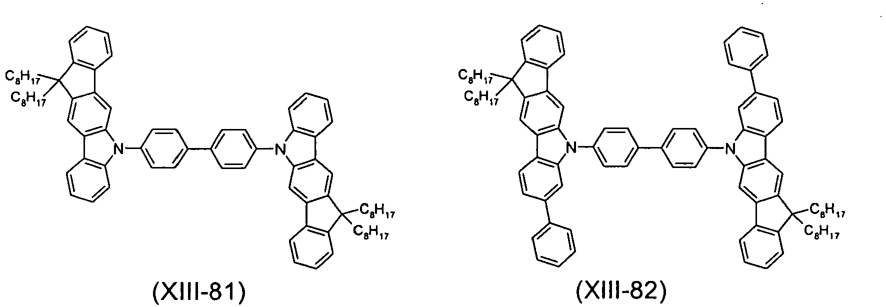

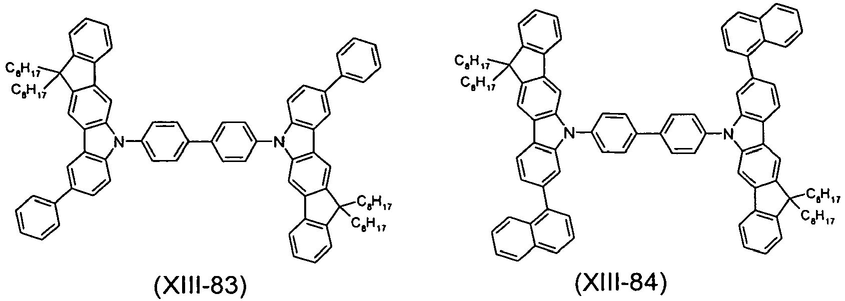

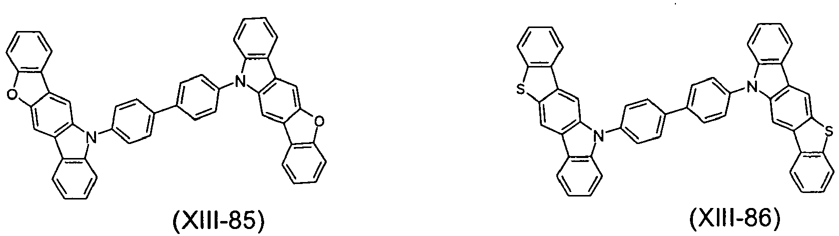

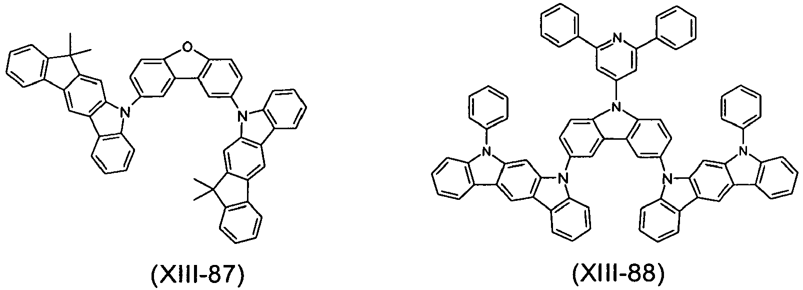

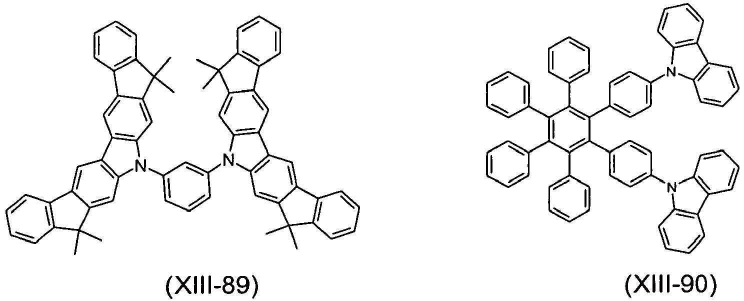

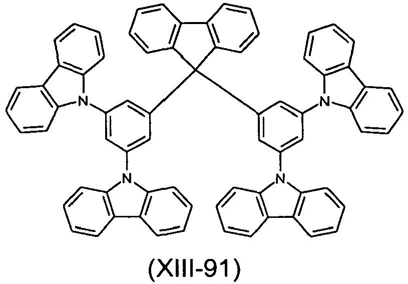

Die erfindungsgemäß eingesetzten Carbazolverbindungen gemäß Formel (XIII) können nach Standardmethoden der organischen Chemie synthetisiert werden, wie auch in der WO 2008/086851 ausführlich offenbart. Der Inhalt dieser Schrift ist via Zitat Bestandteil der vorliegenden Erfindung.

So ist bekannt, dass 2-Nitrobiphenylderivate mit einem Trialkylphosphit zu den entsprechenden Carbazolderivaten umgesetzt werden können (M. Tavasli et al., Synthesis 2005, S. 1619-1624). Diese Reaktion lässt sich zum Aufbau von 2-Aryl-substituierten Carbazolderivaten verwenden, indem zunächst ein entsprechendes Aryl-substituiertes 2-Nitrobiphenylderivat aufgebaut wird, welches anschließend mit Trialkylphosphit umgesetzt wird. Das 2-Aryl-substituierte Carbazolderivat lässt sich mit einem Dibromaromaten in einer Hartwig-Buchwald-Kupplung unter Standardbedingungen zur Verbindung gemäß Formel (XIII) kuppeln. Die verschiedenen Ausführungsmethoden und Reaktionsbedingungen der Hartwig-Buchwald-Kupplung sind dem Fachmann der organischen Synthese bekannt. Statt eines Dibromaromaten lassen sich auch entsprechende Verbindungen mit anderen Abgangsgruppen, beispielsweise Chlor, Iod, Triflat, Tosylat oder allgemein Sulfonate, verwenden. Durch Verwendung von trisubstituierten Aromaten oder Verbindungen mit nochmals mehr Abgangsgruppen lassen sich entsprechend Verbindungen gemäß Formel (XIII) synthetisieren, in denen der Index w für 2 oder mehr steht.

Die Synthese von Verbindungen gemäß Formel (XIII) ist im folgenden Schema 1 abgebildet, wobei der Übersichtlichkeit halber w = 1 gewählt wurde und keine Substituenten R oder R⁶ abgebildet sind:

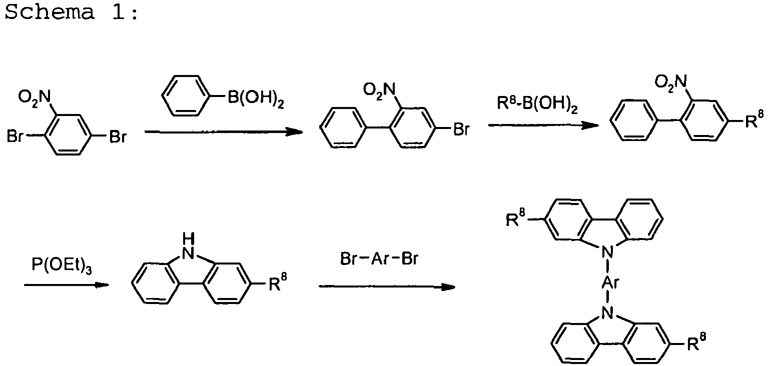

Zusätzlich oder alternativ zu den oben genannten Carbazolverbindungen kann als Host-Molekül eine neutrale Verbindung, die bevorzugt eine reine Kohlenwasserstoffverbindung, insbesondere eine aromatische Kohlenwasserstoffverbindung, ist, enthalten sein.

Besonders bevorzugt sind hierbei neutrale Verbindungen gemäß den allgemeinen Formeln (XIV) oder (XV) 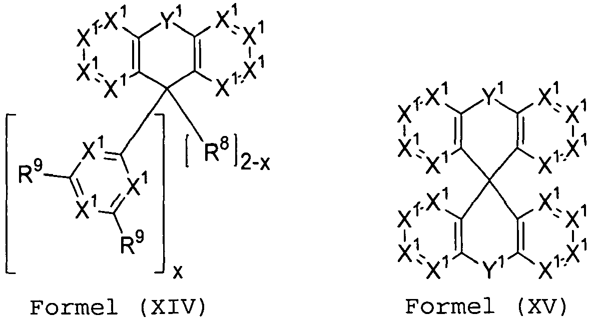 wobei für die verwendeten Symbole und Indices gilt:
- X¹: ist bei jedem Auftreten gleich oder ver-schieden CR⁸; oder zwei direkt benachbarte Gruppen X¹ stehen für eine Einheit der fol-genden Formel (XVI) 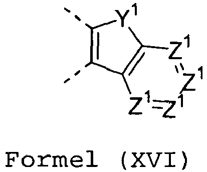
wobei die gestrichelten Bindungen die Verknüpfung der Einheit mit den benachbarten C-Atomen andeuten;
- Y¹: ist bei jedem Auftreten gleich oder ver-schieden eine Einfachbindung oder eine Grup-pe ausgewählt aus C(R⁸)₂, C(=C(R⁸)₂), Si(R⁸)₂, C(R⁸)₂-C(R⁸)₂, oder CR⁸=CR⁸;
- Z¹: ist bei jedem Auftreten gleich oder ver-schieden CR⁸;
- R⁸: ist bei jedem Auftreten gleich oder ver-schieden H, D, eine geradkettige Alkyl-, Alkenyl- oder Alkinylgruppe mit 1 bis 40 C-Atomen oder eine verzweigte oder cyclische Alkyl-, Alkenyl- oder Alkinylgruppe mit 3 bis 40 C-Atomen, die jeweils mit einem oder mehreren Resten R¹⁰ substituiert sein kann, oder ein aromatisches oder heteroaroma-tisches Ringsystem mit 5 bis 60 aromatischen Ringatomen, das jeweils durch einen oder mehrere Reste R⁹ substituiert sein kann, oder eine Kombination dieser Systeme; dabei können zwei oder mehrere benachbarte Substi-tuenten R⁸ auch miteinander ein mono- oder polycyclisches, aliphatisches oder aromati-sches Ringsystem bilden; oder eine Einheit gemäß der allgemeinen Formel (XVII) 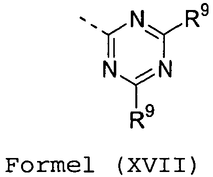
wobei die gestrichelten Bindungen die Verknüpfung der Einheit mit den benachbarten C-Atomen andeutet;
- R⁹: ist bei jedem Auftreten gleich oder ver-schieden H, D oder ein aromatisches oder he-teroaromatisches Ringsystem mit 5 bis 60 aromatischen Ringatomen, welches durch einen oder mehrere Reste R⁸ substituiert sein kann;
- R¹⁰: ist bei jedem Auftreten gleich oder ver-schieden H, D oder ein aliphatischer, aroma-tischer und/oder heteroaromatischer Kohlen-wasserstoffrest mit 1 bis 20 C-Atomen, in dem auch H-Atome durch F ersetzt sein kön-nen; dabei können zwei oder mehrere benach-barte Substituenten R¹⁰ auch miteinander ein mono- oder polycyclisches, aliphatisches oder aromatisches Ringsystem bilden; und
- x: ist 1 oder 2.

Bevorzugt weisen die neutralen Verbindungen und damit auch die Verbindungen gemäß Formel (XIV), eine Glasübergangstemperatur Tg von größer als 70°C, besonders bevorzugt von größer als 100°C und ganz besonders bevorzugt größer als 110°C, auf.

Wie aus der Formel (XIV) hervorgeht, bedeutet x = 2, dass in der Verbindung zwei Arylreste, welche in 3,5-Position substituiert sind, in der 9,9-Position des Fluorens bzw. des entsprechenden Derivats gebunden sind, während x = 1 bedeutet, dass ein solcher Arylrest vorhanden ist und weiterhin eine Gruppe R⁸.

In einer Ausführungsform der Erfindung steht vorzugsweise das Symbol X¹ gleich oder verschieden bei jedem Auftreten für CR⁸.

Das Symbol Z¹ in der Einheit gemäß Formel (XIV) steht vorzugsweise für CR⁸.

Eine bevorzugte Ausführungsform der Verbindungen gemäß Formel (XIV) sind die Verbindungen gemäß Formel (XVIII), (XIX) und (XX): 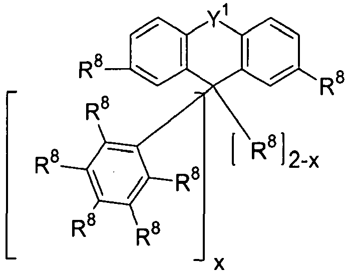 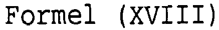 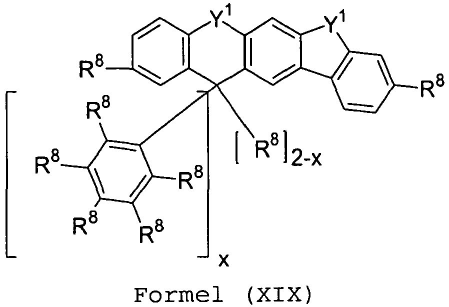 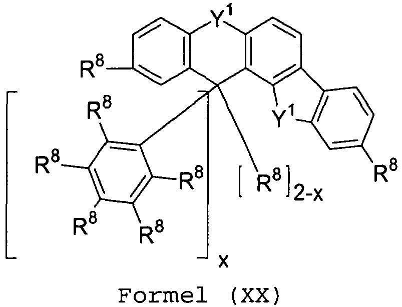 wobei die verwendeten Symbole und Indices die oben aufgeführten Bedeutungen haben.

Bevorzugt sind ferner die Verbindungen gemäß den Formeln (XXI), (XXII) und (XXIII): 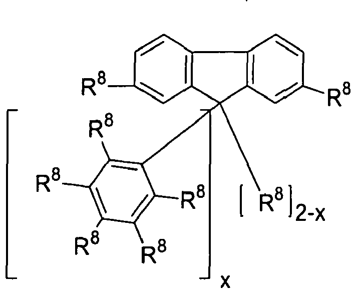 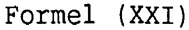 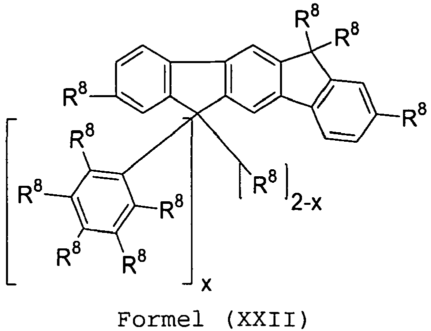 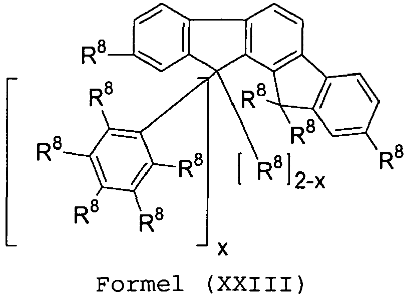 wobei die verwendeten Symbole und Indices die oben genannten Bedeutungen haben.

In einer bevorzugten Ausführungsform der Erfindung ist x = 2.

Eine weitere bevorzugte Ausführungsform der Verbindungen gemäß Formel (XIV) sind die Verbindungen gemäß Formel (XXIV): 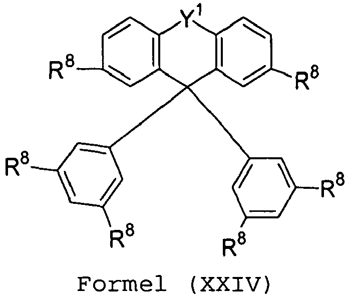 wobei die verwendeten Symbole die oben aufgeführten Bedeutungen haben.

Eine besonders bevorzugte Ausführungsform der vorliegenden Erfindung sind die Verbindungen der folgenden Formeln (XXV), (XXVI) und (XXVII): 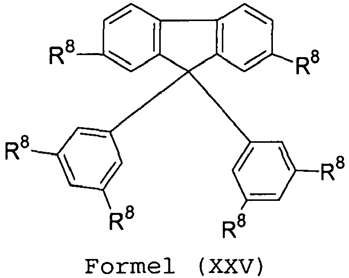 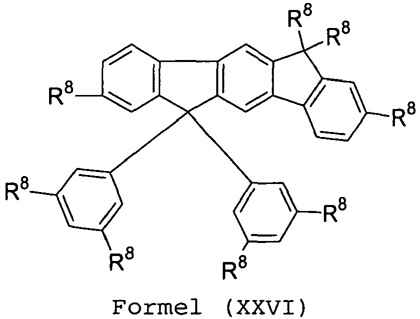 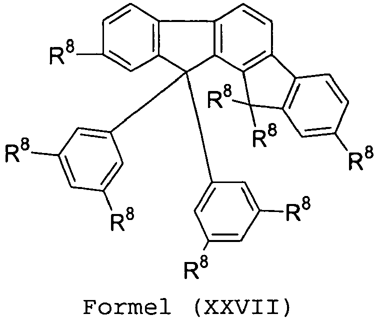 wobei die verwendeten Symbole und Indices die oben genannten Bedeutungen haben.

In einer weiteren Ausführungsform der vorliegenden Erfindung steht das Symbol R⁸ in Verbindungen der oben genannten Formeln (XIV) bis (XXVII) gleich oder verschieden bei jedem Auftreten für ein aromatisches oder heteroaromatisches Ringsystem mit 5 bis 30 aromatischen Ringatomen, welches durch einen oder mehrere nicht-aromatische Reste R⁸ substituiert sein kann. Weiterhin bevorzugte Substituenten R⁸ sind Halogen, vorzugsweise Br und I, O-Tosylat, O-Triflat, O-SO₂R¹⁰, B(OR¹⁰)₂ und Sn(R¹⁰)₃, besonders bevorzugt Br, da dies wertvolle Intermediate bei der Synthese weiterer erfindungsgemäßer Verbindungen sind.

In einer weiteren bevorzugten Ausführungsform der Erfindung sind alle Symbole R⁸ in Verbindungen der oben genannten Formeln (XIV) bis (XXVII) gleich gewählt. Diese Bevorzugung lässt sich durch die leichtere synthetische Zugänglichkeit der Verbindungen erklären. Beispiele für bevorzugte Verbindungen gemäß den Formeln (XIV) bis (XXVII) sind die im Folgenden abgebildeten Strukturen (XIV-1) bis (XIV-32).

| | |
|---|---|
| 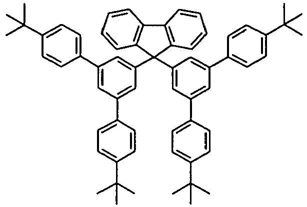 | 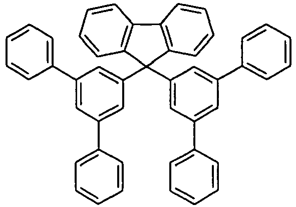 |
| (XIV-1) | (XIV-2) |
| 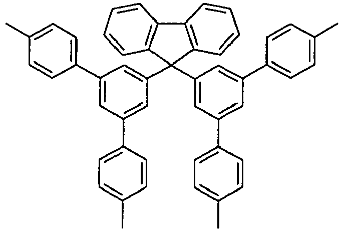 | 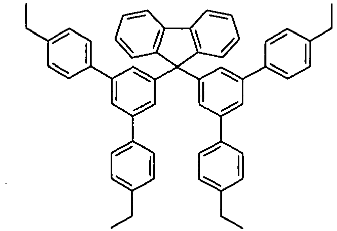 |
| (XIV-3) | (XIV-4) |
| 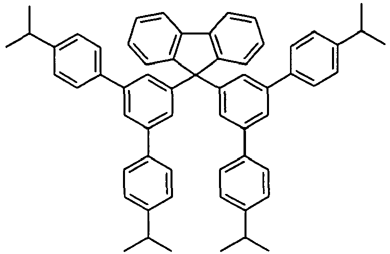 | 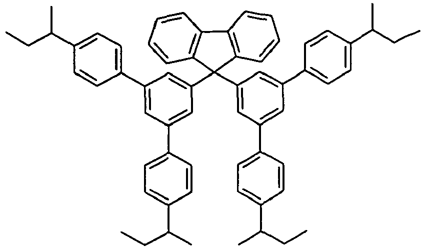 |
| (XIV-5) | (XIV-6) |
| 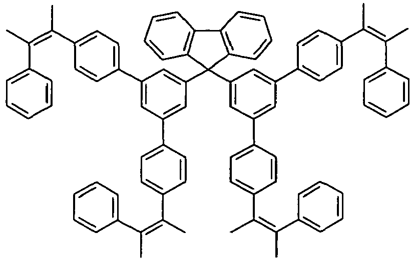 | 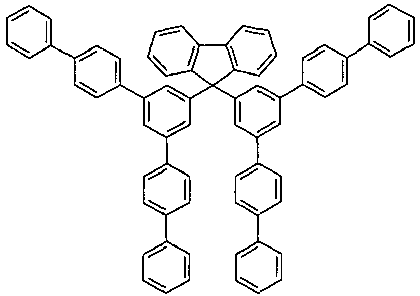 |
| (XIV-7) | (XIV-8) |
| 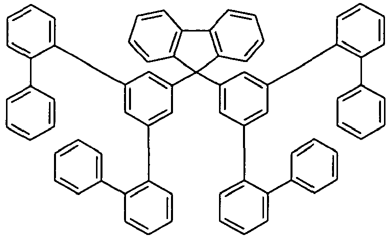 | 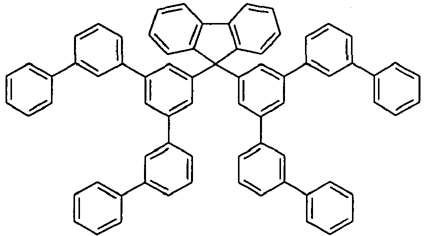 |
| (XIV-9) | (XIV-10) |
| 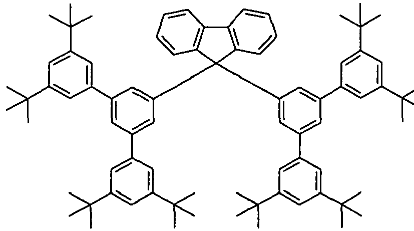 | 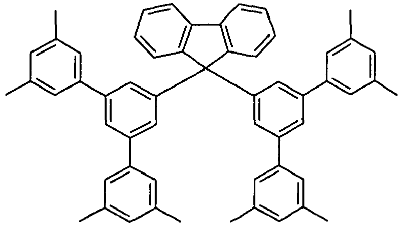 |
| (XIV-11) | (XIV-12) |
| 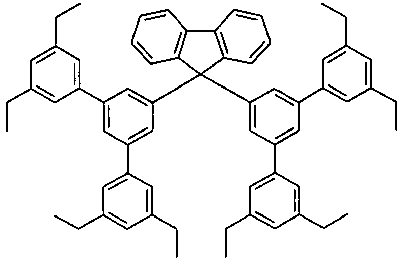 | 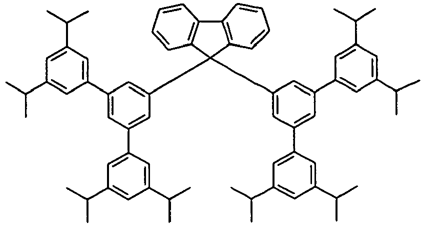 |
| (XIV-13) | (XIV-14) |
| 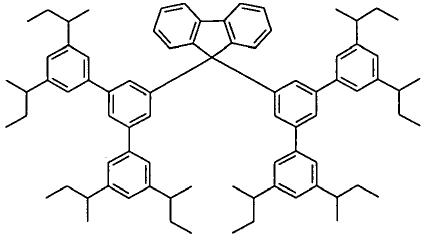 | 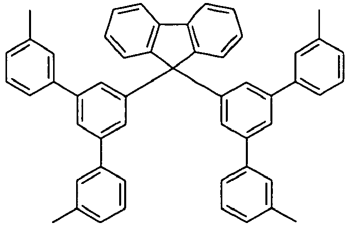 |
| (XIV-15) | (XIV-16) |
| 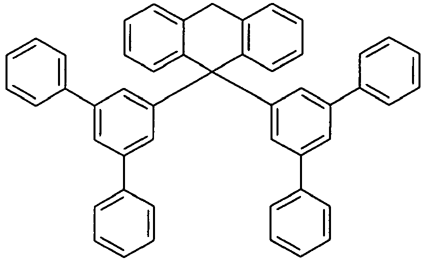 | 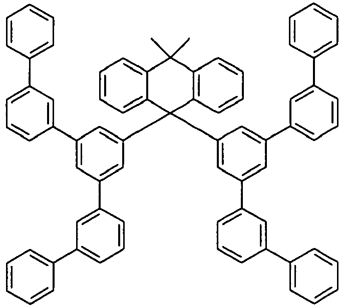 |
| (XIV-17) | (XIV-18) |
| 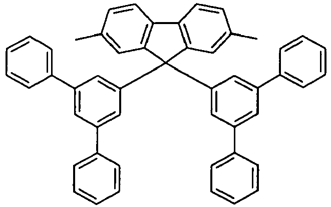 | 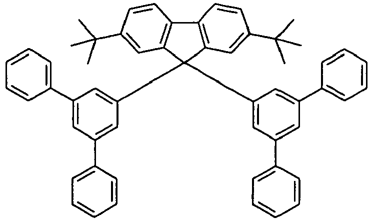 |
| (XIV-19) | (XIV-20) |
| 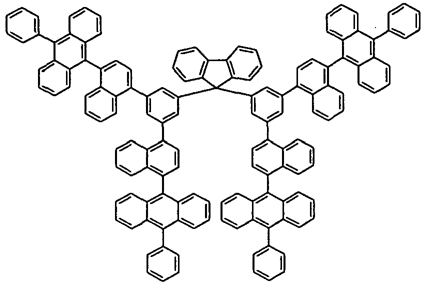 | 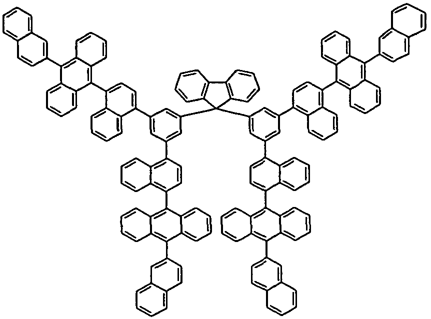 |
| (XIV-21) | (XIV-22) |
| 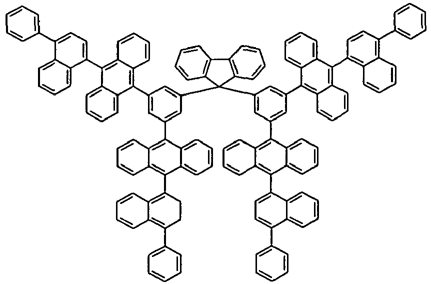 | 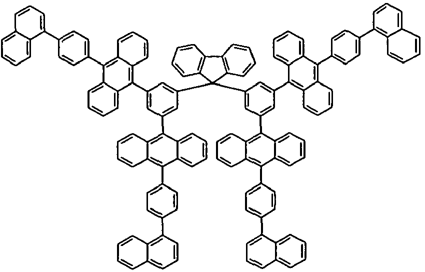 |
| (XIV-23) | (XIV-24) |
| 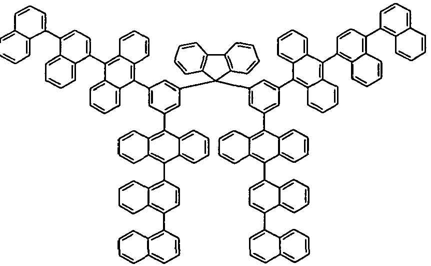 | 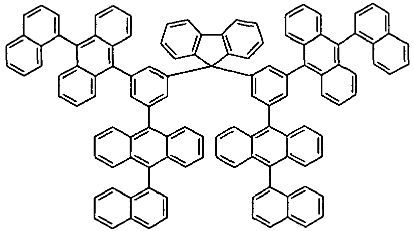 |
| (XIV-25) | (XIV-26) |
| 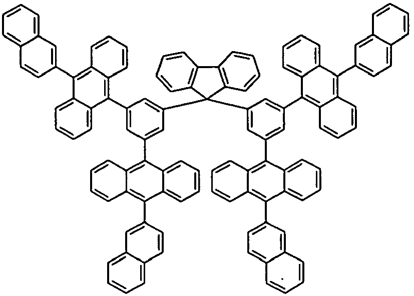 | 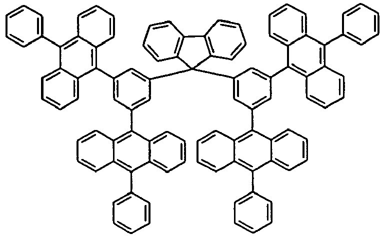 |
| (XIV-27) | (XIV-28) |
| 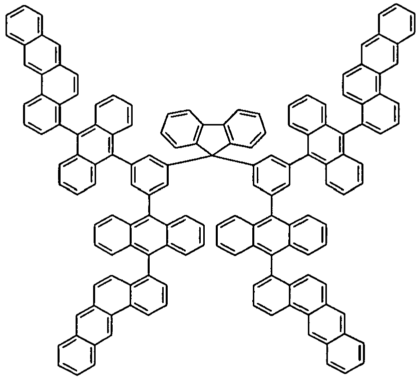 | 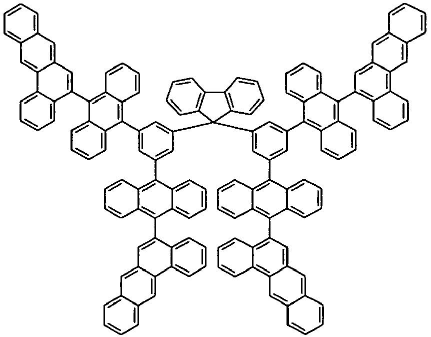 |
| (XIV-29) | (XV-30) |
| 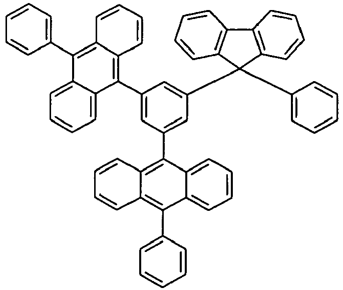 | 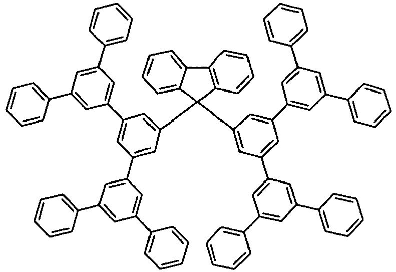 |
| (XIV-31) | (XIV-32) |

Eine besonders bevorzugt Verbindung gemäß Formel (XV) ist dabei die Verbindung gemäß Formel (XV-1)

| |
|---|
| 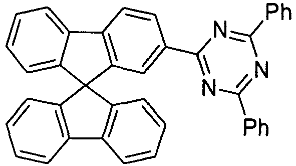 |
| (XV-1) |

Gemäß einer weiteren Ausführungsform der vorliegenden Erfindung ist die neutrale Verbindung eine Verbindung gemäß Formel (XXVIII): 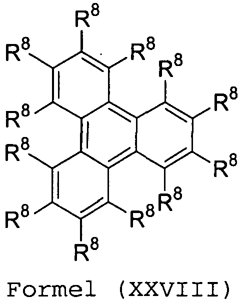 wobei R⁸ die in Bezug auf Formel (XIV) angegebenen Bedeutungen annehmen kann.

Gemäß noch einer weiteren Ausführungsform der vorliegenden Erfindung ist die neutrale Verbindung eine Verbindung gemäß Formel (XXIX): 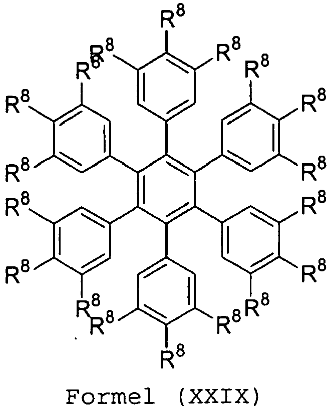 wobei R⁸ die in Bezug auf Formel (XIV) angegebenen Bedeutungen annehmen kann.

Eine besonders bevorzugte neutrale Verbindung der Formel (XXIX) ist die folgende Struktur:

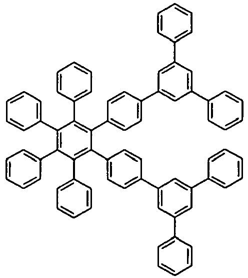

Die erfindungsgemäßen Verbindungen gemäß Formel (XIV) können nach dem Fachmann allgemein bekannten Syntheseschritten dargestellt werden. Als Ausgangsverbindung zu symmetrisch substituierten erfindungsgemäßen Verbindungen kann z.B. 3,3',5,5'-Tetrabrombenzophenon (Eur. J. Org. Chem. 2006, S. 2523-2529) dienen. Dieses kann z.B. gemäß Schema 2 durch Umsetzung mit einem substituierten oder unsubstituierten 2-Lithiobiphenyl, 2-Lithiodiphenylether, 2-Lithiodiphenylthioether, 2-(2-Lithiophenyl)-2-phenyl-1,3-dioxolan oder 2-Lithiophenyldiphenylamin zu den entsprechenden Triarylmethanolen umgesetzt werden, die dann sauer, z.B. in Gegenwart von Essigsäure und einer Mineralsäure, wie Bromwasserstoff, cyclisiert werden. Die für diese Umsetzung benötigten Organolithiumverbindungen können durch Transmetallierung der entsprechenden Arylbromide (2-Brombiphenyl, 2-Bromdiphenylether, 2-Bromdiphenylthioether, 2-(2-Bromphenyl)-2-phenyl-1,3-dioxolan, 2-Bromphenyl-diphenylamin, etc.) mit Alkyllithiumverbindungen, wie *n*-Butyllithium, dargestellt werden. Analog dazu ist es selbstverständlich möglich, die entsprechenden GrignardVerbindungen einzusetzen.

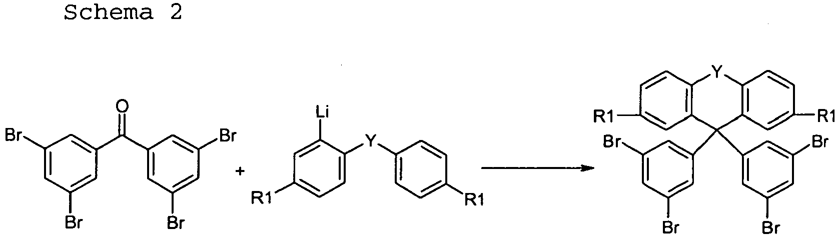

Die so erzeugten Tetrabromide können nach dem Fachmann bekannten Methoden weiter umgewandelt werden. Die palladiumkatalysierte Umsetzung mit Boronsäuren (Suzuki-Kuppung) oder palladiumkatalysierte Umsetzung mit Organozinkverbindungen (Negishi-Kupplung) führt zu erfindungsgemäßen aromatischen oder heteroaromatischen Verbindungen (Schema 3).

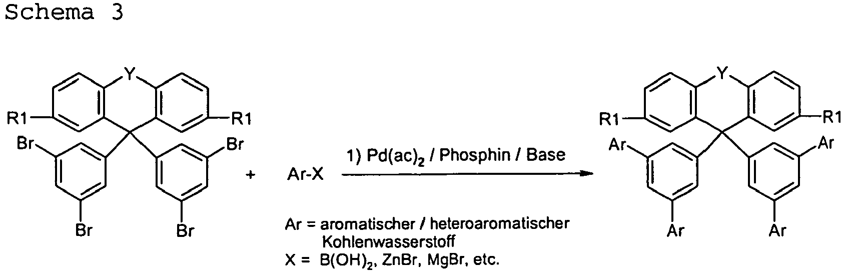

Die Bromfunktion kann durch Transmetallierung mit Organolithiumverbindungen bzw. Grignardverbindungen in eine elektrophile Gruppe überführt werden, die dann mit einer Vielzahl von Elektrophilen, wie z.B. Aryl-Bor-Halogeniden, Aldehyden, Ketonen, Nitrilen, Estern, Halogenestern, Kohlendioxid, Arylphosphinhalogeniden, Halogensulfinsäuren, Halogenarylsulfonsäuren, etc., gekoppelt werden, wobei die so erhaltenen Verbindungen erfindungsgemäße Endprodukte oder aber Intermediate sein können, die weiter umgesetzt werden können.

Unsymmetrisch substituierte erfindungsgemäße Verbindungen können durch die Sequenz gemäß Schema 4 ausgehend von Fluorenon und analogen Arylketonen durch Addition einer Aryl-Metallverbindung, z.B. 1-Lithio-3,5-dibrombenzol, an die Carbonylfunktion, Umwandlung des Bromaromaten nach einer der oben genannten Methoden unter Aufbau der einen Funktionalität und anschließender Einführung der anderen Funktionalität via säurekatalysierter Friedel-Crafts-Arylierung an 1,3-Dibrombenzol und Umwandlung des Bromaromaten nach einer der oben genannten Methoden erhalten werden (s. z.B. Org. Lett. 2001, 3(15), S. 2285.).

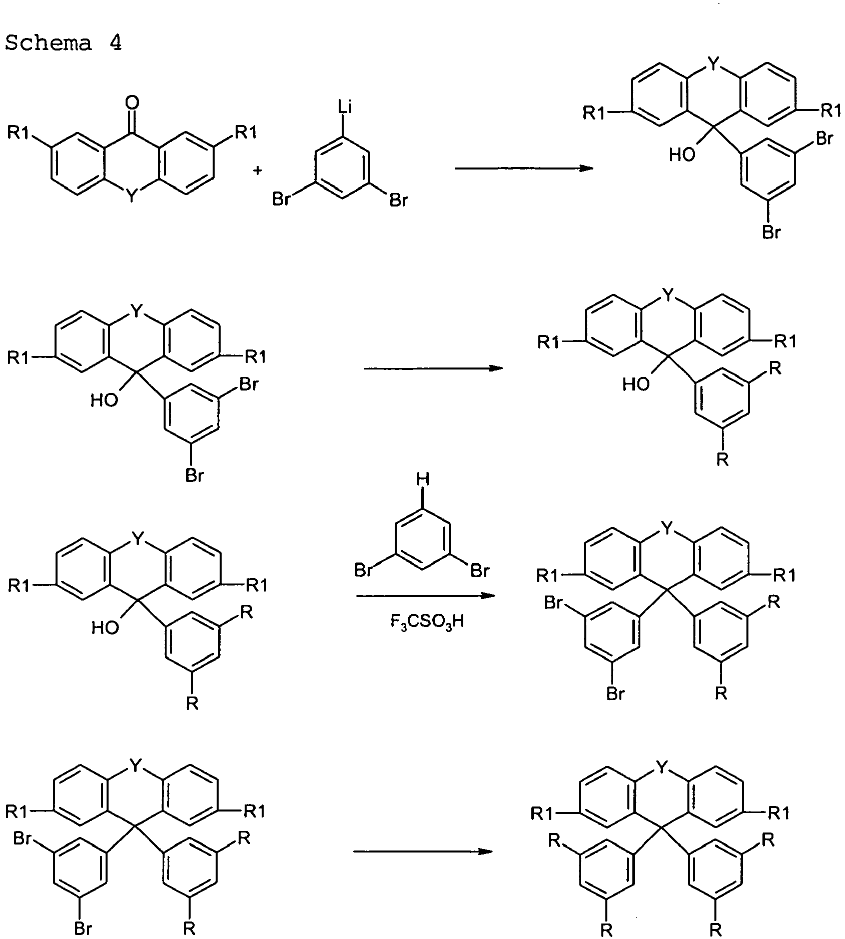

In den oben angegebenen Schemata bedeuten y = y¹ und R oder R1 = R⁸.

Die entsprechenden Indenofluorenderivate, Indenocarbazolderivate und die weiteren Derivate der Formel (XIV) lassen sich entsprechend synthetisieren.

Die oben beschriebenen erfindungsgemäß eingesetzten Verbindungen, insbesondere Verbindungen, welche mit reaktiven Abgangsgruppen, wie Brom, Iod, Triflat, Tosylat, Boronsäure oder Boronsäureester, substituiert sind, können als Monomere zur Erzeugung entsprechender Dimere, Trimere, Tetramere, Pentamere, Oligomere, Polymere oder als Kern von Dendrimeren Verwendung finden. Die Oligomerisation bzw. Polymerisation erfolgt dabei vorzugsweise über die Halogenfunktionalität bzw. die Boronsäurefunktionalität.

Zusätzlich oder alternativ zu den oben genannten Carbazolverbindungen bzw. zu den zuvor beschriebenen neutralen Verbindungen können ebenso neutrale Verbindungen, auch neutrale Verbindungen der allgemeinen Formel (XXX) 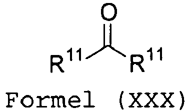 enthalten sein, wobei
- R¹¹: ein aromatisches oder heteroaromatisches Ringsystem mit 5 bis 60 aromatischen Ring-atomen, das jeweils durch einen oder mehrere Reste R⁹ substituiert sein kann, oder eine Kombination dieser Systeme; dabei können zwei oder mehrere benachbarte Substituenten R¹⁰ auch miteinander ein mono- oder poly-cyclisches, aliphatisches oder aromatisches Ringsystem bilden; oder eine Einheit gemäß der allgemeinen Formel (XXXI) 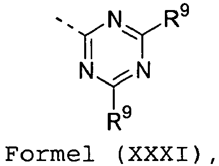
wobei die gestrichelten Bindungen die Verknüpfung der Einheit mit dem C-Atom der Ketogruppe andeuten.

Besonders bevorzugte Host-Moleküle weisen dabei elektronentransportierende Funktionalität auf und sind insbesondere ausgewählt aus der Gruppe bestehend aus den nachfolgend abgebildeten Verbindungen

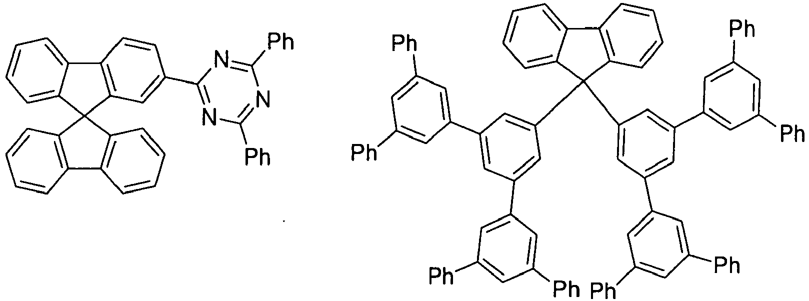

Alternativ oder zusätzlich hierzu kann das Host-Molekül auch lochtransportierende Funktionalitäten aufweisen, insbesondere ist es dann ausgewählt aus der Gruppe bestehend aus den nachfolgend abgebildeten Verbindungen

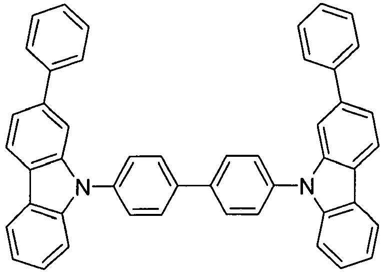

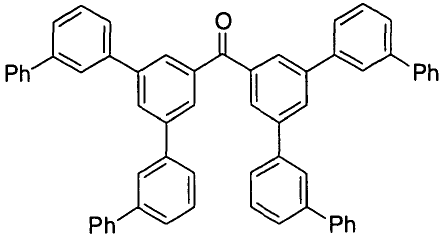

Wie oben bereits ausgeführt, enthält die erfindungsgemäße Mischung bzw. der erfindungsgemäße Blend auch ein Emitter-Molekül. Ein Emitter-Molekül bzw. eine Emitter-Verbindung (phosphoreszierende Verbindung) im Sinne der vorliegenden Erfindung ist eine Verbindung, welche bei Raumtemperatur Lumineszenz aus einem angeregten Zustand mit höherer Spinmultiplizität zeigt, also einem Spinzustand > 1, insbesondere aus einem angeregten Triplettzustand. Im Sinne der vorliegenden Erfindung sollen alle lumineszierenden Übergangsmetallkomplexe mit Übergangsmetallen der zweiten und dritten Übergangsmetallreihe, insbesondere alle lumineszierenden Iridium-, Platin- und Kupferverbindungen als phosphoreszierende Verbindungen angesehen werden.

In einer bevorzugten Ausführungsform der vorliegenden Erfindung handelt es sich bei der Triplett-Emitter-Verbindung um eine rot phosphoreszierende Verbindung oder um eine grün phosphoreszierende Verbindung.

Als Triplett-Emitterverbindung (phosphoreszierende Verbindung) eignen sich insbesondere Verbindungen, die bei geeigneter Anregung Licht, vorzugsweise im sichtbaren Bereich, emittieren und außerdem mindestens ein Atom der Ordnungszahl größer 20, vorzugsweise größer 38 und kleiner 84, besonders bevorzugt größer 56 und kleiner 80 enthalten. Bevorzugt werden als Triplett-Emitter-Verbindung Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Besonders bevorzugte erfindungsgemäße Mischungen enthalten als Triplett-Emitterverbindung eine Verbindung der Formeln (21) bis (24), 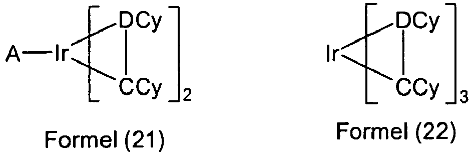 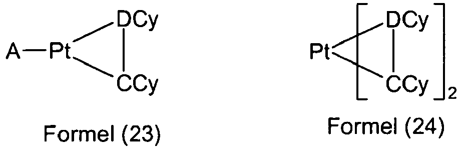 wobei für die verwendeten Symbole gilt:
- DCy: ist gleich oder verschieden bei jedem Auftreten eine cyclische Gruppe, die mindestens ein Donor-atom, vorzugsweise Stickstoff, Kohlenstoff in Form eines Carbens oder Phosphor, enthält, über welches die cyclische Gruppe an das Metall ge-bunden ist, und die wiederum einen oder mehrere Substituenten R¹² tragen kann; die Gruppen DCy und CCy sind über eine kovalente Bindung mitei-nander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹⁴ tragen kann;
- A: ist gleich oder verschieden bei jedem Auftreten ein monoanionischer, zweizähnig chelatisierender Ligand, bevorzugt ein Diketonatligand;
- R¹²: ist bei jedem Auftreten gleich oder verschieden H, D, F, CN, N(R¹³)₂, eine geradkettige, ver-zweigte oder cyclische Alkyl-, Alkoxy- oder Thioalkoxygruppe mit 1 bis 40 C-Atomen, die mit R¹⁴ substituiert oder auch unsubstituiert sein kann, wobei eine oder mehrere nicht benachbarte CH₂-Gruppen durch -R¹⁵C=CR¹⁵-, -C=C-, Si (R¹⁵)₂, Ge(R¹⁵)₂, Sn(R¹⁵)₂, C=O, C=S, C=Se, C=NR¹⁵, -O-, - S-, -NR¹⁵ oder -CONR¹⁵- ersetzt sein können und wobei ein oder mehrere H-Atome durch F, Cl, Br, I, CN oder NO₂ ersetzt sein können, oder ein aromatisches oder heteroaromatisches Ringsystem mit 1 bis 60 C-Atomen, das mit einem oder mehre-ren Resten R¹⁹ substituiert sein kann, wobei zwei oder mehrere Substituenten R¹² auch zusam-men mit den Atomen, an die sie gebunden sind, miteinander ein mono- oder polycyclisches, ali-phatisches oder aromatisches Ringsystem bilden können; wobei mindestens eine Gruppe R¹² eine Bindung zu einer weiteren Struktureinheit des Polymers aufweist;
- R¹³: ist bei jedem Auftreten gleich oder verschieden eine geradkettige, verzweigte oder cyclische Al-kyl- oder Alkoxygruppe mit 1 bis 22 C-Atomen, in der auch ein oder mehrere nicht benachbarte C-Atome durch -R¹⁵C=CR¹⁵-, -C≡C-, Si(R¹⁵)₂, Ge(R¹⁵)₂, Sn(R¹⁵)₂, -NR¹⁵-, -O-, -S-, -CO-O- , -O-CO-O- er-setzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehre-re Reste R¹⁴ substituiert sein kann, oder OH oder N(R¹⁴)₂;
- R¹⁴: ist bei jedem Auftreten gleich oder verschieden R¹⁵ oder CN, B(R¹⁵)₂ oder Si(R¹⁵)₃;
- R¹⁵: ist bei jedem Auftreten gleich oder verschieden H, D oder ein aliphatischer oder aromatischer Kohlenwasserstoffrest mit 1 bis 20 C-Atomen.

Dabei kann durch Bildung von Ringsystemen zwischen mehreren Resten R¹² auch eine Brücke zwischen den Gruppen DCy und CCy vorliegen. Weiterhin kann durch Bildung von Ringsystemen zwischen mehreren Resten R¹² auch eine Brücke zwischen zwei oder drei Liganden CCy-DCy bzw. zwischen ein oder zwei Liganden CCy-DCy und dem Liganden A vorliegen, so dass es sich um ein polydentates bzw. polypodales Ligandensystem handelt.

Beispiele der oben beschriebenen Emitter können der WO 00/70655, der WO 01/41512, der WO 02/02714, der WO 02/15645, der EP 1 191 613, der EP 1 191 612, der EP 1 191 614, der WO 04/081017, der WO 05/033244, der WO 05/042550, der WO 05/113563, der WO 06/008069, der WO 06/061182, der WO 06/081973, der DE 10 2008 015 526, der DE 10 2008 027 005 und der DE 10 2009 007 038 entnommen werden. Generell eignen sich alle phosphoreszierenden Komplexe, wie sie gemäß dem Stand der Technik für phosphoreszierende OLEDs oder PLEDs verwendet werden und wie sie dem Fachmann auf dem Gebiet der organischen Elektrolumineszenz bekannt sind, und der Fachmann kann ohne erfinderisches Zutun weitere phosphoreszierende Verbindungen verwenden. Insbesondere ist dem Fachmann bekannt, welche phosphoreszierenden Komplexe mit welcher Emissionsfarbe emittieren.

Beispiele für geeignete phosphoreszierende Verbindungen sind die in der folgenden Tabelle aufgeführten Strukturen (T-1) bis (T-140).

| | | |
|---|---|---|
| 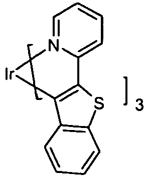 | 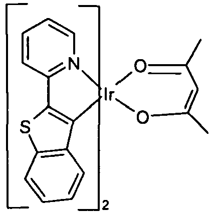 | 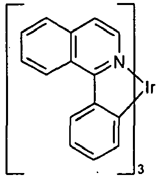 |
| (T-1) | (T-2) | (T-3) |
| 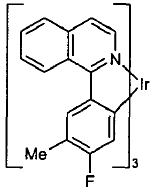 | 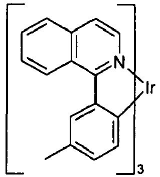 | 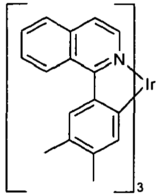 |
| (T-4) | (T-5) | (T-6) |
| 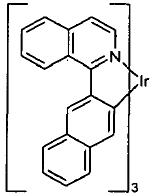 | 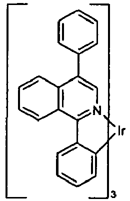 | 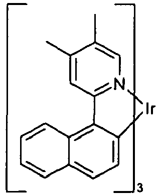 |
| (T-7) | (T-8) | (T-9) |
| 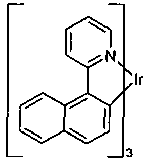 | 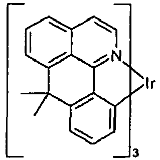 | 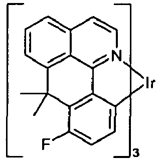 |
| (T-10) | (T-11) | (T-12) |
| 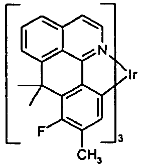 | 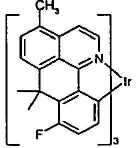 | 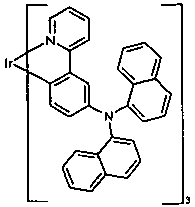 |
| (T-13) | (T-14) | (T-15) |
| 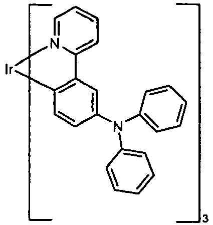 | 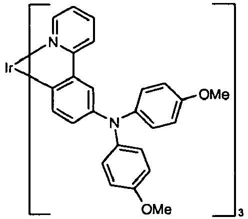 | 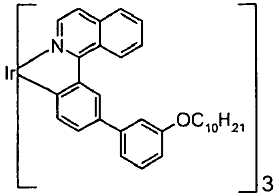 |
| (T-16) | (T-17) | (T-18) |
| 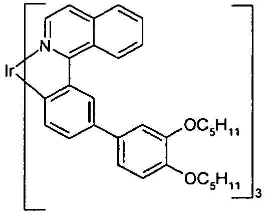 | 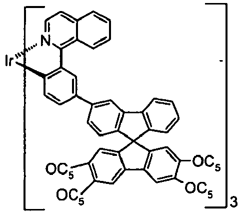 | 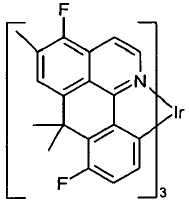 |
| (T-19) | (T-20) | (T-21) |
| 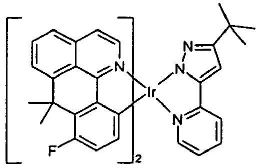 | 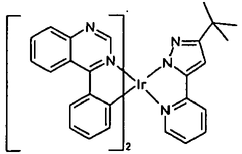 | 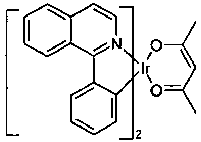 |
| (T-22) | (T-23) | (T-24) |
| 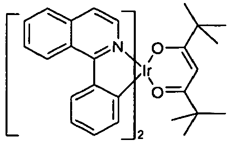 | 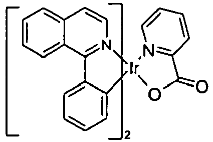 | 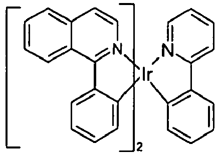 |
| (T-25) | (T-26) | (T-27) |
| 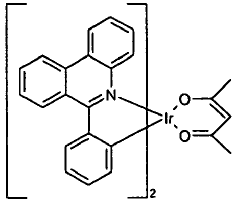 | 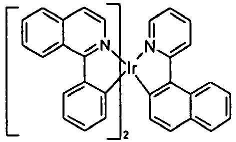 | 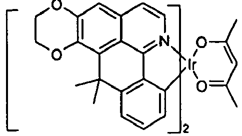 |
| (T-28) | (T-29) | (T-30) |
| 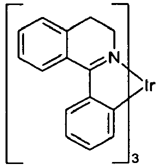 | 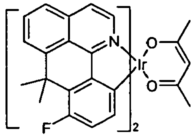 | 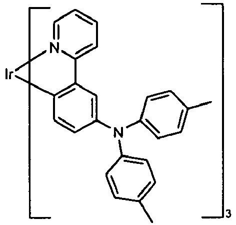 |
| (T-31) | (T-32) | (T-33) |
| 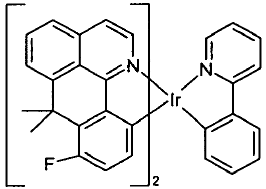 | 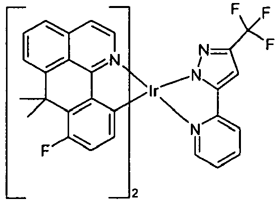 | 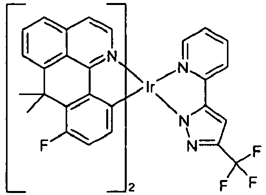 |
| (T-34) | (T-35) | (T-36) |
| 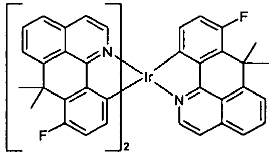 | 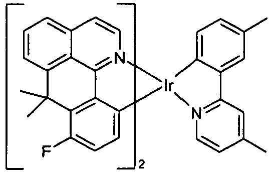 | 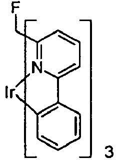 |
| (T-37) | (T-38) | (T-39) |
| 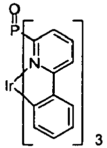 | 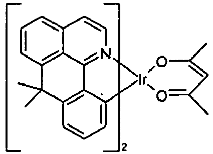 | 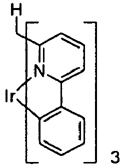 |
| (T-40) | (T-41) | (T-42) |
| 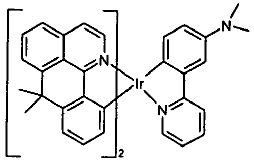 | 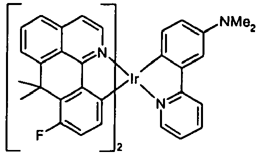 | 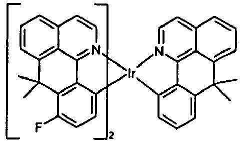 |
| (T-43) | (T-44) | (T-45) |
| 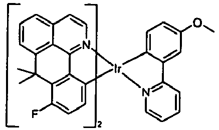 | 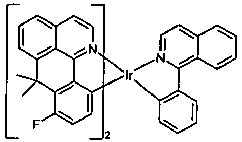 | 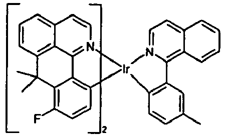 |
| (T-46) | (T-47) | (T-48) |
| 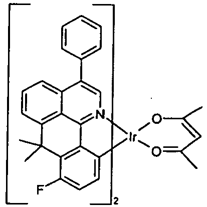 | 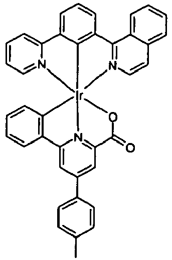 | 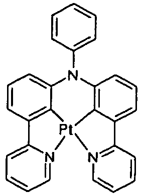 |
| (T-49) | (T-50) | (T-51) |
| 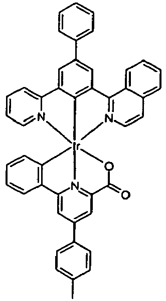 | 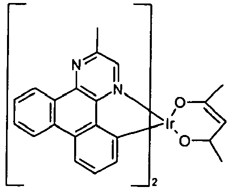 | 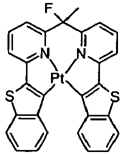 |
| (T-52) | (T-53) | (T-54) |
| 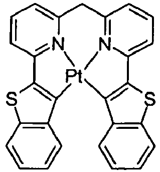 | 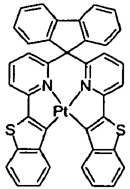 | 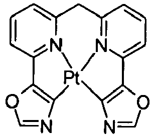 |
| (T-55) | (T-56) | (T-57) |
| 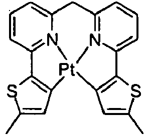 | 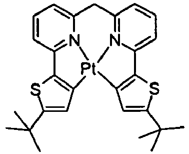 | 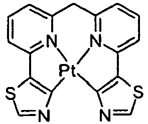 |
| (T-58) | (T-59) | (T-60) |
| 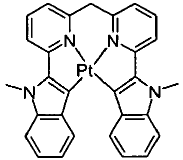 | 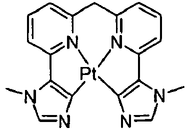 | 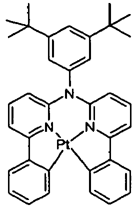 |
| (T-61) | (T-62) | (T-63) |
| 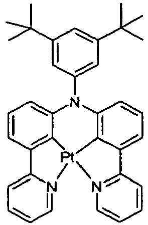 | 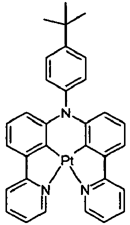 | 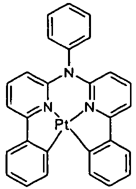 |
| (T-64) | (T-65) | (T-66) |
| 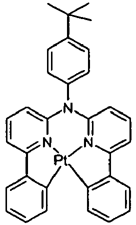 | 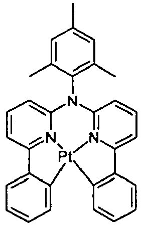 | 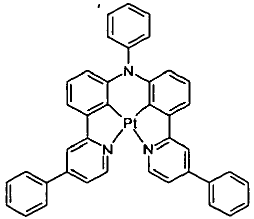 |
| (T-67) | (T-68) | (T-69) |
| 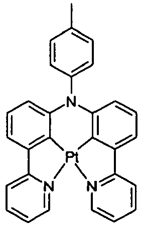 | 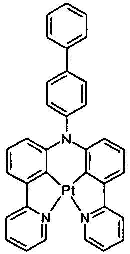 | 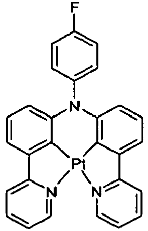 |
| (T-70) | (T-71) | (T-72) |
| 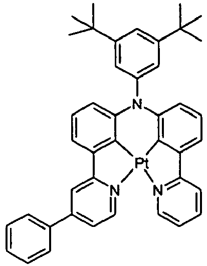 | 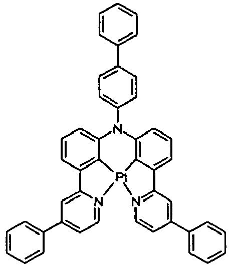 | 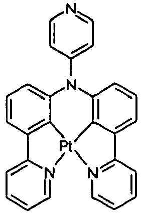 |
| (T-73) | (T-74) | (T-75) |
| 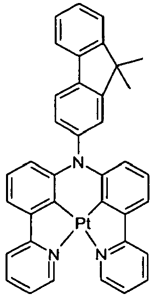 | 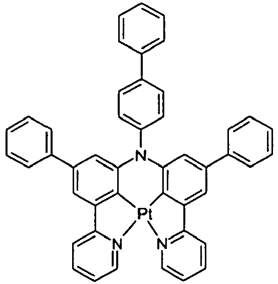 | 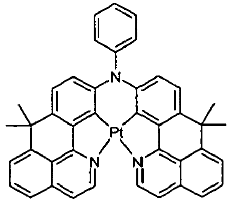 |
| (T-76) | (T-77) | (T-78) |
| 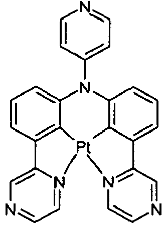 | 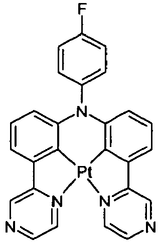 | 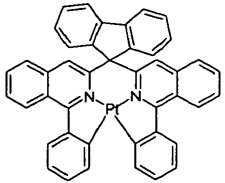 |
| (T-79) | (T-80) | (T-81) |
| 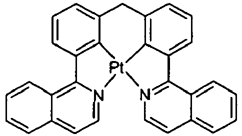 | 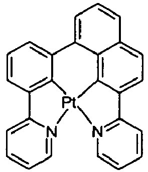 | 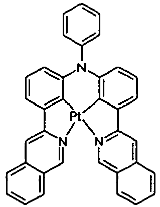 |
| (T-82) | (T-83) | (T-84) |
| 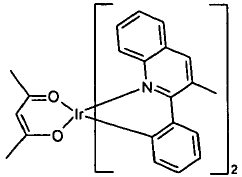 | 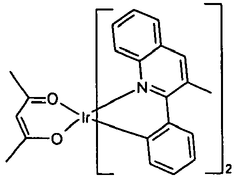 | 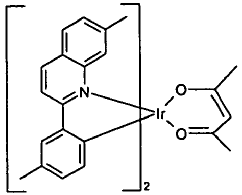 |
| (T-85) | (T-86) | (T-87) |
| 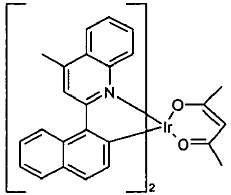 | 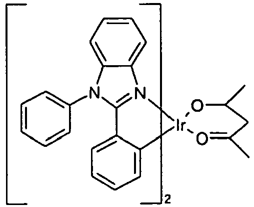 | 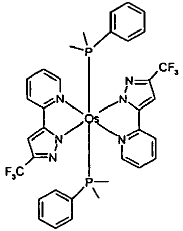 |
| (T-88) | (T-89) | (T-90) |
| 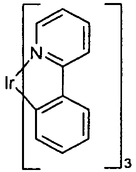 | 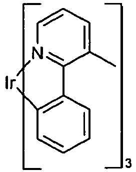 | 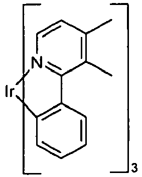 |
| (T-91) | (T-92) | (T-93) |
| 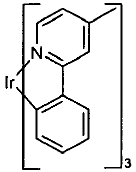 | 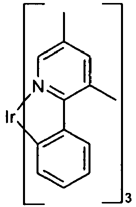 | 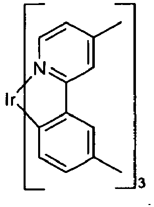 |
| (T-94) | (T-95) | (T-96) |
| 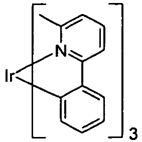 | 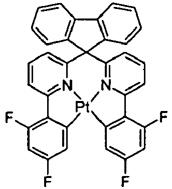 | 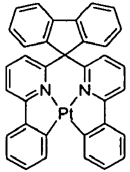 |
| (T-97) | (T-98) | (T-99) |
| 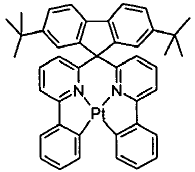 | 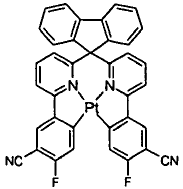 | 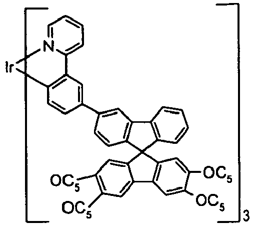 |
| (T-100) | (T-101) | (T-102) |
| 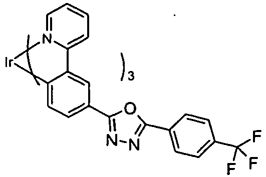 | 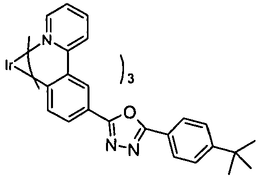 | 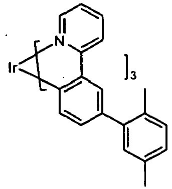 |
| (T-103) | (T-104) | (T-105) |
| 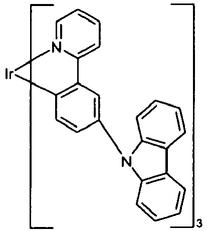 | 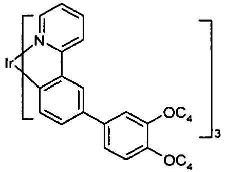 | 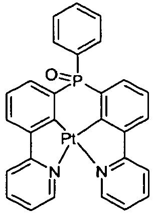 |
| (T-106) | (T-107) | (T-108) |
| 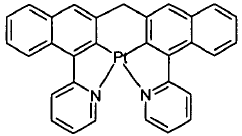 | 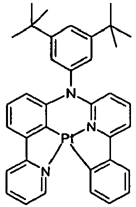 | 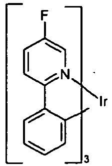 |
| (T-109) | (T-110) | (T-111) |
| 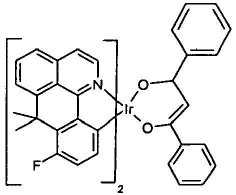 | 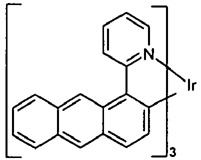 | 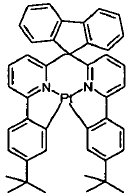 |
| (T-112) | (T-113) | (T-114) |
| 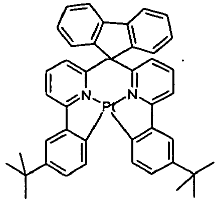 | 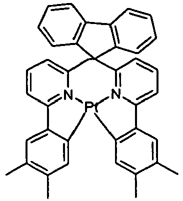 | 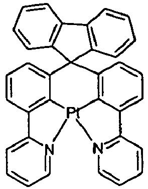 |
| (T-115) | (T-116) | (T-117) |
| 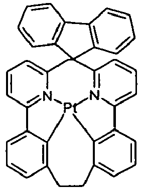 | 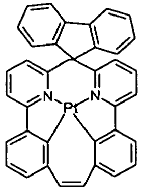 | 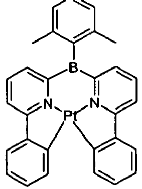 |
| (T-118) | (T-119) | (T-120) |
| 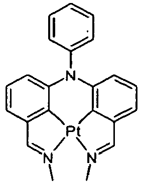 | 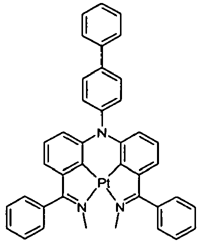 | 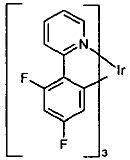 |
| (T-121) | (T-122) | (T-123) |
| 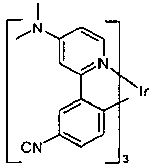 | 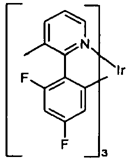 | 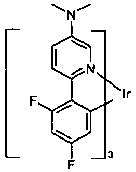 |
| (T-124) | (T-125) | (T-126) |
| 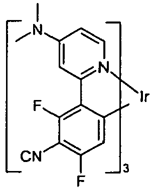 | 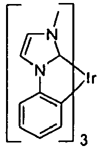 | 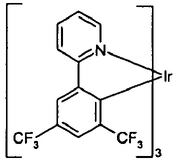 |
| (T-127) | (T-128) | (T-129) |
| 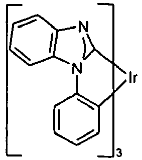 | 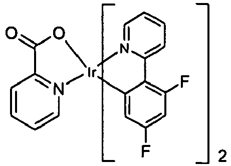 | 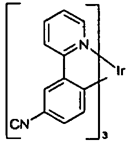 |
| (T-130) | (T-131) | (T-132) |
| 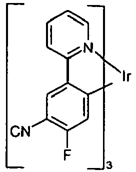 | 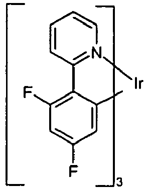 | 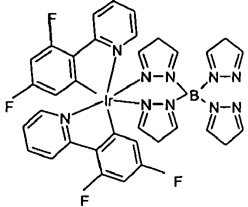 |
| (T-133) | (T-134) | (T-135) |
| 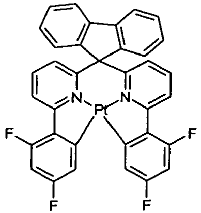 | 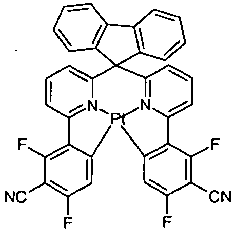 | 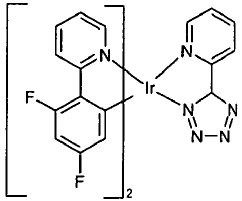 |
| (T-136) | (T-137) | (T-138) |
| 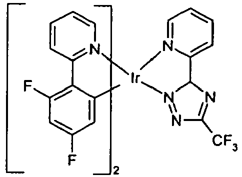 | 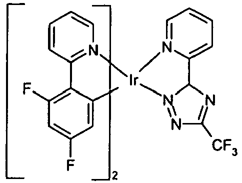 | |
| (T-139) | (T-140) | |

Die erfindungsgemäße Mischung enthält vorzugsweise:
a) 1 bis 70 Gew.-%, besonders bevorzugt 5 bis 60 Gew.-% und ganz besonders bevorzugt 10 bis 50 Gew.-% des mindestens einen Polymers bzw. Copolymers der allgemeinen Formel I,
b) 1 bis 70 Gew.-%, besonders bevorzugt 5 bis 60 Gew.-% und ganz besonders bevorzugt 10 bis 50 Gew.-% des mindestens einen Host-Moleküls, sowie
c) 0,1 bis 40 Gew.-%, besonders bevorzugt 0,5 bis 30 Gew.-% und ganz besonders bevorzugt 1 bis 25 Gew.-% Emittermolekül.

Weiter ist es bevorzugt, wenn
a) die Struktureinheit in den Seitenketten des mindestens einen Polymers oder Copolymers elektronentransportierende Funktionalität und das mindestens eine Host-Molekül lochtransportierende Funktionalität aufweist, oder
b) die Struktureinheit in den Seitenketten des mindestens einen Polymers oder Copolymers lochtransportierende Funktionalität und das mindestens eine Host-Molekül elektronentransportierende Funktionalität aufweist.

Das Grundgerüst des Polymers bzw. Copolymers ist dabei bevorzugt ein Polyethylen-Gerüst. Dieses Gerüst kann erhalten werden, indem die voranstehend beschriebenen polymerisierbaren Verbindungen beispielsweise eine vinylische Funktion aufweisen. Durch derartige Polymerisation können Homopolymere erhalten werden, die ein Polyethylen-Grundgerüst aufweisen, wobei jedes zweite Kohlenstoffatom der Kette mit einer Seitenkette gemäß der allgemeinen Formel (I) versehen ist.

Entsprechende Copolymere können durch Copolymerisation derartiger polymerisierbarer Verbindungen mit weiteren Monomeren, wie beispielsweise Ethylen, Propylen, Styrol, etc., erhalten werden.

Zudem betrifft die vorliegende Erfindung eine Formulierung, die einen Blend wie voranstehend beschrieben sowie mindestens eine weitere Komponente beinhaltet.

Bevorzugt ist dabei die mindestens eine weitere Komponente ausgewählt aus der Gruppe bestehend aus Lösungsmitteln, wobei die Formulierung in diesem Fall bevorzugt als Lösung, Dispersion, Suspension oder Aufschlämmung vorliegt; Lichtstabilisatoren; UV-Stablilisatoren; Flammschutzmitteln; Füllstoffe sowie Kombinationen hieraus.

Geeignete und bevorzugte Lösungsmittel sind beispielsweise Toluol, Anisol, Xylole, Methylbenzoat, Dimethylanisole, Trimethylbenzole, Tetralin, Veratrole, Tetrahydrofuran, Chlorbenzol oder Dichlorbenzol sowie Gemische derselben. Die Formulierungen als Lösung oder Dispersion oder Suspension eignen sich hervorragend zum Erzeugen oder Abscheiden von Schichten.

Die erfindungsgemäße Mischung eignet sich für den Einsatz in organischen Elektrolumineszenzvorrichtungen (OLEDs, PLEDs), insbesondere in einer Lumineszenzschicht solcher Vorrichtungen.

Ein weiterer Gegenstand der Erfindung ist daher die Verwendung des erfindungsgemäßen Blends in organischen elektronischen Vorrichtungen, insbesondere in organischen Elektrolumineszenzvorrichtungen, insbesondere OLEDs oder PLEDs, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), organischen lichtemittierenden elektrochemischen Zellen (OECs) oder organischen Laserdioden (O-Laser).

Nochmals ein weiterer Gegenstand der Erfindung sind organische elektronische Vorrichtungen, enthaltend den erfindungsgemäßen Blend, insbesondere organische Elektrolumineszenzvorrichtungen, enthaltend Anode, Kathode und mindestens eine emittierende Schicht, die dadurch gekennzeichnet ist, dass mindestens eine Schicht eine erfindungsgemäße Mischung enthält. Insbesondere sind derartige Vorrichtungen als organischen Elektrolumineszenzvorrichtungen, insbesondere OLEDs oder PLEDs, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser) ausgestaltet.

Außer Kathode, Anode und der mindestens einen emittierenden Schicht, die oben beschrieben wurde, kann die organische Elektrolumineszenzvorrichtung noch weitere Schichten enthalten. Diese sind beispielsweise ausgewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Ladungserzeugungsschichten (Charge-Generation Layers) und/oder organischen oder anorganischen p/n-Übergängen. Außerdem können Interlayers vorhanden sein, welche beispielsweise die Ladungsbalance im Device steuern. Insbesondere können solche Interlayers als Zwischenschicht zwischen zwei emittierenden Schichten sinnvoll sein, insbesondere als Zwischenschicht zwischen einer fluoreszierenden und einer phosphoreszierenden Schicht. Weiterhin können die Schichten, insbesondere die Ladungstransportschichten, auch dotiert sein. Die Dotierung der Schichten kann für einen verbesserten Ladungstransport vorteilhaft sein. Es sei aber darauf hingewiesen, dass nicht notwendigerweise jede der oben genannten Schichten vorhanden sein muss und die Wahl der Schichten immer von den verwendeten Verbindungen abhängt. Die Verwendung derartiger Schichten ist dem Fachmann bekannt, und er kann hierfür ohne erfinderisches Zutun alle für derartige Schichten bekannten Materialien gemäß dem Stand der Technik verwenden.

Weiterhin ist es möglich, mehr als eine emittierende Schicht zu verwenden, beispielsweise zwei oder drei emittierende Schichten, wobei diese vorzugsweise unterschiedliche Emissionsfarben aufweisen. In einer besonders bevorzugten Auführungsform der vorliegenden Erfindung handelt es sich um eine weiß emittierende organische Elektrolumineszenzvorrichtung. Diese ist dadurch gekennzeichnet, dass sie Licht mit CIE-Farbkoordinaten im Bereich von 0,28/0,29 bis 0,45/0,41 emittiert. Der allgemeine Aufbau einer derartigen weiß emittierenden Elektrolumineszenzvorrichtung ist beispielsweise in der WO 05/011013 offenbart.

Als Kathode der erfindungsgemäßen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z.B. Ca, Ba, Mg, Al, In, Mg, Yb und Sm). Bei mehrlagigen Strukturen können auch zusätzlich zu den genannten Metallen weitere Metalle verwendet werden, die eine relativ hohe Austrittsarbeit aufweisen, wie z.B. Ag, wobei dann in der Regel Kombinationen der Metalle, wie beispielsweise Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z.B. LiF, Li₂O CsF, Cs₂CO₃, BaF₂, MgO und NaF). Die Schichtdicke dieser Schicht liegt vorzugsweise zwischen 0,5 und 5 nm.

Als Anode der erfindungsgemäßen Elektrolumineszenzvorrichtung sind Materialien mit hoher Austrittsarbeit bevorzugt. Bevorzugt weist die Anode eine Austrittsarbeit größer 4,5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z.B. Al/Ni/NiOₓ, Al/PtOₓ) bevorzugt sein. Dabei muss mindestens eine der Elektroden transparent sein, um die Auskopplung von Licht zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

In einer bevorzugten Ausführungsform der Erfindung werden die erfindungsgemäßen Polymere als emittierende Verbindungen in einer emittierenden Schicht eingesetzt. Dabei kann die organische Elektrolumineszenzvorrichtung eine emittierende Schicht enthalten, oder sie kann mehrere emittierende Schichten enthalten, wobei mindestens eine emittierende Schicht mindestens ein erfindungsgemäßes Polymer, wie oben definiert, enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d.h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z.B. WO 05/011013).

Wenn die erfindungsgemäßen Polymere als emittierende Verbindungen in einer emittierenden Schicht eingesetzt werden, werden sie bevorzugt in Kombination mit einem oder mehreren Matrixmaterialien eingesetzt. Die Mischung aus den erfindungsgemäßen Polymeren und dem Matrixmaterial enthält zwischen 1 und 99 Gew.-%, vorzugsweise zwischen 2 und 90 Gew.-%, besonders bevorzugt zwischen 3 und 40 Gew.-%, insbesondere zwischen 5 und 15 Gew.-% der erfindungsgemäßen Polymere, bezogen auf die Gesamtmischung aus Emitterpolymer und Matrixmaterial. Entsprechend enthält die Mischung zwischen 99 und 1 Gew.-%, vorzugsweise zwischen 98 und 10 Gew.-%, besonders bevorzugt zwischen 97 und 60 Gew.-%, insbesondere zwischen 95 und 85 Gew.-% des Matrixmaterials, bezogen auf die Gesamtmischung aus Emitterpolymer und Matrixmaterial.

Bevorzugte Matrixmaterialien sind CBP (N,N-Biscarbazolylbiphenyl), Carbazolderivate (z.B. gemäß WO 05/039246, US 2005/0069729, JP 2004/288381), Azacarbazole (z.B. gemäß EP 1 617 710, EP 1 617 711, EP 1 731 584, JP 2005/347160), Ketone (z.B. gemäß WO 04/093207), Phosphinoxide, Sulfoxide und Sulfone (z.B. gemäß WO 05/003253), Oligophenylene, aromatische Amine (z.B. gemäß US 2005/0069729), bipolare Matrixmaterialien (z.B. gemäß WO 07/137725) oder Silane (z.B. gemäß WO 05/111172).

Weiterhin bevorzugt ist eine organische Elektrolumineszenzvorrichtung, wobei eine oder mehrere Schichten mit einem Sublimationsverfahren mit kleinen Molekülen beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition)-Verfahren oder mit Hilfe einer Trägergassublimation beschichtet werden. Dabei werden die Materialien bei einem Druck zwischen 10⁻⁵ mbar und 1 bar aufgebracht.

Weiterhin bevorzugt ist eine organische Elektrolumineszenzvorrichtung, dadurch gekennzeichnet, dass eine oder mehrere Schichten aus Lösung, wie z.B. durch Spincoating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche gegebenenfalls durch geeignete Substitution erhalten werden.

Es können generell alle weiteren Materialien, wie sie gemäß dem Stand der Technik in organischen Elektrolumineszenzvorrichtungen eingesetzt werden, in Kombination mit der erfindungsgemäßen Mischung in der emittierenden Schicht eingesetzt werden.

Ganz besonders bevorzugt ist eine organische Elektrolumineszenzvorrichtung, die dadurch gekennzeichnet ist, dass eine oder mehrere Schichten aus Lösung, wie z.B. durch Spincoating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Systeme nötig, wie sie durch die erfindungsgemäße Mischung bereitgestellt werden.

Die organische Elektrolumineszenzvorrichtung kann auch als Hybridsystem hergestellt werden, indem eine oder mehrere Schichten aus Lösung aufgebracht werden und eine oder mehrere weitere Schichten aufgedampft werden.

Weiterhin bevorzugt ist somit eine organische Elektrolumineszenzvorrichtung, die dadurch gekennzeichnet ist, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, vorzugsweise kleiner 10⁻⁶ mbar aufgedampft. Es sei jedoch angemerkt, dass der Anfangsdruck auch noch geringer sein kann, beispielsweise kleiner 10⁻⁷ mbar.

Bevorzugt ist ebenfalls eine organische Elektrolumineszenzvorrichtung, die dadurch gekennzeichnet ist, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z.B. M. S. Arnold et al., Appl. Phys. Lett. 2008, 92, 053301).

Diese Verfahren sind dem Fachmann generell bekannt und können von ihm ohne erfinderisches Zutun auf die erfindungsgemäßen organischen Elektrolumineszenzvorrichtungen angewandt werden.

Die erfindungsgemäßen organischen Elektrolumineszenzvorrichtungen weisen folgende überraschende Vorteile gegenüber dem Stand der Technik auf:
1. Die erfindungsgemäße organische Elektrolumineszenzvorrichtung weist eine sehr hohe Effizienz auf.
2. Die erfindungsgemäße organische Elektrolumineszenzvorrichtung weist gleichzeitig eine verbesserte Lebensdauer auf.

Die Erfindung wird durch die nachfolgenden Beispiele genauer beschrieben, ohne sie dadurch einschränken zu wollen. Der Fachmann kann, ohne erfinderisch tätig zu werden, weitere erfindungsgemäße organische Elektrolumineszenzvorrichtungen herstellen.

### Ausführungsbeispiele

### A) Herstellung der Monomeren

### Beispiel 1

### Phenyl-4-vinylphenylketon (M1)

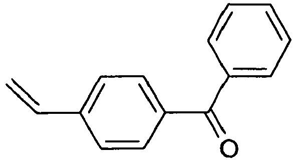

8,88 g Magnesium wird in einem ausgeheizten Kolben in 150 ml trockenem THF suspendiert und mit einer kleinen Menge Chlorstyrol und 2,6 ml Dichlorethan versetzt und erwärmt. Sobald die Reaktion angesprungen ist, wird das restliche Chlorstyrol (46,4 g) so zugetropft, dass es leicht siedet. Anschließend wird 30 Minuten unter Rückfluss erhitzen, bis das Magnesium vollständig gelöst ist. Unter Rückfluss werden dann innerhalb von 15 Minuten 34,2 g Benzonitril in 60 ml trockenem THF zugetropft und für weitere 15 Minuten zum Sieden erhitzt.

200 ml Eiswasser mit 30 ml konz. H₂SO₄ werden vorgelegt und der Ansatz unter Rühren zugeben und weitere 10 Minuten gerührt. Anschließend wird das Reaktionsgemisch mit Essigester in einen Scheidetrichter überführt und mit Heptan bis zur Phasentrennung erweitert. Die Phasen werden getrennt, die wässrige Phase einmal mit Essigester/Hexan 1/1 extrahiert, die organischen Phasen vereinigt und mit einer gesättigten NaHCO₃ Lösung und Wasser gewaschen, über MgSO₄ getrocknet, filtriert und das Lösungsmittel im Vakuum abgezogen.

Der Rückstand wird aus Hexan umkristallisiert.
(Schmelzpunkt: 49°C)

Man erhält 62,5 g eines weißen Feststoffs.

### Beispiel 2

### 1. Schritt:

### 2,4-Bis-biphenyl-3-yl-6-(3-bromphenyl)-[1,3,5]triazin

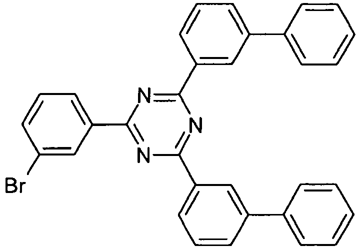

Zu einer Suspension von 60 ml 3-Brombenzoylchlorid [1711-09-7], 10 ml Thionylchlorid und 60,6 g Aluminiumchlorid in 800 ml Dichlorbenzol werden bei 100°C langsam 171 g Biphenyl-3-carbonitril [24973-50-0] zugefügt. Die Temperatur steigt leicht an und die Reaktionslösung färbt sich orange. Die Reaktion wird so lange bei 115°C gerührt, bis die Trübung verschwunden ist. Die Reaktion wird auf 100°C abgekühlt und mit Aluminiumchlorid versetzt und für 20 Stunden bei 100°C gerührt. Die Lösung wird auf Raumtemperatur abgekühlt und auf 3 1 Methanol gegossen, für eine weitere Stunde gerührt und der entstandene Niederschlag abgesaugt.

Der erhaltene Niederschlag wird in heißem Ethanol gewaschen, abgesaugt und im Vakuum getrocknet. Man erhält 92 g eines weißen Feststoffes.

### 2. Schritt:

### 2,4-Bis-biphenyl-3-yl-6-(4'-vinyl-biphenyl-3-yl)-[1,3,5]triazin (M2)

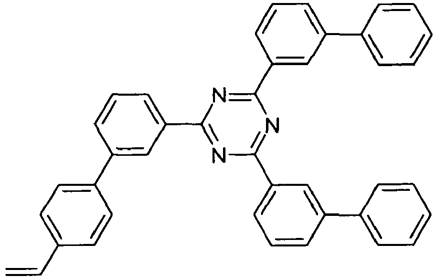

50 g 2,4-Bis-biphenyl-3-yl-6-(3-bromo-phenyl)-[1,3,5]triazin und 13,8 g Styrolboronsäure [2156-04-9] werden in 300 ml Toluol gelöst und mit 100 ml einer 2M Natriumcarbonatlösung versetzt. Die Reaktionsmischung wird sorgfältig entgast und mit 200 mg Tetrakistriphenylphosphinpalladium versetzt und für 20 Stunden zum Rückfluss erhitzt. Die Lösung wird auf Raumtemperatur abgekühlt. Die Phasen werden getrennt. Die wässrige Phase wird dreimal mit Toluol extrahiert, anschließend werden die vereinigten organischen Phasen zweimal mit Wasser gewaschen, über Magnesiumsulfat getrocknet, filtriert und das Lösungsmittel im Vakuum abgezogen.

Der Rückstand wird aus Isopropanol umkristallisiert.

Man erhält 18,8 g (36%) eines weißen Feststoffes mit einer Reinheit von 99,7%.

### Beispiel 3

### 4-Styryl-5-terphenyl (M3)

### 1,3,5-Tribrom-2-iod-benzol

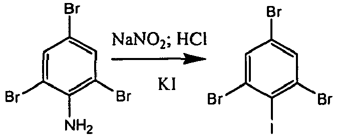

22,5 g (68,25 mmol) Tribromanilin werden in 60 mL konzentrierter Salzsäure gelöst und auf 0 °C gekühlt. Separat werden 4,92 g (71,3 mmol) Natriumnitrit in 22,5 mL Wasser gelöst. Diese Lösung wird zu der Salzsäurelösung getropft und 30 min bei RT gerührt. Parallel werden 113,3 g (682,5 mmol) Kaliumiodid in 171 mL Wasser gelöst. Reaktionslösung 1 wird in die Kaliumiodidlösung getropft und 1 h bei RT gerührt. Nach der Zugabe von 300 mL Dichlormethan und 30 mL einer 0,5 M Natriumsulfitlösung erfolgt eine Phasentrennung. Die wässrige Phase wird mit Dichlormethan gewaschen. Die organische Phase wird mit 10 % NaOH-Lösung und mit einer gesättigten Natriumchloridlösung gewaschen. Die vereinigten organischen Phasen werden über Natriumsulfat getrocknet, bis zur Trockne eingeengt und in Hexan/Dichlormethan umkristallisiert. Es werden 21,1 g (69%) saubere Substanz isoliert.

### 5'-Brom-[1,1';3',1'']terphenyl

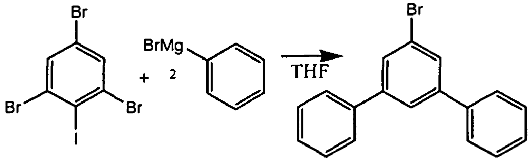

Es werden 10 g (0,023 mol) 2,4,6-Tribromphenylamin in 100 mL THF gelöst. In einer zweiten Apparatur wird 228 mL Phenylmagnesiumbromid im Rückfluss erhitzt. Das gelöste 2,4,6-Tribromphenylamin wird zu der Phenylmagnesiumbromidlösung getropft, 1 h im Rückfluss und weitere 12 h bei Raumtemperatur gerührt. Nach der Zugabe von gesättigter Natriumchloridlösung wird die wässrige Phase mit Diethylether gewaschen und über Natriumsulfat getrocknet. Nach dem Entfernen des Lösungsmittels erfolgt eine Umkristallisation in Hexan/Dichlormethan. Es werden 4,8 g (77%) saubere Substanz isoliert.

### 4-Styryl-5-terphenyl

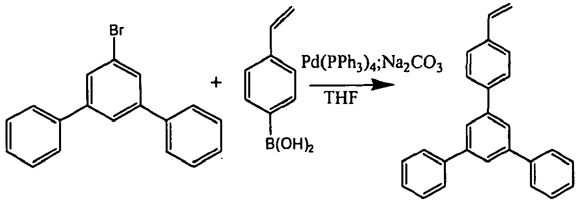

2,2 g (0,007 mol) 5-Bromterphenyl, 1,32 g (0,010 mol) Vinylphenylboronsäure und 0,023 g (0,02 mmol) Tetrakispalladium werden vorgelegt. Nach der Zugabe von 30 mL einer 1 M Natriumcarbonatlösung und 45 mL THF wird das Gemisch 22 h im Rückfluss gerührt.

Es erfolgt eine Filtration über Celite und die Aufnahme in Ethylacetat. Die organische Phase wird 3x mit Wasser gewaschen. Die vereinigten organischen Phasen werden bis zur Trockne eingeengt und es erfolgt eine Umkristallisation aus Ethanol/Chloroform. Eine weitere Reinigung erfolgt durch Säulenchromatographie (Laufmittel: Hexan/Chloroform). Dabei werden 1,3 g (77%) reine Substanz isoliert.

**Elementaranalyse:**

| | | |
|---|---|---|
| C: 90,83 % | H: 6,19 % | N: 0,04 % |

### Beispiel 4

### 5'-Vinyl-[1,1';3',1"]terphenyl (M4)

### [1,1';3',1"]Terphenyl-5'-carbaldehyd

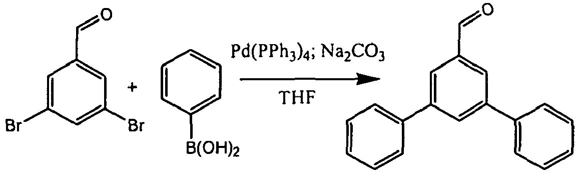

21,38 g (0,081 mol) 3,5-Dibrombenzaldehyd, 16,82 g (0,162 mol) Phenylboronsäure und 1,04 g (0,90 mmol) Tetrakispalladium werden vorgelegt. Es werden 500 mL 1 M Natriumcarbonatlösung sowie 300 mL THF zugefügt und die Reaktion wird im Rückfluss 24 h zur Reaktion gebracht.

Nach der Abkühlung auf Raumtemperatur und der Filtration über Celite wird die Mutterlauge mit Ethylacetat versetzt. Die organische Phase wird mehrfach mit Wasser gewaschen und bis zur Trockne eingeengt. Eine erste Umkristallisation findet in Ethanol statt und eine Zweite wird in Dichlormethan/Hexan durchgeführt. Nach der erfolgreichen Umkristallisation werden 9,3 g (47%) reine Substanz isoliert.

### 5'-Vinyl-[1,1';3',1"]terphenyl

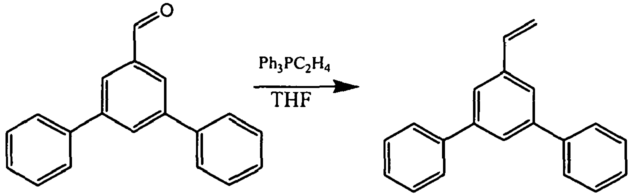

Es werden 4,82 g (0,0228 mol) Methyltriphenylphosphoniumbromid sowie 1,64 g (0,0146 mol) Kalium-tert-butanolat bei 0 °C mit 25 mL THF versetzt und 20 Minuten gerührt.

3,33 g (0,01289 mol) [1,1';3',11"]Terphenyl-5'-carbaldehyd werden in 12 mL THF gelöst und zu Methyltriphenylphosphonimbromidlösung gegeben. Das gelbliche Gemisch wird 1 h bei 0 °C gerührt. Nach dem Abkühlen auf Raumtemperatur wird das Gemisch in Dichlormethan aufgenommen. Es wird mit Wasser gewaschen und die vereinigten organischen Phasen werden über Natriumsulfat getrocknet. Das Gemisch wird bis zur Trockne eingeengt. Es wird eine Säulenchromatographie mit Hexan/Ethylacetat durchgeführt. Die Säulenchromatographie führt zu einer Ausbeute von 2,4 g (71%) sauberer Substanz.
Elementaranalyse: C: 92,68 % H: 6,69 %

### Beispiel 5

### 2,4-Diphenyl-6-(4'-vinyl-biphenyl-3-yl)-[1,3,5]triazin (M5)

### 2-(3-Brom-phenyl)-4,6-diphenyl-[1,3,5]triazin

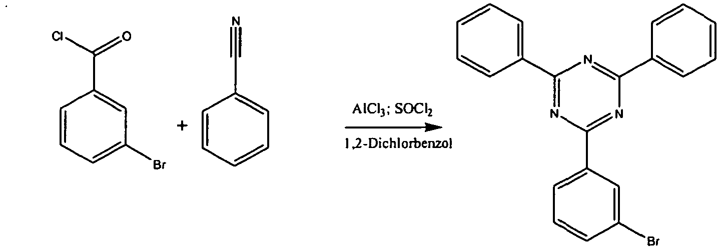

60,587 g (0,454 mol) Aluminumtrichlorid werden vorgelegt. Nach der Zugabe von 9,889 mL (0,136 mol) Thionylchlorid, 60 mL (0,454 mol) 3-Brombenzoylchlorid, 800 mL 1,2-Dichlorbenzol sowie 98,398 mL (0,954 mol) Benzonitril wird das Gemisch 20 h bei 100 °C gerührt. Nach 1 h erfolgt die Zugabe von 48,61 g (0,909 mol) Ammoniumchlorid.

Die Reaktionslösung wird auf 3 L Methanol geschüttet und 45 min gerührt. Der Feststoff wird abfiltriert und mit 1,25 L heißem Ethanol versetzt. Unter Rühren wird das Gemisch weitere 10 min im Rückfluss erhitzt, auf RT abgekühlt und das Produkt abfiltriert. Es werden 37,7 g (20%) saubere Substanz isoliert.

### 2,4-Diphenyl-6-(4'-vinyl-biphenyl-3-yl)-[1,3,5]triazin

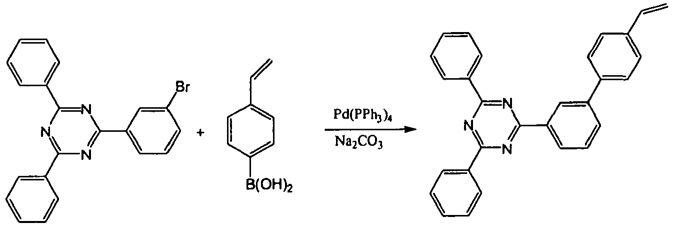

1,16 g (0,003 mol) 2-(3-Brom-phenyl)-4,6-diphenyl-[1,3,5]triazin, 0,74 g (0,005 mol) 4-Styrolboronsäure und 0,023 g (0,02 mmol) Tetrakispalladiumphosphat werden in 45 mL THF und 30 mL 1M Natriumcarbonatlösung 24 h im Rückfluss gerührt.

Nach dem Abkühlen auf Raumtemperatur wird das Gemisch über Celite gefiltert und in Ethylacetat aufgenommen. Nach dem dreimaligen Waschen mit Wasser werden die vereinigten organischen Phasen bis zur Trockne einrotiert. Es erfolgt eine Umkristallisation aus Chloroform/Ethanol, welche 0,8 g (61%) saubere Substanz liefert.

**Elementaranalyse:**

| | | |
|---|---|---|
| C: 83,77 % | H: 5,08 % | N: 10,13 % |

### Beispiel 6

### 2,4-Diphenyl-6-(4'-vinyl-biphenyl-4-yl)-[1,3,5]triazin (M6)

### 2-(4-Brom-phenyl)-4,6-diphenyl-[1,3,5]triazin

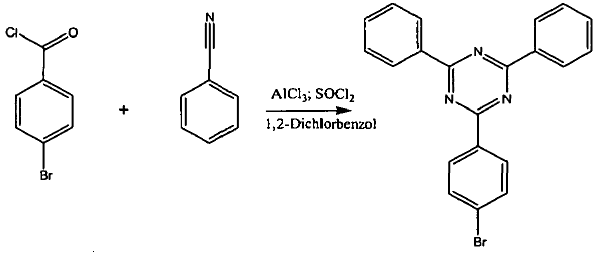

12,15 g (0,091 mol) Aluminiumtrichlorid und 20,0 g (0,091 mol) 4-Brombenzoylchlorid werden vorgelegt. Die Feststoffe werden in 200 mL 1,2-Dichlorbenzol gelöst. Nach der Zugabe von 2,20 mL (0,030 mol) Thionylchlorid sowie 19,90 mL (0,191 mol) Benzonitril wird das Gemisch 20 h bei 100 °C gerührt. Nach 1 h erfolgt die Zugabe von 9,73 g (0,182 mol) Ammoniumchlorid.

Die Reaktionslösung wird auf 500 mL Methanol geschüttet und 2 h gerührt. Der Feststoff wird abfiltriert und mit 250 mL heißem Ethanol versetzt. Unter Rühren wird das Gemisch weitere 10 min im Rückfluss erhitzt, auf RT abgekühlt und das Produkt abfiltriert. Es werden 7,6 g (21%) saubere Substanz isoliert.

### 2,4-Diphenyl-6-(4'-vinyl-biphenyl-4-yl)-[1,3,5]triazin

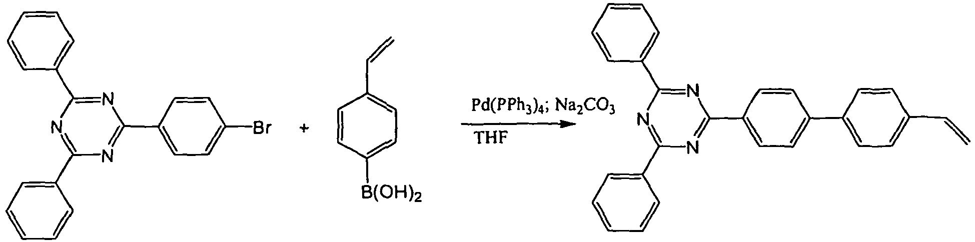

Es werden 3,48 g (0,009 mol) 3-Bromphenyl-diphenyltriazin, 2,22 g (0,015 mol) 4-Vinylphenylboronsäure und 0,069 g (0,06 mmol) Pd(PPh₃)₄ eingewogen. Nach der Zugabe von 150 mL THF (absolut) sowie 90 mL einer 1M Natriumcarbonatlösung wird das Gemisch für 24 h im Rückfluss gerührt.

Das Gemisch wird über Celite gefiltert und in Ethylacetat aufgenommen. Nach dem dreimaligen Waschen mit Wasser wird die organische Phase bis zur Trockne einrotiert. Die Umkristallisation wird in einem Gemisch aus Dichlormethan/Hexan durchgeführt.

Es erfolgt eine Säulenchromatographie mit Hexan/- Ethylacetat, welche 1,0 g (26%) saubere Substanz liefert.

**Elementaranlyse:**

| | | |
|---|---|---|
| C: 83,04 % | H: 4,97 % | N: 10,05 % |

### Beispiel 7

### 2,4-Bis-biphenyl-4-yl-6-(4-brom-phenyl)-[1,3,5]triazin (M7)

### 2,4-Bis-biphenyl-4-yl-6-(4-brom-phenyl)-[1,3,5]triazin

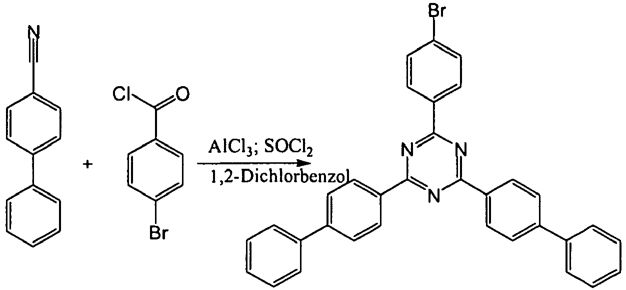

1,21 g (0,0091 mol) Aluminiumchlorid, 1,997 g (0,0091 mol) 4-Brombenzoylchlorid sowie 3,42 g (0,01911 mol) 4-Cyanobiphenyl werden vorgelegt. Die Feststoffe werden in 80 mL 1,2-Dichlorbenzol gelöst. Es erfolgt die Zugabe von 0,2 mL (0,00274 mol) Thionylchlorid. Die Reaktion wird 24 h bei 120 °C durchgeführt. Nach 1 h Reaktionszeit erfolgt die Zugabe von 0,9736 g (0,00182 mol) Ammoniumchlorid. Als Aufarbeitung wird das Gemisch auf 50 mL Methanol geschüttet. Der weiße Feststoff wird abgesaugt und in Chloroform/Ethanol umkristallisiert. Es werden 1,7 g (34%) saubere Substanz isoliert.

### 2,4-Bis-biphenyl-4-yl-6-(4'-vinyl-biphenyl-4-yl)-[1,3,5]triazin

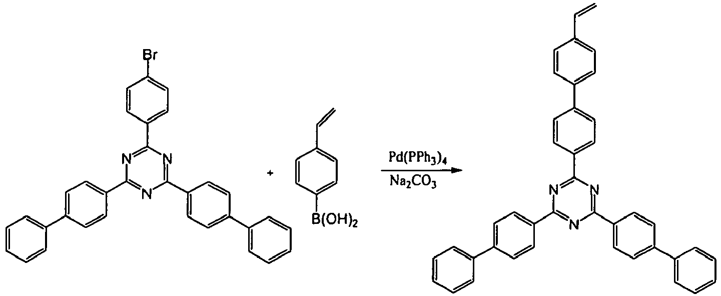

1,0 g (0,00185 mol) 2,4-Bis-biphenyl-4-yl-6-(4-bromphenyl)-[1,3,5]triazin, 0,4106 g 4-Vinylphenylboronsäure und 0,02368 g Pd(PPh₃)₄ werden unter Zugabe von 15 mL 1M Natriumcarbonatlösung und 30 mL THF im Rückfluss 48 h zur Reaktion gebracht.

Nach der Filtration wird die Mutterlauge in Ethylacetat aufgenommen. Die organische Phase wird dreimal mit Wasser extrahiert. Das Lösungsmittel wird komplett entfernt und es erfolgt eine Umkristallisation in Chloroform/Ethanol. Es werden 0,5 g (48%) saubere Substanz isoliert.

**Elementaranalyse:**

| | | |
|---|---|---|
| C: 87,25 % | H: 5,15 % | N: 7,42 % |

### Beispiel 8

### 2,4-Bis-(4-tert-butyl-phenyl)-6-(4'-vinyl-biphenyl-4-yl)-[1,3,5]triazin (M8)

### 2-(4-Brom-phenyl)-4,6-bis-(4-tert-butyl-phenyl)-[1,3,5]triazin

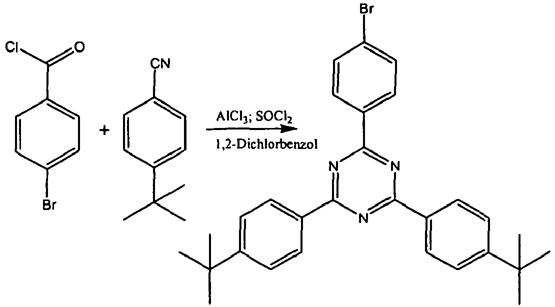

Es werden 1,6747 g (0,01256 mol) Aluminiumchlorid vorgelegt. Nach der Zugabe von 5,32 mL (0,0314 mol) 4-tert-Butylbenzonitril, 25 mL 1,2-Dichlorbenzol, 1,66 mL (0,01256 mol) 3-Brombenzoylchlorid sowie 0,274 mL (0,003768 mol) Thionylchlorid wird das Gemisch 24 h bei 130 °C zur Reaktion gebracht. Nach einer Stunde erfolgt die Zugabe von 1,344 g (0,02512 mol) Ammoniumchlorid. Zur Aufarbeitung wird das Gemisch nach dem Abkühlen auf 100 mL Methanol geschüttet. Der weiße ausgefallene Niederschlag wird abgesaugt. Dieser Niederschlag zeigt 3,1 g (21%) sauber isolierte Substanz.

### 2,4-Bis-(4-tert-butyl-phenyl)-6-(4'-vinyl-biphenyl-4-yl)-[1,3,5]triazin

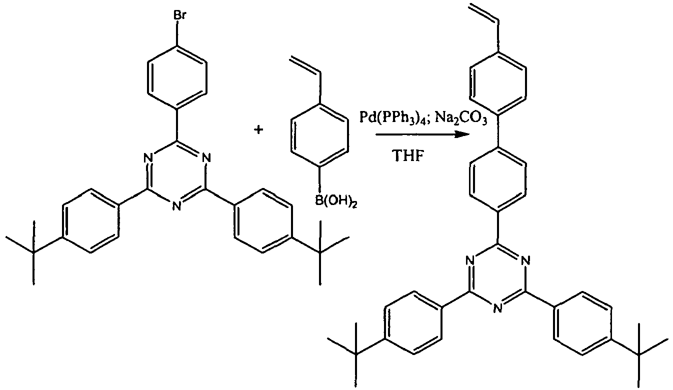

2,0 g (0,0040 mol) 2-(4-Brom-phenyl)-4,6-bis-(4-tert-butyl-phenyl)-[1',3,5]triazin sowie 0,8878 g (0,006 mol) Vinylphenylboronsäure und 0,050 g (0,0432 mmol) Pd(PPh₃)₄ werden vorgelegt. Nach der Zugabe von 26 mL Natriumcarbonatlösung und 54 mL THF wird das Gemisch 24 h im Rückfluss zur Reaktion gebracht. Zur Aufarbeitung wird das Gemisch über Celite gefiltert und in Ethylacetat aufgenommen. Die organische Phase wird mehrfach mit Wasser extrahiert. Das Lösungsmittel der vereinigten organischen Phasen wird komplett entfernt. Es erfolgt eine Umkristallisation aus Chloroform/Ethanol und eine anschließende Säulenchromatographie mit Hexan: Ethylacetat. Nach der Säulenchromatographie werden 1,6 g (76%) saubere Substanz isoliert.

**Elementaranalyse:**

| | | |
|---|---|---|
| C: 86,13 % | H: 7,34 % | N: 7,38 % |

### Beispiel 9

### [1,1';3',1"]Terphenyl-5'-yl-(4'-vinyl-biphenyl-3-yl)-methanon (M9)

### (3-Brom-phenyl)-[1,1';3',1"]terphenyl-5'-yl-methanon

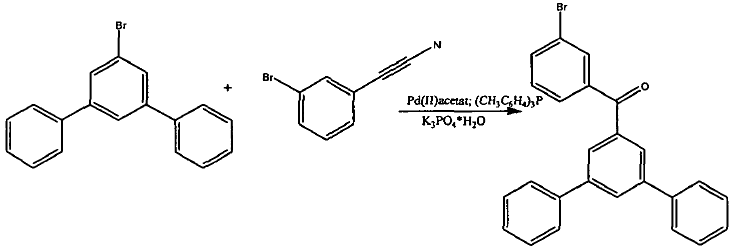

0,78 g (3,2*10⁻² mol) Magnesium wird vorgelegt. 9,00 g (2,91*10⁻² mol) 5'-Brom-[1,1';3',1"]terphenyl werden in 120 mL trockenem THF gelöst und über einen Tropftrichter zugegeben. Die Mischung wird für 2 h im Reflux gerührt. Nach dem Abkühlen auf -78 °C werden 5,30 g (2,91*10⁻² mol) 3-Brombenzonitril, in 100 mL trockenem THF gelöst, zugetropft. Die Mischung wird 4h im Reflux gerührt. Die Reaktionslösung wird im Eiswasser auf gesättigte NH₄CL-Lösung gegeben. Nach dem Verdünnen mit Ethylacetat und dem Waschen mit H₂O wird das Gemisch über Na₂SO₄ getrocknet, filtriert und einrotiert.

Das Öl wird in 60 mL NMP gelöst und mit 7,7 mL H₂O und 0,67 mL Eisessig versetzt. Das Reaktionsgemisch wird 4 h bei 145 °C und anschließend über Nacht bei Raumtemperatur gerührt. Die Lösung wird in Ethylacetat aufgenommen, dreimal mit H₂O gewaschen, über Na₂SO₄ getrocknet, filtriert und bis zur Trockne eingeengt. Eine Säulenchromatographie mit Toluol/Hexan als Eluent führt zu 5,69 g (55,1%) sauberem Produkt.

**Elementaranalyse:**

| | |
|---|---|
| C: 72,55 % | H: 4,10 % |

### [1,1';3',1"]Terphenyl-5'-yl-(4'-vinyl-biphenyl-3-yl)-methanon

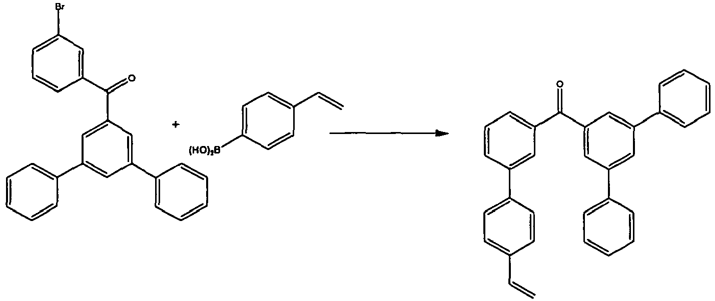

8,00 g (1,94*10⁻² mol) 3-Brom-phenyl-[1,1;3',1"]terphenyl-5'-yl-methanon; 5,73 g (3,87*10⁻² mol) 4-Vinylphenylboronsäure sowie 0,25 g (2,16*10⁻⁴ mol) Tetrakistripheylphosphin Palladium (II) werden vorgelegt. Nach der Zugabe von 300 mL trockenem THF und 200 mL 2M Natriumcarbonatlösung wird die Mischung bei 60 °C über Nacht gerührt. Die Reaktionslösung wird abgekühlt, die organische Phase mit gesättigter NaHCO₃ und H₂O gewaschen, über Na₂SO₄ getrocknet, filtriert und einrotiert. Eine Säulenchromatographie mit Toluol liefern 7,04 g (83%) sauberes Produkt.
Elementaranalyse: C: 98,82 % H: 5,48 %

### Beispiel 10

### 9-(4'-Carbazol-9-yl-biphenyl-4-yl)-2-(4-vinyl-phenyl)-9H-carbazol (M10)

### 4-(9H-Carbazol-2-yl)-benzaldehyd

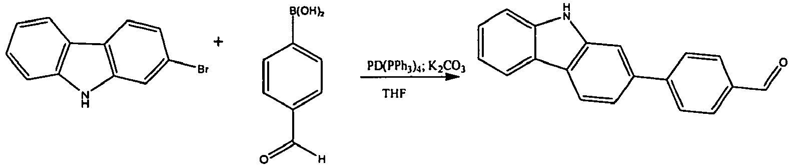

10,0 g 2-Brom-9H-carbazol (4,06 10⁻² mol ), 9,22 g 4-Formylphenylboronsäure (6,15 10⁻² mol), 0,63 g Tetrakistriphenylpalladium (5,5 10⁻⁴ mol), 42,0 g Kaliumcarbonat (3 10⁻¹ mol) werden vorgelegt. Nach dem Durchspülen von 300 mL Wasser mit Argon wird 400 mL THF hinzugefügt. Die Reaktionsmischung wird 2 Tage im Reflux gerührt. Nach der Filtration über Celite wird die organische Phase getrennt, über Na₂CO₄ getrocknet und die wässrige Phase 2x mit CH₂Cl₂ gewaschen und über Na₂SO₄ getrocknet. Eine Säulenchromatographie mit Toluol als Eluent liefern 2,0 g (53%) sauberes Produkt.

### 9-(4'-Brom-biphenyl-4-yl)-9H-carbazol

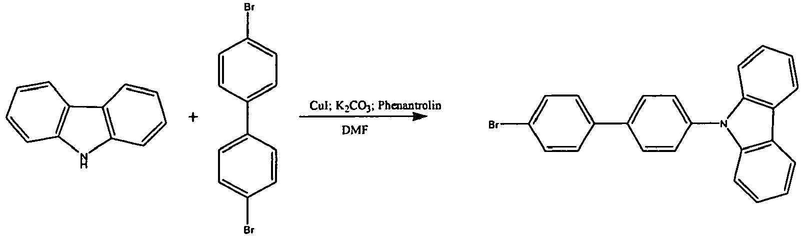

5,0 g 9H-Carbazol (3,0 10⁻² mol), 0,67 g CuI (3,2 10⁻³ mol), 10,0 g K₂CO₃ (7,2 10⁻² mol), 1,16 g 1,10 Phenanthrolin (6,4 10⁻³ mol), sowie 9,36 g 4,4'-Dibrombiphenyl (3,0 10⁻² mol) werden vorgelegt. Nach der Zugabe von 200 mL DMF wird das Reaktionsgemisch für 12 h im Reflux gerührt. Nach dem Absaugen über Celite wird es mit Wasser gefällt und abgesaugt. Der Feststoff wird in der Hitze in THF gelöst und mit Ethanol gefällt. So werden 7,7 g (64%) saubere Substanz gewonnen.

### 4-[9-(4'-Carbazol-9-yl-biphenyl-4-yl)-9H-carbazol-2-yl]-benzaldehyd

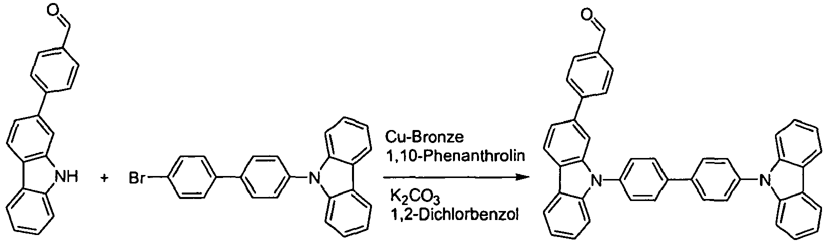

Es werden 2,27 g (0,008367 mol) 1-(9H-Carbazol-2-yl)-benzaldehyd, 4,0 g (0,010 mol) 9-(4'-Brom-biphenyl-4-yl)-9H-carbazol, 3,79 g Cu-Bronze, 0,53 g (0,00294 mol) 1,10-Phenanthrolin und 11,39 g (0,082 mol) Kaliumcarbonat vorgelegt. Die Feststoffe werden in 53 ml 1,2-Dichlorbenzol gelöst und 2 Tage im Reflux gerührt. Nach der Filtration über Celite wird das Gemisch bis zur Trockne eingeengt. Eine Säulenchromatographie mit Toluol/Hexan als Eluent liefern 2,4 g (49%) sauberes Produkt.

### 9-(4'-Carbazol-9-yl-biphenyl-4-yl)-2-(4-vinyl-phenyl)-9H-carbazol

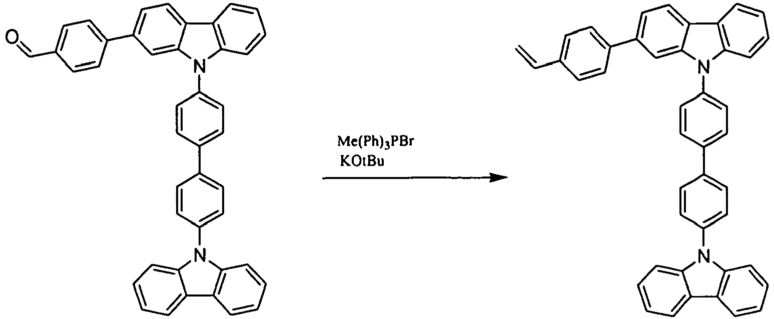

Es werden 0,86 g (0,00767 mol) Kalium-tert-butoxylat und 2,55 g (0,00714 mol) Methyl-triphenyl-phosphoniumbromid vorgelegt. Die Apparatur wird auf 0 °C gekühlt und die Feststoffe werden mit 15 ml THF(abs.) gelöst. Das Gemisch wird 30 min gerührt, während in einer zweiten Apparatur 2,31 g (0,0039 mol) 4-[9-(4'-Carbazol-9-yl-biphenyl-4-yl)-9H-carbazol-2-yl]-benzaldehyd eingewogen und mit 25 mL THF gelöst wird. Brei 0 °C wird Lösung 2 zu Lösung 1 gegeben und weitere 1,5 h gerührt. Das Gemisch wird in CH₂Cl₂ aufgenommen und dreimal mit Wasser ausgeschüttelt. Die vereinigten organischen Phasen werden über Magnesiumsulfat getrocknet, abfiltriert und bis zur Trockne eingeengt. Eine Säulenchromatographie mit Toluol liefern 2,1 g (93%) saubere Substanz.

**Elementaranalyse:**

| | | |
|---|---|---|
| C: 89,42 % | H: 5,31 % | N: 4,57 % |

### Beispiel 11 (Herstellung eines Comonomers):

### Diphenyl-(4-vinyl-phenyl)-amin

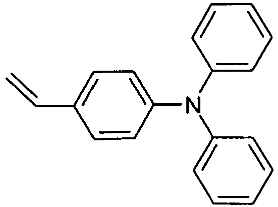

19 g Methylphosphoniumbromid wird in getrocknetem THF unter Schutzgas suspendiert und portionsweise bei 0°C mit 6 g Kalium-tert-butylat versetzt. Es findet ein sofortiger Farbumschlag nach Orange statt. Die Reaktionslösung wird bei 0°C mit 14 g N,N-Diphenyl-p-aminobenzaldehyd versetzt. Die Mischung wird auf Raumtemperatur erwärmt und für weitere 20 Stunden gerührt. Das Lösungsmittel wird im Vakuum abgezogen, der Rückstand in Dichlormethan aufgenommen und die Lösung mit Wasser extrahiert über Magnesiumsulfat getrocknet, filtriert und das Lösungsmittel im Vakuum abgezogen.

Das erhaltene gelbe Öl wird über Kieselgel chromatographiert.

Man erhält 12 g (86%) eines weißen Feststoffes mit einer Reinheit von 99,5%.

### Beispiel 12

### 2,4-Bis-biphenyl-3-yl-6-{3-[2-(3-ethyl-oxetan-3-ylmethoxy)-ethyl]-phenyl}-[1,3,5]triazin

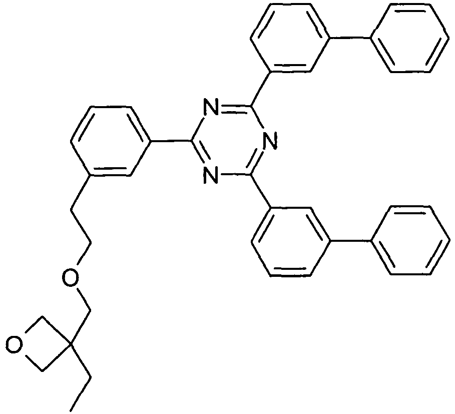

13,1 g 3-Ethyl-3-vinyloxymethyl-oxetan und 11,3 g 9-BBN-Dimer (9-Borabicyclo(3.3.1)nonan-Dimer) werden unter Schutzgas in 200 ml Toluol bei Raumtemperatur gelöst und für 20°C gerührt. Während der Reaktion löst sich die Suspension von 9BBN langsam auf. Anschließend werden der Reaktionslösung 50 g 2,4-Bis-biphenyl-3-yl-6-(3-bromphenyl)-[1,3,5]triazin und 50 ml einer 1M NaOH Lösung zugesetzt. Die Reaktionsmischung wird sorgfältig entgast und mit 200 mg Tetrakistriphenylphosphinpalladium versetzt und für 20 Stunden zum Rückfluss erhitzt. Die Lösung wird auf Raumtemperatur abgekühlt. Die Phasen werden getrennt. Die wässrige Phase wird dreimal mit Toluol extrahiert, anschließend werden die vereinigten organischen Phasen zweimal mit Wasser gewaschen, über Magnesiumsulfat getrocknet, filtriert und das Lösungsmittel im Vakuum abgezogen.

Der Rückstand wird aus Ethanol/Toluol 3:1 umkristallisiert.

Man erhält 54 g (97%) eines weißen Feststoffes mit einer von Reinheit 99,8%.

Die Strukturen des Emitters T1 sowie der verwendeten kleinen Moleküle sind der Übersichtlichkeit halber im Folgenden abgebildet.

### Struktur des Emitters T1:

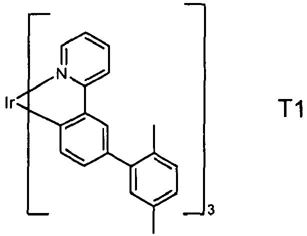

### Strukturen der Host-Moleküle auf Basis kleiner Moleküle:

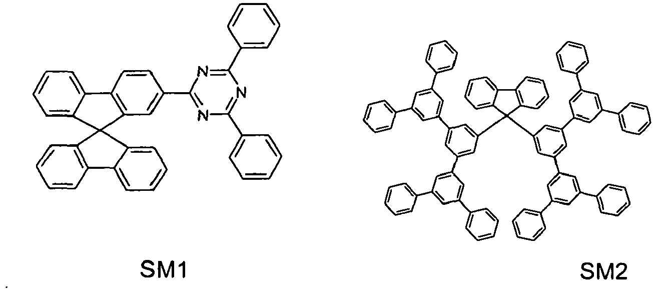

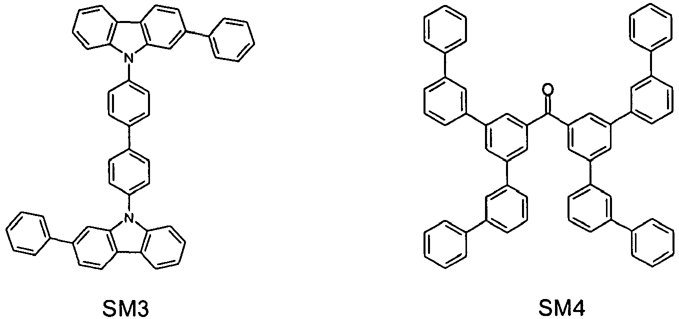

| **Polymer** | **Elementaranalyse** | **Device-Aufbau** |
|---|---|---|
| 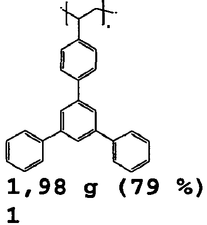 | C: 91,99 % | SM1+Polymer1+T1 |
| | H: 6,01 % | |
| | N: 0,12% | Polymer3+Polymer1+ T1 |
| | | |
| | Mw = 57862 | |
| | Mn = 16710 | |
| | Tg = 166°C | |
| 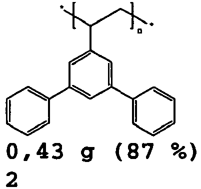 | C: 94,72 % | SM1+Polymer2+T1 |
| | H: 6,27 % | |
| | N: 0,12 % | |
| | | |
| | Mw = 58423 | |
| | Mn = 15661 | |
| | Tg = 153°C | |
| 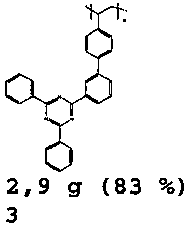 | C: 84,32 % | Polymer3+SM2+T1 |
| | H: 5,13 % | |
| | N: 10,22 % | Polymer3+Polymer1+T1 |
| | | |
| | Mw = 66288 | |
| | Mn = 22908 | |
| | Tg = 202°C | |
| 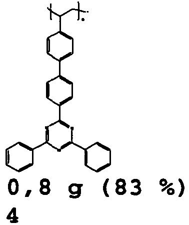 | C: 84,16 % | Polymer4+SM2+T1 |
| | H: 5,27 % | |
| | N: 10,03 % | |
| | | |
| | Mw = 382949 | |
| | Mn = 33213 | |
| | Tg = 244°C | |
| 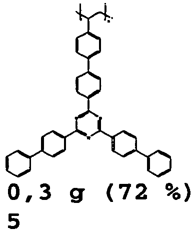 | C: 86,32 % | Kein Deviceaufbau möglich |
| | H: 5,13 % | |
| | N: 7,28 % | |
| | | |
| | Mw: nicht messbar | |
| | Mn: nicht messbar | |
| | Tg = 294°C | |
| 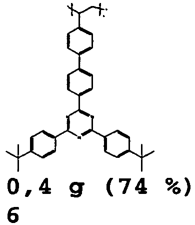 | C: 84,50 % | Polymer6+SM2+T1 |
| | H: 7,13 % | |
| | N: 7,95 % | |
| | | |
| | Mw = 100834 | |
| | Mn = 34603 | |
| | Tg = 277°C | |
| 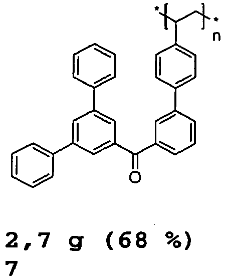 | C: 90,44 % | Polymer7+SM2+T1 |
| | H: 5,61 % | Polymer7+SM3+T1 |
| | N: 0,07 % | |
| | | |
| | Mw = 100870 | |
| | Mn = 48930 | |
| | Tg = 154°C | |
| 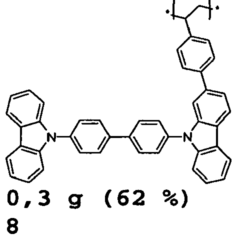 | C: 89,13 % | SM1+Polymer8+T1 |
| | H: 5,08 % | SM4+Polymer8+T1 |
| | N: 4,78 % | |
| | | |
| | Mw = 208289 | |
| | Mn = 82964 | |
| | Tg = 267°C | |

### Device-Ergebnisse:

Die PhPLED-Devices wurden jeweils mit den korrespondierenden Bestandteilen (Polymer/kleines Molekül bzw. kleines Molekül/Polymer) mit dem Einmischen des Triplettemitters hergestellt (Beispiele 1-5). Zum Vergleich wurden dann die Polymer/Polymer-Mischungen mit dem Triplettemitter hergestellt (Beispiel 6). Im Folgenden wird der Aufbau der Device-Strukturen beschrieben.

Für den Aufbau wurden ITO-Glassubstrate mit einem Flächenwiderstand von 10 bis 15 Ohm/Quadrat benutzt, die insgesamt vier gleiche Pixelstrukturen von 4 mm² aufweisen. Exemplarisch wird folgender Aufbau vorgenommen: Die ITO-Substrate werden nasschemisch gereinigt und einem Sauerstoffplasma ausgesetzt. Unmittelbar danach werden die Substrate in eine Glove-Box eingeschleust. Dort erfolgt das Auftragen der PEDOT:PSS-Schicht (Clevios®) (CH8000 oder Al4083) und eine Temperung bei 180 °C für 60 min, die eine Trockenschichtdicke von ca. 60 bis 80 nm zur Folge hatte. Danach wird eine weitere Lochinjektionsschicht (HIL1: Arylamin-Polymer) aufgetragen. Dieses Material wird aus einer 0,5 %-igen Lösung aus Toluol aufgetragen. Nach einer Temperung von 180 °C und 60 min erhält man eine finale Schichtdicke von ca. 20 nm. Die Polymer/kleine Molekül und die Polymer/Polymer-Mischungen können unter Zugabe des Triplettemitters in Abhängigkeit von der Löslichkeit der einzelnen Komponenten mit einer 2,5 %-igen Lösungskonzentration sowohl in Chlorbenzol als auch Toluol gelöst werden. Der Spin-Coating-Prozess der fertigen Lösungen resultiert in Schichtdicken zwischen 50 und 110 nm. Das Lösungsmittel wird bei bis zu 180 °C in 15 min verdampft. Anschließend erfolgt das Aufdampfen der Kathodenstruktur unter Hochvakuumbedingungen mit Barium (3 nm) und Aluminium (150 nm). Danach erfolgt eine Randverkapselung mit einem im Deckglas fixierten CaO-Absorber. Die LIV-Messungen erfolgen mit einer Source-Measure-Unit von Keithley 237 und einer Minolta-Kamera CS-2000. Die Lebensdauer wird durch einen beschleunigten Lebensdauertest bei Starthelligkeiten von 9000, 6000, 5000, 4000 cd/m² bestimmt.

### Beispiele: kleines Molekül/Polymer

### Beispiel 1

Das kleine Molekül SM1 wird mit dem Polymer 1 im Verhältnis 2:1 und 16,6 % Triplettemitter T1 gemischt. Die Lochinjektionsschicht ist CH8000.

| **Device-Eigenschaften** | **SM1 + Polymer1 + T1 2:1 (CH8000)** |
|---|---|
| Spannung/V @ 100 cd/m² | 4,0 |
| Spannung/V @ 1000 cd/m² | 5,75 |
| Spannung/V @ 5000 cd/m² | 7,3 |
| Spannung/V @ 10 mA/cm² | 7,1 |
| Leuchtstärke/cd/A⁺ | 43 @ 6 V |
| Lebensdauer | 20306 h |

### Beispiel 2

Das kleine Molekül SM1 wird mit dem Polymer 2 im Verhältnis 2:1 und 16,6 % Triplettemitter gemischt. Die Lochinjektionsschicht wurde mit CH8000 hergestellt.

| **Device-Eigenschaften** | **SM1 + Polymer2 (2:1)+ T1 (CH8000)** |
|---|---|
| Spannung/V @ 100 cd/m² | 3,9 |
| Spannung/V @ 1000 cd/m² | 5,3 |
| Spannung/V @ 5000 cd/m² | 7,0 |
| Spannung/V @ 10 mA/cm² | 6,0 |
| Leuchtstärke/cd/A⁺ | 22 @ 6,5 V |
| Lebensdauer | 749 h |

### Beispiel 3

Das Polymer 3 wird mit dem kleinen Molekül SM2 im Verhältnis 1:2 und 16,6 % Triplettemitter gemischt. Die Lochinjektionsschicht wurde mit CH8000 hergestellt.

| **Device-Eigenschaften** | **Polymer3 + SM2 (1:2)** + **T1 (CH8000)** |
|---|---|
| Spannung/V @ 100 cd/m² | 3,6 |
| Spannung/V @ 1000 cd/m² | 4,85 |
| Spannung/V @ 5000 cd/m² | 6,1 |
| Spannung/V @ 10 mA/cm² | 5,6 |
| Leuchtstärke/cd/A⁺ | 28,6 @ 5 V |
| Lebensdauer | 27508 h |

### Beispiel 4

Das Polymer 4 wird mit dem kleinen Molekül SM2 im Verhältnis 1:2 und 16,6 % Triplettemitter gemischt. Die Lochinjektionsschicht wurde mit CH8000 hergestellt.

| **Device-Eigenschaften** | **Polymer4 + SM2 (1:2) + T1 (CH8000)** |
|---|---|
| Spannung/V @ 100 cd/m² | 4,2 |
| Spannung/V @ 1000 cd/m² | 6,0 |
| Spannung/V @ 5000 cd/m² | 7,7 |
| Spannung/V @ 10 mA/cm² | 7,1 |
| Leuchtstärke/cd/A⁺ | 35 @ 5,3 V |
| Lebensdauer | 940 h |

### Beispiel 5

Das Polymer 6 wird mit dem kleinen Molekül SM2 im Verhältnis 1:2 und 16,6 % Triplettemitter gemischt. Die Lochinjektionsschicht wurde mit CH8000 hergestellt.

| **Device-Eigenschaften** | **Polymer6 + SM2 (1:2) + T1 (CH8000)** |
|---|---|
| Spannung/V @ 100 cd/m² | 7,3 |
| Spannung/V @ 1000 cd/m² | 10 |
| Spannung/V @ 5000 cd/m² | >10 |
| Spannung/V @ 10 mA/cm² | >10 |
| Leuchtstärke/cd/A⁺ | 17,4 @ 10 V |
| Lebensdauer | 957 h |

### Referenzbeispiel Polymer/Polymer

### Beispiel 6

Dieses Beispiel zeigt die Mischung zweier Polymere im Verhältnis 1:2 mit 16,7 % Triplettemitter. Auch hier wurde zum Vergleich wieder CH8000 eingesetzt.

| **Device-Eigenschaften** | **Polymer3 + Polymer1 + T1 (1:2) (CH8000)** |
|---|---|
| Spannung/V @ 100 cd/m² | 7,8 |
| Spannung/V @ 1000 cd/m² | >10 |
| Spannung/V @ 5000 cd/m² | >10 |
| Spannung/V @ 10 mA/cm² | >10 |
| Leuchtstärke/cd/A⁺ | 6 @ 10 V |
| Lebensdauer | 152 h |

Durch den Vergleich der Beispiele 1 bis 5 mit dem Beispiel 6 wird der Vorteil der Mischungen kleines Molekül/korrespondierendes Polymer gegenüber den Polymer/Polymer-Mischungen deutlich. Nicht nur in der Performance (z.B. Leuchtstärke bei den entsprechenden Spannungen), sondern vor allem in der Lebensdauer sind die Mischungen aus kleinem Molekül/Polymer bevorzugt unabhängig von den eingesetzten Polymerstrukturen. Besonders bevorzugt sind die Polymere 1 und 3 mit den korrespondierenden kleinen Molekülen.

## Patentansprüche

1. Blend, enthaltend:
a) mindestens ein Polymer oder Copolymer oder eine Mischung mehrerer Polymere und/oder Copolymere, wobei das mindestens eine Polymer oder Copolymer in den Seitenketten mindestens eine Struktureinheit der folgenden Formel (I) enthält 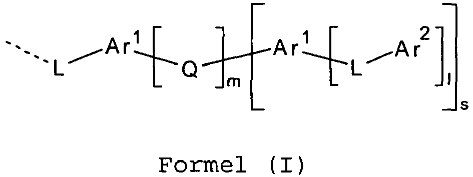 wobei die gestrichelte Linie die Verbindung zum Grundgerüst des Polymers oder Copolymers darstellt, und die übrigen verwendeten Symbole und Indices die folgenden Bedeutungen aufweisen:
L ist bei jedem Auftreten gleich oder ver-schieden eine kovalente Einfachbindung oder eine geradkettige Alkylengruppe mit 1 bis 20 C-Atomen oder eine verzweigte oder cyc-lische Alkylengruppe mit 3 bis 20 C-Atomen, die jeweils mit einem oder mehreren Resten R¹ substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wo-bei ein oder mehrere H-Atome durch F, Cl, Br, I, CN oder NO₂ ersetzt sein können, vorzugsweise eine kovalente Einfachbindung;
Ar¹ ist bei jedem Auftreten gleich oder verschieden, ein bivalentes, mono- oder polycyclisches, aromatisches oder hetero-aromatisches Ringsystem mit 5 bis 60 aroma-tischen Ringatomen, welches mit einem oder mehreren Resten R¹ substituiert sein kann;
Ar² ist bei jedem Auftreten gleich oder verschieden, ein mono- oder polycyclisches, aromatisches oder heteroaromatisches Ring-system mit 5 bis 60 aromatischen Ringato-men, welches mit einem oder mehreren Resten R¹ substituiert sein kann;
Q ist eine Einheit, ausgewählt aus der Gruppe bestehend aus einer Gruppe -X(=A)-, mit A = O, S, Se oder Te, sowie mono- oder polycyclischen aromatischen Ringsystemen mit 6 bis 60 aromatischen Kohlenstoffatomen oder mono- oder polycyclischen heteroaroma-tischen Ringsystemen mit 2 bis 50 aromati-schen Kohlenstoffatomen;
m ist 0, 1, 2 oder 3, vorzugsweise 0 oder 1;
1 ist 0, 1, 2 oder 3;
s ist 1 im Falle von Q = -X(=A)-; ist 1 bis 5, bevorzugt 1 bis 3 für den Fall, dass Q ausgewählt ist aus der Gruppe bestehend aus mono- oder polycyclischen aromatischen Ringsystemen mit 6 bis 60 aromatischen Koh-lenstoffatomen oder mono- oder poly-cyclischen heteroaromatischen Ringsystemen mit 2 bis 50 aromatischen Kohlenstoff-atomen; und ist 1 oder 2 im Falle m = 0;
R¹ ist bei jedem Auftreten gleich oder verschieden D, F, Cl, Br, I, N(Ar³)₂, CN, NO₂, Si(R²)₃, B(OR²)₂, C(=O)Ar³, P(=O)(Ar³)₂, S(=O)Ar³, S(=O)₂Ar³, -CR²=CR²(Ar³), ein monooder polycyclisches, aromatisches oder heteroaromatisches Ringsystem mit 5 bis 60 aromatischen Ringatomen, Tosylat, Triflat, OSO₂R², eine geradkettige Alkyl-, Alkoxy-oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, oder eine Kombination dieser Systeme; wobei auch zwei oder mehrere benachbarte Substituenten R¹ miteinander über eine kovalente Einfachbindung oder eine bivalente Gruppe Z verknüpft sein können;
X ist aus der Gruppe ausgewählt, die aus C, P(Ar⁴), S und SO besteht, vorzugsweise C oder P(Ph);
R² ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei eine oder mehrere nicht benachbarte CH₂-Gruppen durch NH, 0 oder S ersetzt sein können und wobei ein oder mehrere H-Atome durch F ersetzt sein können, oder ein mono- oder polycylisches, aromatisches oder heteroaromatisches Ringsystem mit 5 bis 20 aromatischen Ringatomen, das jeweils durch einen oder mehrere Reste R³ substituiert sein kann; wobei auch zwei oder mehrere Substituenten R² miteinander über eine kovalente Einfachbindung oder eine bivalente Gruppe Z verknüpft sein können;
R³ ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei eine oder mehrere nicht benachbarte CH₂-Gruppen durch NH, O oder S ersetzt sein können und wobei ein oder mehrere H-Atome durch F ersetzt sein können; wobei auch zwei oder mehrere Substituenten R³ miteinander über eine kovalente Einfachbindung oder eine bivalente Gruppe Z verknüpft sein können;
Ar³ und Ar⁴ sind bei jedem Auftreten gleich oder verschieden ein mono- oder polycyclisches, aromatisches oder heteroaromatisches Ringsystem mit 5 bis 60 aromatischen Ringatomen, welches mit einem oder mehreren Resten R³ substituiert sein kann;
Z stellt eine bivalente Gruppe -(CR⁴₂)_{q}- dar;
q ist gleich 1, 2, 3, 4 oder 5;
R⁴ ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, wobei eine oder mehrere nicht benachbarte CH₂-Gruppen durch NH, O oder S ersetzt sein können und wobei ein oder mehrere H-Atome durch F ersetzt sein können.
b) mindestens ein Host-Molekül, das elektronen- oder lochtransportierende Funktionalität aufweist, sowie
c) mindestens ein Emittermolekül.

2. Blend nach Anspruch 1, **dadurch gekennzeichnet, dass**
Q ausgewählt ist aus der Gruppe bestehend aus - X(=O)-; 1,3,5-Triazylen und/oder Resten, die abgeleitet sind von Benzol, Naphthalin, An-thracen, Benzanthracen, Phenanthren, Benzo-phenanthren, Pyren, Chrysen, Perylen, Fluor-anthen, Benzfluoranthen, Naphthacen, Penta-cen, Benzpyren, Biphenyl, Biphenylen, Ter-phenyl, Terphenylen, Fluoren, Spirobifluoren, Dihydrophenanthren, Dihydropyren, Tetrahydro-pyren, cis- oder trans-Indenofluoren, cis-oder trans-Monobenzoindenofluoren, cis- oder trans-Dibenzoindenofluoren, Truxen, Iso-truxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazin-imidazol, Chinoxalinimidazol, Oxazol, Benz-oxazol, Naphthoxazol, Anthroxazol, Phenan-throxazol, Isoxazol, 1,2-Thiazol, 1,3-Thia-zol, Benzothiazol, Pyridazin, Benzopyridazin, Pyrimidin, Benzpyrimidin, Chinoxalin, 1,5-Di-azaanthracen, 2,7-Diazapyren, 2,3-Diazapyren, 1,6-Diazapyren, 1,8-Diazapyren, 4,5-Diaza-pyren, 4,5,9,10-Tetraazaperylen, Pyrazin, Phenazin, Phenoxazin, Phenothiazin, Fluoru-bin, Naphthyridin, Azacarbazol, Benzocarbo-lin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxa-diazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetra-zol, 1,2,4,5-Tetrazin, 1,2,3,4-Tetrazin, 1,2,3,5-Tetrazin, Purin, Pteridin, Indolizin und Benzothiadiazol, wobei das 1,3,5-Triazy-len oder die Reste jeweils an beliebiger Po-sition mit einem oder mehreren Resten R¹, R² und/oder R³ substituiert sein können und/oder über beliebige Positionen am Aromaten bzw. Heteroaromaten verknüpft sein können; und
s ist 1 im Falle von Q = -X(=O)-; ist 1 oder 2 im Falle Q = 1,3,5-Triazylen; oder ist 1, 2, 3, 4 oder 5 für den Fall, dass Q ausgewählt ist aus den oben angegebenen Resten.

3. Blend nach einem der vorhergehenden Ansprüche, **dadurch gekennzeichnet, dass dadurch gekennzeichnet, dass** bei jedem Auftreten unabhängig voneinander Ar¹ oder Ar² oder Ar¹ und Ar² ausgewählt sind aus der Gruppe bestehend aus Resten, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol, die jeweils an beliebiger Position mit einem oder mehreren Resten R¹, R² und/oder R³ substituiert sein können und/oder über beliebige Positionen am Aromaten bzw. Heteroaromaten verknüpft sein können.

4. Blend nach einem der vorhergehenden Ansprüche, **dadurch gekennzeichnet, dass** die Struktureinheit der Formel (I) ausgewählt ist aus der Gruppe bestehend aus
a) elektronentransportierende Substituenten aufweisenden Struktureinheiten gemäß den folgenden allgemeinen Formeln (II) und/oder (III) 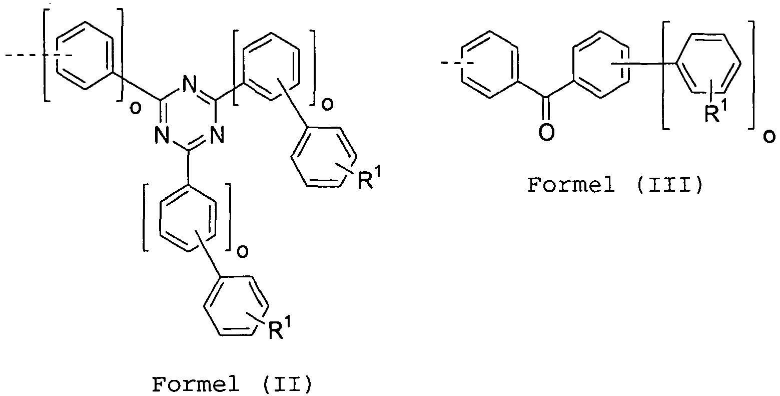
b) und/oder lochtransportierende Substituenten aufweisende Struktureinheiten gemäß den allgemeinen Formeln (IV) und/oder (V) 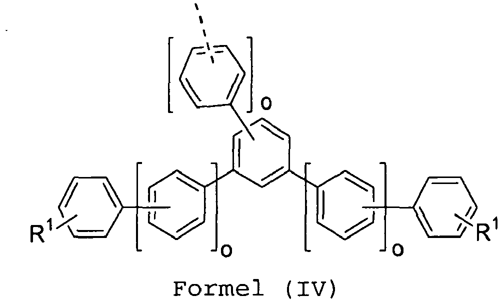 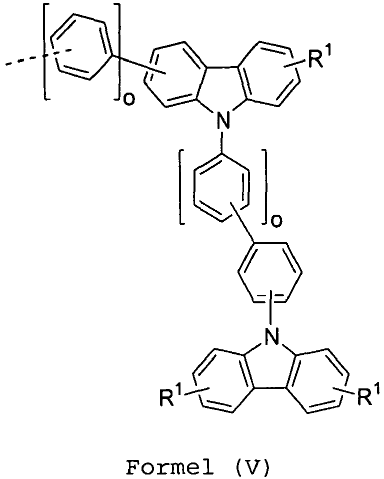
wobei die gestrichelte Linie die Verbindung zum Grundgerüst des Polymers oder Copolymers darstellt, R¹ die zuvor genannte Bedeutung aufweist und jeweils unabhängig voneinander o = 0 oder 1 bis 10 ist.

5. Blend nach einem der vorhergehenden Ansprüche, **dadurch gekennzeichnet, dass**
a) die elektronentransportierende Substituenten aufweisende Struktureinheit ausgewählt ist aus der Gruppe bestehend aus den nachfolgenden Struktureinheiten: 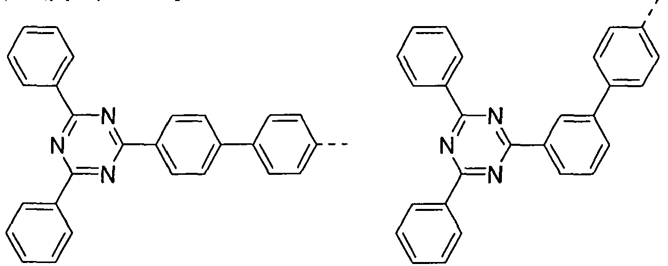 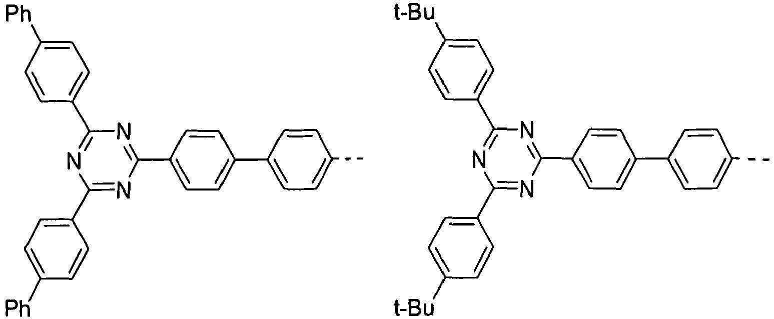 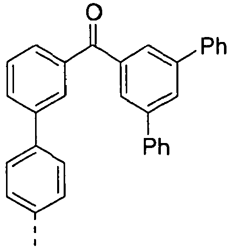
b) und/oder die lochtransportierende Substituenten aufweisende Struktureinheit ausgewählt ist aus der Gruppe bestehend aus den nachfolgenden Struktureinheiten: 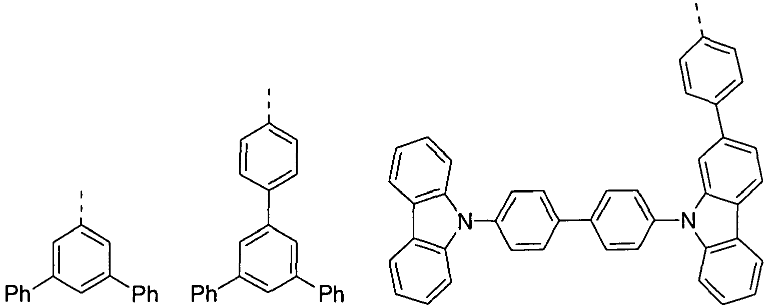
wobei die gestrichelte Linie jeweils die Verbindung zum Grundgerüst des Polymers oder Copolymers darstellt.

6. Blend nach einem der vorhergehenden Ansprüche, **dadurch gekennzeichnet, dass** es neben der Seitenkette mit der Struktureinheit der Formel (I) noch mindestens eine weitere Seitenkette umfasst, die eine weitere Struktureinheit enthält.

7. Blend nach vorhergehendem Anspruch, worin die weitere Struktureinheit eine Einheit der folgenden Formel (VI) ist 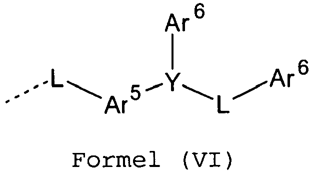 wobei die gestrichelte Linie die Verbindung zum Grundgerüst des Polymers darstellt, und das Symbol L die gleichen Bedeutungen wie in den vorhergehenden Ansprüchen hat, und die übrigen verwendeten Symbole die folgenden Bedeutungen aufweisen:
Y ist eine trivalente Einheit, die aus der Gruppe ausgewählt ist, die aus N, B, Si(Ar⁴), SiR⁵, Ge(Ar⁴), GeR⁵, P und As besteht;
Ar⁵ ist ein bivalentes, mono- oder polycyclisches, aromatisches oder heteroaro-matisches Ringsystem mit 5 bis 60 aromati-schen Ringatomen, welches mit einem oder meh-reren Resten R¹ substituiert sein kann;
Ar⁶ ist ein mono- oder polycyclisches, aromati-sches oder heteroaromatisches Ringsystem mit 5 bis 60 aromatischen Ringatomen, welches mit einem oder mehreren Resten R¹ substituiert sein kann;
R⁵ ist bei jedem Auftreten gleich oder verschie-den H, D, F, Cl, Br, I, N(Ar³)₂, CN, NO₂, Si(R²)₃, B(OR²)₂, C(=O)Ar³, P(=O)(Ar³)₂, S(=O)Ar³, S(=O)₂Ar³, -CR²=CR²(Ar³), Tosylat, Triflat, OSO₂R², eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² er-setzt sein können und wobei ein oder mehrere H-Atome durch F, Cl, Br, I, CN oder NO₂ er-setzt sein können, oder eine Aryloxy- oder Heteroaryloxygruppe mit 5 bis 60 aromatischen Ringatomen, die durch einen oder mehrere Res-te R² substituiert sein kann, oder eine Kom-bination dieser Systeme; wobei auch zwei oder mehrere benachbarte Substituenten R⁵ mitei-nander über eine kovalente Einfachbindung oder eine bivalente Gruppe Z verknüpft sein können;
wobei R¹, R², Ar³, Ar⁴ und Z die gleichen Bedeutungen wie in den vorhergehenden Ansprüchen definiert haben.

8. Blend nach einem der beiden vorhergehenden Ansprüche, **dadurch gekennzeichnet, dass** eine weitere Struktureinheit eine Einheit der folgenden Formel (VII) ist 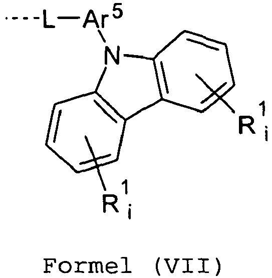 wobei die gestrichelte Linie die Verbindung zum Grundgerüst des Polymers darstellt,
die unspezifischen Bindungen, die in der Mitte der aromatische Ringe enden, andeuten, dass der Rest R¹ an jeder der Positionen 1 bis 8 des Carbazols sitzen kann,
die Symbole L, R¹ und Ar⁵ die gleichen Bedeutungen wie in den vorhergehenden Ansprüchen haben, und
der Index i gleich 0,1, 2, 3 oder 4 ist.

9. Blend nach einem oder mehreren der Ansprüche 6 bis 8, **dadurch gekennzeichnet, dass** eine weitere Struktureinheit eine Einheit der folgenden Formel (VIII) ist 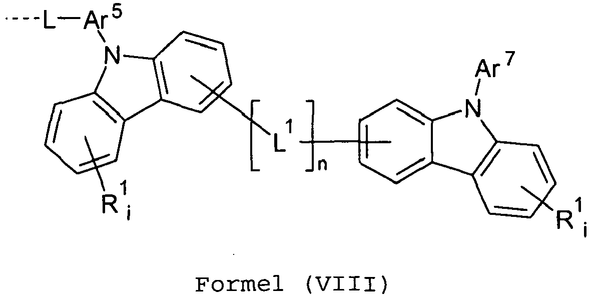 wobei die gestrichelte Linie die Verbindung zum Grundgerüst des Polymers darstellt,
die unspezifischen Bindungen, die in der Mitte der aromatischen Ringe enden, andeuten, dass die Symbole R¹ und L¹ jeweils an jeder der entsprechenden Positionen 1 bis 8 des Carbazols sitzen können,
die Symbole L, R¹ und Ar⁵ und der Index i die gleichen Bedeutungen wie in den vorstehenden Ansprüchen haben, und die übrigen verwendeten Symbole und Indices die folgenden Bedeutungen aufweisen:
L¹ ist bei jedem Auftreten gleich oder ver-schieden eine kovalente Einfachbindung oder eine geradkettige Alkylengruppe mit 1 bis 20 C-Atomen oder eine verzweigte oder cyc-lische Alkylengruppe mit 3 bis 20 C-Atomen, die jeweils mit einem oder mehreren Resten R¹ substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wo-bei ein oder mehrere H-Atome durch F, Cl, Br, I, CN oder NO₂ ersetzt sein können;
n ist gleich 0, 1, 2 oder 3, mit der Maßgabe, dass, wenn n > 1 ist, maximal ein L¹ ein aromatisches oder heteroaromatisches Ring-system sein kann;
Ar⁷ ist ein mono- oder polycyclisches, aromati-sches oder heteroaromatisches Ringsystem mit 5 bis 60 aromatischen Ringatomen, wel-ches mit einem oder mehreren Resten R¹ sub-stituiert sein kann.

10. Blend nach einem oder mehreren der Ansprüche 6 bis 9, **dadurch gekennzeichnet, dass** eine weitere Struktureinheit eine Einheit der folgenden Formel (IX) ist 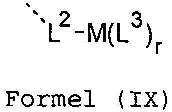 wobei die gestrichelte Linie eine Verbindung zum Grundgerüst des Polymers darstellt, und die verwendeten Symbole und Indices die folgenden Bedeutungen aufweisen:
L² und L³ sind unabhängig voneinander bei jedem Auftreten gleich oder verschieden ein ein-oder mehrzähniger Ligand;
M ist eine Übergangsmetall, ein Hauptgruppen-metall, ein Lanthanoid oder ein Actinoid;
r ist je nach Zähnigkeit der Liganden L² und L³ und der Koordinationszahl des Metall M gleich 0, 1, 2, 3, 4, 5, 6 oder 7.

11. Blend nach einem oder mehreren der Ansprüche 6 bis 10, **dadurch gekennzeichnet, dass** eine weitere Struktureinheit eine Einheit der folgenden Formel (XI) ist 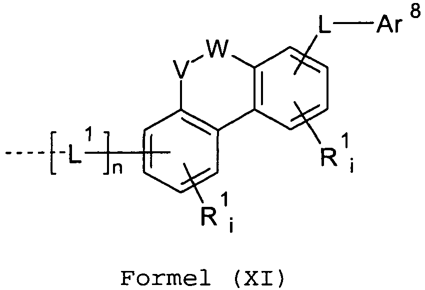 wobei die gestrichelte Linie die Verbindung zum Grundgerüst des Polymers darstellt,
die unspezifischen Bindungen, die in der Mitte der aromatischen Ringe enden, andeuten, dass die Symbole R¹, L und L¹ jeweils an jeder der freien Positionen der aromatischen Ringe sitzen können,
die Symbole R¹, L und L¹ und die Indices i und n die gleichen Bedeutungen wie in den vorstehenden Ansprüchen haben, und die übrigen verwendeten Symbole die folgenden Bedeutungen haben:
V und W sind unabhängig voneinander aus der Gruppe ausgewählt, die aus C(Ar³)₂, C(R⁵)₂, Si(Ar³)₂, Si(R⁵)₂, Ge(Ar³)₂, Ge(R⁵)₂, C=O, O, S, Se, N(Ar⁴), N(R⁵), P(Ar⁴), P(R⁵), P=O(Ar³), P=O(R⁵), B und (R⁵)₂CO;
Ar⁸ ist ein mono- oder polycyclisches, aromati-sches oder heteroaromatisches Ringsystem mit 5 bis 60 aromatischen Ringatomen, wel-ches mit einem oder mehreren Resten R¹ sub-stituiert sein kann;
wobei die Symbole R⁵, Ar³ und Ar⁴ die gleichen Bedeutungen wie in den vorstehenden Ansprüchen definiert haben.

12. Blend nach einem der vorhergehenden Ansprüche, **dadurch gekennzeichnet, dass** das mindestens eine Host-Molekül ausgewählt ist aus der Gruppe bestehend aus
a) Carbazolverbindungen der allgemeinen Formel (XIII) 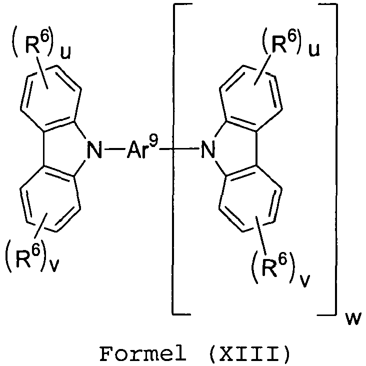 wobei für die verwendeten Symbole und Indices gilt:
Ar⁹ ist bei jedem Auftreten ein aromati-sches oder heteroaromatisches Ringsystem mit 5 bis 60 aromatischen Ringatomen, wel-ches mit einem oder mehreren Resten R⁶ sub-stituiert sein kann;
R⁶ ist bei jedem Auftreten gleich oder verschieden H, D, F, Cl, Br, I, N(Ar¹⁰)₂, CN, NO₂, Si(R⁷)₃, B(OR⁷)₂, C(=O)Ar¹⁰, P(=O)(Ar¹⁰)₂, S(=O)Ar¹⁰, S(=O)₂Ar¹⁰, -CR⁷=CR⁷(Ar¹⁰), OSO₂R⁷, eine geradkettige Al-kyl-, Alkoxy- oder Thioalkoxygruppe mit 1 bis 40 C-Atomen oder eine verzweigte oder cyclische Alkyl-, Alkoxy- oder Thioalkoxy-gruppe mit 3 bis 40 C-Atomen, die jeweils mit einem oder mehreren Resten R⁷ substitu-iert sein kann, wobei eine oder mehrere nicht benachbarte CH₂-Gruppen durch R⁷C=CR⁷, C=C, Si(R⁷)₂, Ge(R⁷)₂, Sn(R⁷)₂, C=O, C=S, C=Se, C=NR⁷, P(=O)(R⁷), SO, SO₂, NR⁷, O, S oder CONR⁷ ersetzt sein können und wobei ein oder mehrere H-Atome durch F, Cl, Br, I, CN oder NO₂ ersetzt sein können, oder ein aromatisches oder heteroaromatisches Ringsystem mit 5 bis 60 aromatischen Ring-atomen, das jeweils mit einem oder mehreren Resten R⁷ substituiert sein kann, oder eine Aryloxy- oder Heteroaryloxygruppe mit 5 bis 60 aromatischen Ringatomen, die mit einem oder mehreren Resten R⁷ substituiert sein kann, oder eine Kombination dieser Systeme; dabei können zwei oder mehrere Substituen-ten R⁶ und/oder R⁷ auch miteinander ein mo-no oder polycyclisches aliphatisches oder aromatisches Ringsystem bilden;
Ar¹⁰ ist bei jedem Auftreten gleich oder verschieden ein aromatisches oder hetero-aromatisches Ringsystem mit 5 bis 60 aroma-tischen Ringatomen, welches mit einem oder mehreren Resten R⁷ substituiert sein kann;
R⁷ ist bei jedem Auftreten gleich oder verschieden H, D oder ein aliphatischer, aromatischer und/oder heteroaromatischer Kohlenwasserstoffrest mit 1 bis 20 C-Atomen; oder ein aromatisches oder hetero-aromatisches Ringsystem mit 5 bis 60 aroma-tischen Ringatomen, welches mit einem oder mehreren Resten R substituiert sein kann;
R ist bei jedem Auftreten gleich oder verschieden H, D, N(Ar¹⁰)₂, eine gerad-kettige Alkylgruppe mit 1 bis 5 C-Atomen oder verzweigte Alkylgruppe mit 3 bis 5 C-Atomen, wobei jeweils eine oder mehrere nicht benachbarte CH₂-Gruppen durch-R⁸C=CR⁸-, wobei R⁸ wie untenstehend defi-niert ist, oder -O- ersetzt sein können und wobei ein oder mehrere H-Atome durch F er-setzt sein können, oder eine Arylgruppe mit 6 bis 16 C-Atomen oder Heteroarylgruppe mit 2 bis 16 C-Atomen oder eine Spiro-bifluorengruppe, die jeweils mit einem oder mehreren Resten R⁷ substituiert sein kann, oder eine Kombination aus zwei dieser Sys-teme steht; dabei können zwei oder mehrere Substituenten R⁷ auch miteinander ein mono-oder polycyclisches, aliphatisches, aroma-tisches oder heteroaromatisches Ringsystem bilden;
u ist bei jedem Auftreten gleich oder ver-schieden 0, 1, 2, 3 oder 4;
v ist bei jedem Auftreten gleich oder ver-schieden 0, 1, 2, 3 oder 4; und
w ist 1, 2, 3, 4 oder 5; und/oder
b) neutralen Verbindungen gemäß den allgemeinen Formeln (XIV) oder (XV) 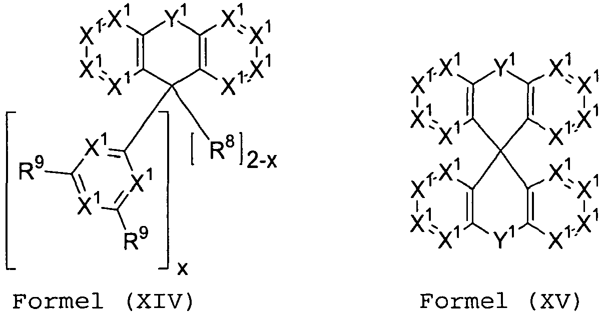 wobei für die verwendeten Symbole und Indices gilt:
X¹ ist bei jedem Auftreten gleich oder verschieden CR⁸; oder zwei direkt benach-barte Gruppen X¹ stehen für eine Einheit der folgenden Formel (XVI) 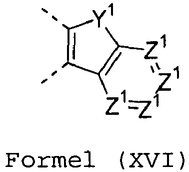
wobei die gestrichelten Bindungen die Verknüpfung der Einheit mit den benachbarten C-Atomen andeutet;
Y¹ ist bei jedem Auftreten gleich oder verschieden eine Einfachbindung oder eine Gruppe ausgewählt aus C(R⁸)₂, C(=C(R⁸)₂), Si(R⁸)₂, C(R⁸)₂-C(R⁸)₂, oder CR⁸=CR⁸;
Z¹ ist bei jedem Auftreten gleich oder verschieden CR⁸;
R⁸ ist bei jedem Auftreten gleich oder verschieden H, D, eine geradkettige Alkyl-, Alkenyl- oder Alkinylgruppe mit 1 bis 40 C-Atomen oder eine verzweigte oder cyclische Alkyl-, Alkenyl- oder Alkinylgruppe mit 3 bis 40 C-Atomen, die jeweils mit einem oder mehreren Resten R¹⁰ substituiert sein kann, oder ein aromatisches oder heteroaroma-tisches Ringsystem mit 5 bis 60 aromati-schen Ringatomen, das jeweils durch einen oder mehrere Reste R⁹ substituiert sein kann, oder eine Kombination dieser Systeme; dabei können zwei oder mehrere benachbarte Substituenten R⁸ auch miteinander ein mono-oder polycyclisches, aliphatisches oder aromatisches Ringsystem bilden; oder eine Einheit gemäß der allgemeinen Formel (XVII) 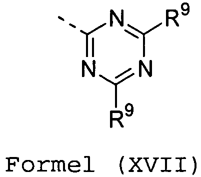
wobei die gestrichelten Bindungen die Verknüpfung der Einheit mit den benachbarten C-Atomen andeuten;
R⁹ ist bei jedem Auftreten gleich oder verschieden H, D oder ein aromatisches oder heteroaromatisches Ringsystem mit 5 bis 60 aromatischen Ringatomen, welches durch ei-nen oder mehrere Reste R⁸ substituiert sein kann;
R¹⁰ ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch F ersetzt sein können; dabei können zwei oder mehrere benachbarte Substituenten R¹⁰ auch miteinan-der ein mono- oder polycyclisches, alipha-tisches oder aromatisches Ringsystem bil-den; und
x ist 1 oder 2; und/oder
c) neutralen Verbindungen der allgemeinen Formel (XXX) 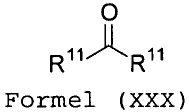 wobei
R¹¹ ein aromatisches oder heteroaroma-tisches Ringsystem mit 5 bis 60 aromati-schen Ringatomen, das jeweils durch einen oder mehrere Reste R⁹ substituiert sein kann, oder eine Kombination dieser Systeme; dabei können zwei oder mehrere benachbarte Substituenten R¹⁰ auch miteinander ein mo-no- oder polycyclisches, aliphatisches oder aromatisches Ringsystem bilden; oder eine Einheit gemäß der allgemeinen Formel (XXXI) 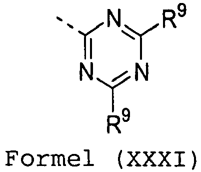
wobei die gestrichelten Bindungen die Verknüpfung der Einheit mit dem C-Atom der Ketogruppe andeuten.

13. Blend nach einem der vorhergehenden Ansprüche, **dadurch gekennzeichnet, dass**
a) das mindestens eine Host-Molekül elektronentransportierende Funktionalität aufweist und ausgewählt ist aus der Gruppe bestehend aus den nachfolgend abgebildeten Verbindungen 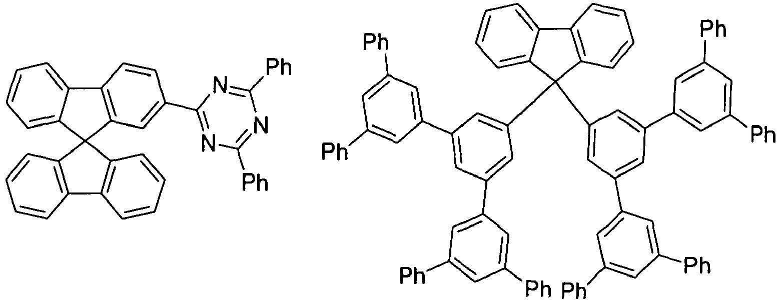
b) und/oder das mindestens eine Host-Molekül lochtransportierende Funktionalität aufweist und ausgewählt ist aus der Gruppe bestehend aus den nachfolgend abgebildeten Verbindungen

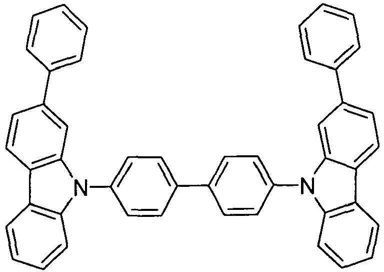

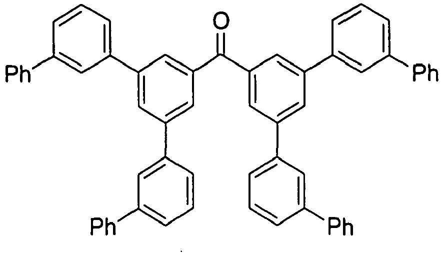

14. Blend nach einem oder mehreren der vorhergehenden Ansprüche, **dadurch gekennzeichnet, dass** das Emitter-Molekül eine Verbindung der Formeln (21) bis (24) ist, 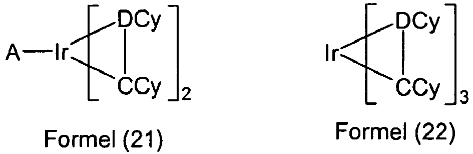 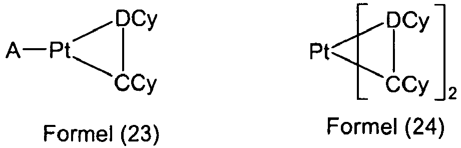 wobei für die verwendeten Symbole gilt:
DCy ist gleich oder verschieden bei jedem Auf-treten eine cyclische Gruppe, die mindes-tens ein Donoratom, vorzugsweise Stick-stoff, Kohlenstoff in Form eines Carbens oder Phosphor, enthält, über welches die cyclische Gruppe an das Metall gebunden ist, und die wiederum einen oder mehrere Substituenten, ausgewählt aus der Gruppe bestehend aus R¹² oder CN, Boranresten oder Silylresten, wobei R¹² ausgewählt ist aus der Gruppe bestehend aus H, D oder ein ali-phatischer oder aromatischer Kohlenwasser-stoffrest mit 1 bis 20 C-Atomen tragen kann; die Gruppen DCy und CCy sind über ei-ne kovalente Bindung miteinander verbunden;
CCy ist gleich oder verschieden bei jedem Auf-treten eine cyclische Gruppe, die ein Koh-lenstoffatom enthält, über welches die cyc-lische Gruppe an das Metall gebunden ist und die wiederum einen oder mehrere Substi-tuenten ausgewählt aus der Gruppe bestehend aus H, D, F, CN, sekundären oder tertiären Aminen, eine geradkettige, verzweigte oder cyclische Alkyl-, Alkoxy- oder Thioalkoxy-gruppe mit 1 bis 40 C-Atomen, oder ein aro-matisches oder heteroaromatisches Ringsys-tem mit 1 bis 60 C-Atomen, tragen kann;
A ist gleich oder verschieden bei jedem Auf-treten ein monoanionischer, zweizähnig chelatisierender Ligand, bevorzugt ein Diketonatligand; und
R¹² ist bei jedem Auftreten gleich oder ver-schieden H, D, F, CN, N(R¹³)₂, eine gerad-kettige, verzweigte oder cyclische Alkyl-, Alkoxy- oder Thioalkoxygruppe mit 1 bis 40 C-Atomen, die mit R¹⁴ substituiert oder auch unsubstituiert sein kann, wobei eine oder mehrere nicht benachbarte CH₂-Gruppen durch -R¹⁵C=CR¹⁵- , -C=C-, Si(R¹⁵)₂, Ge(R¹⁵)₂, Sn(R¹⁵)₂, C=O, C=S, C=Se, C=NR¹⁵, -O-, -S-, -NR¹⁵ oder -CONR¹⁵- ersetzt sein können und wobei ein oder mehrere H-Atome durch F, Cl, Br, I, CN oder NO₂ ersetzt sein können, oder ein aromatisches oder heteroaromati-sches Ringsystem mit 1 bis 60 C-Atomen, das mit einem oder mehreren Resten R¹⁴ substi-tuiert sein kann, wobei zwei oder mehrere Substituenten R¹² auch zusammen mit den Atomen, an die sie gebunden sind, miteinan-der ein mono- oder polycyclisches, alipha-tisches oder aromatisches Ringsystem bilden können; wobei mindestens eine Gruppe R¹² eine Bindung zu einer weiteren Strukturein-heit des Polymers aufweist;
R¹³ ist bei jedem Auftreten gleich oder ver-schieden eine geradkettige, verzweigte oder cyclische Alkyl- oder Alkoxygruppe mit 1 bis 22 C-Atomen, in der auch ein oder meh-rere nicht benachbarte C-Atome durch-R¹⁵C=CR¹⁵-, -C=C-, Si(R¹⁵)₂, Ge(R¹⁵)₂, Sn(R¹⁵)₂, -NR¹⁵-, -O- , -S-, -CO-O- , -O-CO-O-ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R¹⁴ substituiert sein kann, oder OH oder N(R¹⁴)₂;
R¹⁴ ist bei jedem Auftreten gleich oder ver-schieden R¹⁵ oder CN, B(R¹⁵)₂ oder Si(R¹⁵)₃;
R¹⁵ ist bei jedem Auftreten gleich oder ver-schieden H, D oder ein aliphatischer oder aromatischer Kohlenwasserstoffrest mit 1 bis 20 C-Atomen.

15. Blend nach einem der vorhergehenden Ansprüche, **dadurch gekennzeichnet, dass** der Anteil des Emitter-Moleküls in der Mischung 0,1 bis 40 Gew.-% beträgt.

16. Blend nach einem der vorhergehenden Ansprüche, **dadurch gekennzeichnet, dass**
a) die Struktureinheit in den Seitenketten des mindestens einen Polymers oder Copolymers elektronentransportierende Funktionalität und das mindestens eine Host-Molekül lochtransportierende Funktionalität aufweist, oder
b) die Struktureinheit in den Seitenketten des mindestens einen Polymers oder Copolymers lochtransportierende Funktionalität und das mindestens eine Host-Molekül elektronentransportierende Funktionalität aufweist.

17. Blend nach einem der vorhergehenden Ansprüche, **dadurch gekennzeichnet, dass** das Grundgerüst des Polymers ein Polyethylengerüst ist.

18. Formulierung, enthaltend einen Blend nach einem der vorhergehenden Ansprüche, sowie mindestens eine weitere Komponente.

19. Formulierung nach vorhergehendem Anspruch, **dadurch gekennzeichnet, dass** die mindestens eine weitere Komponente ausgewählt ist aus der Gruppe bestehend aus Lösungsmitteln, wobei die Formulierung in diesem Fall bevorzugt als Lösung, Dispersion, Suspension oder Aufschlämmung vorliegt; Lichtstabilisatoren; UV-Stablilisatoren; Flammschutzmitteln; Füllstoffe sowie Kombinationen hieraus.

20. Verbindung der folgenden Formel (Ia) 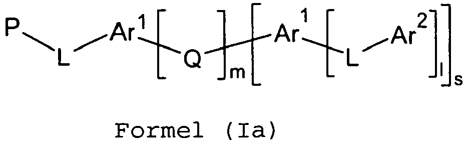 worin die verwendeten Symbole und Indices dieselben Bedeutungen wie in den vorstehenden Ansprüchen haben, und das Symbol P eine polymerisierbare Gruppe ist.

21. Elektronische Vorrichtung, umfassend eine Anode, eine Kathode sowie einen zwischen Anode und Kathode angeordnete Schicht aus einem Blend nach einem der Ansprüche 1 bis 17 oder eine Formulierung nach einem der Ansprüche 18 bis 19.

22. Elektronische Vorrichtung nach vorhergehendem Anspruch, umfassend eine zwischen der Kathode und der Schicht aus dem Blend angeordnete Schicht aus einem leitfähigen Polymer, insbesondere PEDOT:PSS.

23. Elektronische Vorrichtung nach vorhergehendem Anspruch, umfassend eine zwischen dem leitfähigen Polymer und der Schicht aus dem Blend angeordnete Lochinjektionsschicht, insbesondere aus einem Arylamin-Polymer.

24. Elektronische Vorrichtung nach einem der Ansprüche 22 bis 23, **dadurch gekennzeichnet, dass**
a) die Kathode aus einem halbleitenden Mischoxid, insbesondere ITO (Indium-ZinnOxid) und/oder
b) die Anode aus Metallen, insbesondere Barium, Aluminium und/oder Kombinationen oder Legierungen hieraus
gebildet ist.

25. Elektronische Vorrichtung nach einem der Ansprüche 22 bis 24, **dadurch gekennzeichnet, dass**
a) die Anode auf einem Substrat, insbesondere auf einem Glas- oder Kunststoffsubstrat aufgebracht ist, das auf der der Schicht aus dem Blend abgewandten Seite der Anode angeordnet ist, und/oder
b) die Kathode mit einem Deckglas oder einem transparenten Kunststoff versehen ist, das auf der der Schicht aus dem Blend abgewandten Seite der Kathode angeordnet ist.

26. Elektronische Vorrichtung nach einem der Ansprüche 22 bis 25, **dadurch gekennzeichnet, dass** die Schichtdicke
a) der Schicht aus dem Blend von 10 bis 1.000 nm, bevorzugt von 30 bis 300 nm, besonders bevorzugt von 50 bis 110 nm,
b) der Kathode von 3 bis 300 nm, bevorzugt von 3 bis 160 nm,
c) der Schicht aus dem leitfähigen Polymer von 10 bis 500 nm, bevorzugt von 20 bis 200 nm, besonders bevorzugt von 60 bis 80 nm, und/oder
d) der Lochinjektionsschicht von 5 bis 500 nm, bevorzugt von 10 bis 100 nm, besonders bevorzugt von 10 bis 30 nm
beträgt.

27. Elektronische Vorrichtung nach einem der Ansprüche 22 bis 26, **dadurch gekennzeichnet, dass** die elektronische Vorrichtung ausgewählt ist aus der Gruppe bestehend aus organischen Elektrolumineszenzvorrichtungen, insbesondere OLEDs oder PLEDs, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), organischen lichtemittierenden elektrochemischen Zellen (OECs) oder organischen Laserdioden (O-Laser).

28. Verwendung eines Blends nach einem der Ansprüche 1 bis 17 und/oder einer Formulierung nach einem der Ansprüche 18 bis 19 für elektronische Vorrichtungen, insbesondere elektronische Vorrichtungen, ausgewählt aus der Gruppe bestehend aus organischen Elektrolumineszenzvorrichtungen, insbesondere OLEDs oder PLEDs, organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), organischen lichtemittierenden elektrochemischen Zellen (OECs) oder organischen Laserdioden (O-Laser).

## Claims

1. Blend comprising:
a) at least one polymer or copolymer or a mixture of a plurality of polymers and/or copolymers, where the at least one polymer or copolymer contains at least one structural unit of the following formula (I) in the side chains 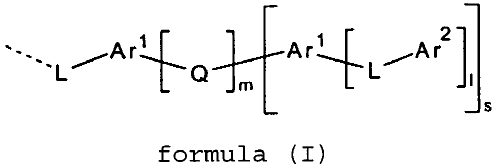 where the dashed line represents the connection to the polymer or copolymer backbone, and the other symbols and indices used have the following meanings:
L is on each occurrence, identically or dif-ferently, a single covalent bond or a straight-chain alkylene group having 1 to 20 C atoms or a branched or cyclic alkylene group having 3 to 20 C atoms, each of which may be substituted by one or more radicals R¹, where one or more non-adjacent CH₂ groups may be replaced by R²C=CR², C≡C, Si(R²)₂, Ge(R²)₂, Sn(R²)₂, C=O, C=S, C=Se, C=NR², P(=O) (R²), SO, SO₂, NR², O, S or CONR² and where one or more H atoms may be replaced by F, Cl, Br, I, CN or NO₂, preferably a single covalent bond;
Ar¹ is on each occurrence, identically or differently, a divalent, mono- or polycyc-lic, aromatic or heteroaromatic ring sys-tem having 5 to 60 aromatic ring atoms, which may be substituted by one or more radicals R¹;
Ar² is on each occurrence, identically or differently, a mono- or polycyclic, aro-matic or heteroaromatic ring system having 5 to 60 aromatic ring atoms, which may be substituted by one or more radicals R¹;
Q is a unit selected from the group consist-ing of a group -X(=A)-, where A = O, S, Se or Te, and mono- or polycyclic aromatic ring systems having 6 to 60 aromatic car-bon atoms or mono- or polycyclic hetero-aromatic ring systems having 2 to 50 aro-matic carbon atoms;
m is 0, 1, 2 or 3, preferably 0 or 1;
l is 0, 1, 2 or 3;
s is 1 in the case of Q = -X(=A)-; is 1 to 5, preferably 1 to 3, in the case where Q is selected from the group consisting of mono- or polycyclic aromatic ring systems having 6 to 60 aromatic carbon atoms or mono- or polycyclic heteroaromatic ring systems having 2 to 50 aromatic carbon atoms; and is 1 or 2 in the case m = 0;
R¹ is on each occurrence, identically or differently, D, F, Cl, Br, I, N(Ar³)₂, CN, NO₂, Si(R²)₃, B(OR²)₂, C(=O) Ar³, P(=O)(Ar³)₂, S(=O) Ar₃, S (=O)₂ Ar³, - CR²=CR² (Ar³) , a mono- or polycyclic, aro-matic or heteroaromatic ring system having 5 to 60 aromatic ring atoms, tosylate, triflate, OSO₂R², a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R², where one or more non-adjacent CH₂ groups may be replaced by R²C=CR², C=C, Si(R²)₂, Ge(R²₂, ₂, Sn(R²)₂, C=O, C=S, C=Se, C=NR², P(=O)(R²), SO, SO₂, NR², O, S or CONR² and where one or more H atoms may be replaced by F, Cl, Br, I, CN or NO₂, or a combination of these systems; where two or more adjacent substituents R¹ may also be linked to one another via a single covalent bond or a divalent group Z;
X is selected from the group consisting of C, P(Ar⁴), S and SO, preferably C or P(Ph);
R² is on each occurrence, identically or differently, a straight-chain alkyl group having 1 to 20 C atoms or a branched or cyclic alkyl group having 3 to 20 C atoms, where one or more non-adjacent CH₂ groups may be replaced by NH, O or S and where one or more H atoms may be replaced by F, or a mono- or polycylic, aromatic or heteroaromatic ring system having 5 to 20 aromatic ring atoms, which may in each case be substituted by one or more radi-cals R³; where two or more substituents R² may also be linked to one another via a single covalent bond or a divalent group Z;
R³ is on each occurrence, identically or differently, a straight-chain alkyl group having 1 to 20 C atoms or a branched or cyclic alkyl group having 3 to 20 C atoms, where one or more non-adjacent CH₂ groups may be replaced by NH, O or S and where one or more H atoms may be replaced by F; where two or more substituents R³ may also be linked to one another via a single covalent bond or a divalent group Z;
Ar³ and Ar⁴ are on each occurrence, identi-cally or differently, a mono- or poly-cyclic, aromatic or heteroaromatic ring system having 5 to 60 aromatic ring atoms, which may be substituted by one or more radicals R³ ;
Z represents a divalent group -(CR⁴₂) q-;
q is equal to 1, 2, 3, 4 or 5;
R⁴ is on each occurrence, identically or differently, a straight-chain alkyl group having 1 to 20 C atoms or a branched or cyclic alkyl group having 3 to 20 C atoms, where one or more non-adjacent CH₂ groups may be replaced by NH, O or S and where one or more H atoms may be replaced by F.
b) at least one host molecule which has electron- or hole-transporting functionality, and
c) at least one emitter molecule.

2. Blend according to Claim 1, **characterised in that**
Q is selected from the group consisting of -X(=O)-; 1,3,5-triazylene and/or radicals derived from benzene, naphthalene, anthra-cene, benzanthracene, phenanthrene, benzo-phenanthrene, pyrene, chrysene, perylene, fluoranthene, benzofluoranthene, naphthacene, pentacene, benzopyrene, biphenyl, biphenyl-ene, terphenyl, terphenylene, fluorene, spirobifluorene, dihydrophenanthrene, dihydropyrene, tetrahydropyrene, cis- or trans-indenofluorene, cis- or trans-mono-benzoindenofluorene, cis- or trans-dibenzo-indenofluorene, truxene, isotruxene, spiro-truxene, spiroisotruxene, furan, benzofuran, isobenzofuran, dibenzofuran, thiophene, benzothiophene, isobenzothiophene, dibenzo-thiophene, pyrrole, indole, isoindole, carba-zole, pyridine, quinoline, isoquinoline, acridine, phenanthridine, benzo-5,6-quino-line, benzo-6,7-quinoline, benzo-7,8-quino-line, phenothiazine, phenoxazine, pyrazole, indazole, imidazole, benzimidazole, naphth-imidazole, phenanthrimidazole, pyridimida-zole, pyrazinimidazole, quinoxalinimidazole, oxazole, benzoxazole, naphthoxazole, anthrox-azole, phenanthroxazole, isoxazole, 1,2-thia-zole, 1,3-thiazole, benzothiazole, pyrida-zine, benzopyridazine, pyrimidine, benzopyri-midine, quinoxaline, 1,5-diazaanthracene, 2,7-diazapyrene, 2,3-diazapyrene, 1,6-diaza-pyrene, 1,8-diazapyrene, 4,5-diazapyrene, 4,5,9,10-tetraazaperylene, pyrazine, phena-zine, phenoxazine, phenothiazine, fluorubine, naphthyridine, azacarbazole, benzocarboline, phenanthroline, 1,2,3-triazole, 1,2,4-tri-azole, benzotriazole, 1,2,3-oxadiazole, 1,2,4-oxadiazole, 1,2,5-oxadiazole, 1,3,4-oxadiazole, 1,2,3-thiadiazole, 1,2,4-thia-diazole, 1,2,5-thiadiazole, 1,3,4-thia-diazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole, where the 1,3,5-triazylene or the radicals may each be substituted at any desired posi-tion by one or more radicals R¹, R² and/or R³ and/or may be linked to the aromatic or heteroaromatic ring system via any desired positions; and
s is 1 in the case of Q = -X(=O)-; is 1 or 2 in the case Q = 1,3,5-triazylene; or is 1, 2, 3, 4 or 5 in the case where Q is selected from the radicals indicated above.

3. Blend according to one of the preceding claims, **characterised in that characterised in that** Ar¹ or Ar² or Ar¹ and Ar² are selected on each occurrence, independently of one another, from the group consisting of radicals derived from benzene, naphthalene, anthracene, benzanthracene, phenanthrene, benzophenanthrene, pyrene, chrysene, perylene, fluoranthene, benzofluoranthene, naphthacene, pentacene, benzopyrene, biphenyl, biphenylene, terphenyl, terphenylene, fluorene, spirobifluorene, dihydrophenanthrene, dihydropyrene, tetrahydropyrene, cis- or trans-indenofluorene, cis- or trans-monobenzoindenofluorene, cis- or trans-dibenzoindenofluorene, truxene, isotruxene, spirotruxene, spiroisotruxene, furan, benzofuran, isobenzofuran, dibenzofuran, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, 1,5-diazaanthracene, 2,7-diazapyrene, 2,3-diazapyrene, 1,6-diazapyrene, 1,8-diazapyrene, 4,5-diazapyrene, 4,5,9,10-tetraazaperylene, pyrazine, phenazine, phenoxazine, phenothiazine, fluorubine, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole, each of which may be substituted at any desired position by one or more radicals R¹, R² and/or R³ and/or may be linked to the aromatic or heteroaromatic ring system via any desired positions.

4. Blend according to one of the preceding claims, **characterised in that** the structural unit of the formula (I) is selected from the group consisting of
a) structural units having electron-transporting substituents, of the following general formulae (II) and/or (III) 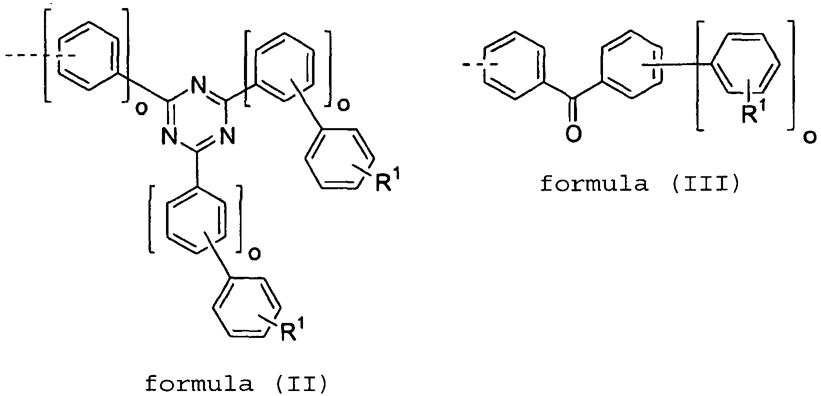
b) and/or structural units having hole-transporting substituents, of the general formulae (IV) and/or (V) 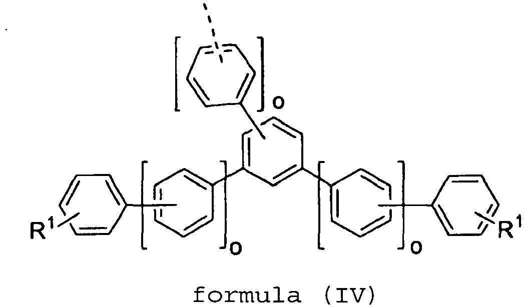 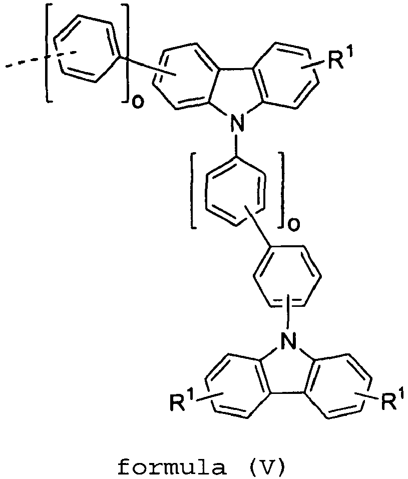
where the dashed line represents the connection to the polymer or copolymer backbone, R¹ has the meaning given above, and in each case, independently of one another, o = 0 or 1 to 10.

5. Blend according to one of the preceding claims, **characterised in that**
a) the structural unit having electron-transporting substituents is selected from the group consisting of the following structural units: 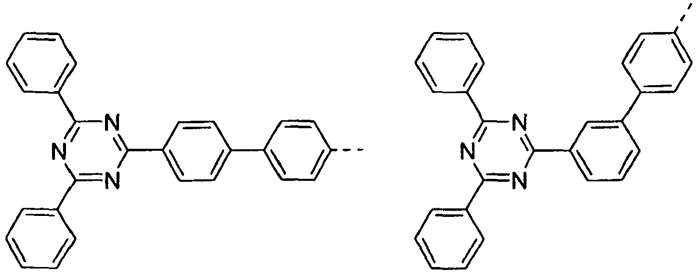 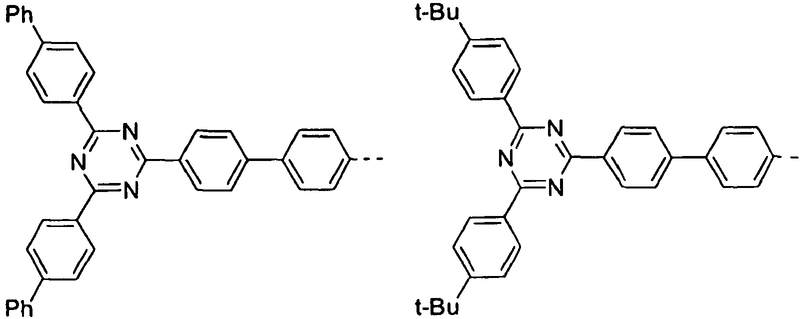 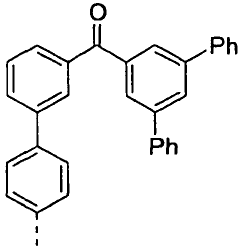
b) and/or the structural unit having hole-transporting substituents is selected from the group consisting of the following structural units: 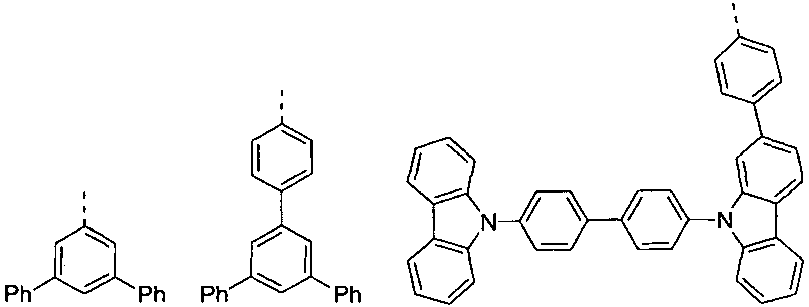
where the dashed line in each case represents the connection to the polymer or copolymer backbone.

6. Blend according to one of the preceding claims, **characterised in that**, besides the side chain containing the structural unit of the formula (I), it includes at least one further side chain which contains a further structural unit.

7. Blend according to the preceding claim, in which the further structural unit is a unit of the following formula (VI) 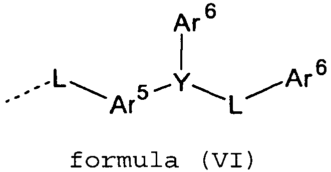 where the dashed line represents the connection to the polymer backbone, and the symbol L has the same meanings as the preceding claims, and the other symbols used have the following meanings:
Y is a trivalent unit which is selected from the group consisting of N, B, Si(Ar⁴), SiR⁵, Ge (Ar⁴), GeR⁵ , P and As;
Ar⁵ is a divalent, mono- or polycyclic, aro-matic or heteroaromatic ring system having 5 to 60 aromatic ring atoms, which may be sub-stituted by one or more radicals R¹;
Ar⁶ is a mono- or polycyclic, aromatic or heteroaromatic ring system having 5 to 60 aromatic ring atoms, which may be substituted by one or more radicals R¹;
R⁵ is on each occurrence, identically or differ-ently, H, D, F, Cl, Br, I, N(Ar³)₂, CN, NO₂, Si(R²)₃, B(OR²)₂, C (=O) Ar³, P (=O) (Ar³)₂, S(=O)Ar³, S(=O)₂Ar³, CR²=CR² (Ar³), tosylate, triflate, OSO₂R², a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R², where one or more non-adja-cent CH₂ groups may be replaced by R²C=CR², C=C, Si(R²)₂, Ge(R²)₂, Sn(R²)₂, C=O, C=S, C=Se, C=NR², P(=O)(R²), SO, SO₂ NR², O, S or CONR² and where one or more H atoms may be replaced by F, Cl, Br, I, CN or NO₂, or an aryloxy or heteroaryloxy group having 5 to 60 aromatic ring atoms, which may be substituted by one or more radicals R², or a combination of these systems; where two or more adjacent substituents R⁵ may also be linked to one another via a single covalent bond or a diva-lent group Z;
where R¹, R², Ar³ , Ar⁴ and Z have the same meanings as defined in the preceding claims.

8. Blend according to one of the two preceding claims, **characterised in that** a further structural unit is a unit of the following formula (VII) 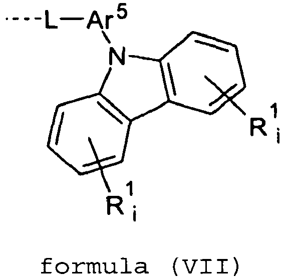 where the dashed line represents the connection to the polymer backbone,
the non-specific bonds which end in the centre of the aromatic rings indicate that the radical R¹ may sit at each of positions 1 to 8 of the carbazole,
the symbols L, R¹ and Ar⁵ have the same meanings as in the preceding claims, and
the index i is equal to 0,1, 2, 3 or 4.

9. Blend according to one or more of Claims 6 to 8, **characterised in that** a further structural unit is a unit of the following formula (VIII) 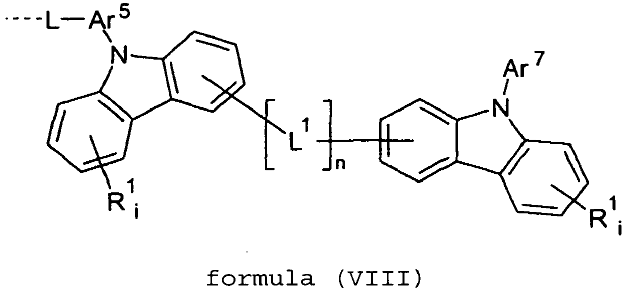 where the dashed line represents the connection to the polymer backbone,
the non-specific bonds which end in the centre of the aromatic rings indicate that the symbols R¹ and L¹ may each sit at each of the corresponding positions 1 to 8 of the carbazole,
the symbols L, R¹ and Ar⁵ and the index i have the same meanings as in the above claims, and the other symbols and indices used have the following meanings:
L¹ is on each occurrence, identically or differently, a single covalent bond or a straight-chain alkylene group having 1 to 20 C atoms or a branched or cyclic alkylene group having 3 to 20 C atoms, each of which may be substituted by one or more radicals R¹, where one or more non-adjacent CH₂ groups may be replaced by R²C=CR², C≡C, Si (R²)₂, Ge (R²)₂, Sn(R²)₂, C=O, C=S, C=Se, C=NR², P (=O) (R²), SO, SO₂, NR², O, S or CONR² and where one or more H atoms may be replaced by F, Cl, Br, I, CN or NO₂;
n is equal to 0, 1, 2 or 3, with the proviso that, if n > 1, a maximum of one L¹ may be an aromatic or heteroaromatic ring system;
Ar⁷ is a mono- or polycyclic, aromatic or heteroaromatic ring system having 5 to 60 aromatic ring atoms, which may be substi-tuted by one or more radicals R¹.

10. Blend according to one or more of Claims 6 to 9, **characterised in that** a further structural unit is a unit of the following formula (IX) 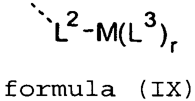 where the dashed line represents a connection to the polymer backbone, and the symbols and indices used have the following meanings:
L² and L³ are, independently of one another, on each occurrence, identically or differ-ently, a mono- or polydentate ligand;
M is a transition metal, a main-group metal, a lanthanoid or an actinoid;
r is equal to 0, 1, 2, 3, 4, 5, 6 or 7, depending on the denticity of the ligands L² and L³ and the coordination number of the metal M.

11. Blend according to one or more of Claims 6 to 10, **characterised in that** a further structural unit is a unit of the following formula (XI) 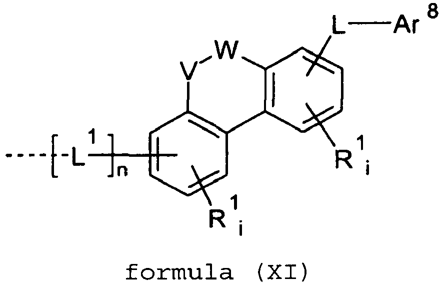 where the dashed line represents the connection to the polymer backbone,
the non-specific bonds which end in the centre of the aromatic rings indicate that the symbols R¹, L and L¹ may each sit at each of the free positions of the aromatic rings, the symbols R¹, L and L¹ and the indices i and n have the same meanings as in the above claims, and the other symbols used have the following meanings:
V and W are selected, independently of one another, from the group from C(Ar³)₂, C(R⁵)₂, Si(Ar³)₂, Si(R⁵)₂, Ge(Ar³)₂, Ge(R⁵)₂, C=O, O, S, Se, N(Ar⁴), N(R⁵), P(Ar⁴), P(R⁵), P=O(Ar³), P=O(R⁵), B and (R⁵)₂CO;
Ar⁸ is a mono- or polycyclic, aromatic or heteroaromatic ring system having 5 to 60 aromatic ring atoms, which may be substi-tuted by one or more radicals R¹;
where the symbols R⁵, Ar³ and Ar⁴ have the same meanings as defined in the above claims.

12. Blend according to one of the preceding claims, **characterised in that** the at least one host molecule is selected from the group consisting of
a) carbazole compounds of the general formula (XIII) 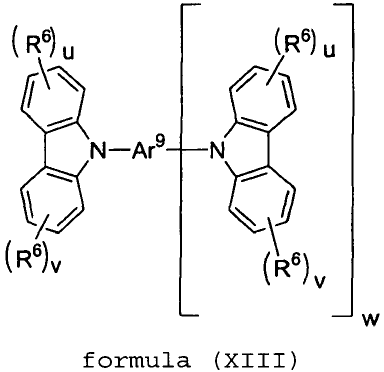 where the following applies to the symbols and indices used:
Ar⁹ is on each occurrence an aromatic or heteroaromatic ring system having 5 to 60 aromatic ring atoms, which may be substi-tuted by one or more radicals R⁶;
R⁶ is on each occurrence, identically or differently, H, D, F, Cl, Br, I, N(Ar¹⁰)₂, CN, NO₂, Si(R⁷)₃, B(OR⁷)₂, C(=O)Ar¹⁰, P (=O) (Ar¹⁰)₂, S(=O)Ar¹⁰, S(=O)₂Ar¹⁰, -CR⁷=CR⁷(Ar¹⁰), OSO₂R⁷, a straight-chain alkyl, alkoxy or thioalkoxy group having 1 to 40 C atoms or a branched or cyclic alkyl, alkoxy or thioalkoxy group having 3 to 40 C atoms, each of which may be substi-tuted by one or more radicals R⁷, where one or more non-adjacent CH₂ groups may be replaced by R⁷C=CR⁷, C=C, Si(R⁷)₂, Ge(R⁷)₂, Sn(R⁷)2, C=O, C=S, C=Se, C=NR⁷, P(=O)(R⁷), SO, SO₂, NR⁷, O, S or CONR⁷ and where one or more H atoms may be replaced by F, Cl, Br, I, CN or NO₂, or an aromatic or hetero-aromatic ring system having 5 to 60 aro-matic ring atoms, which may in each case be substituted by one or more radicals R⁷, or an aryloxy or heteroaryloxy group having 5 to 60 aromatic ring atoms, which may be substituted by one or more radicals R⁷, or a combination of these systems; two or more substituents R⁶ and/or R⁷ here may also form a mono or polycyclic aliphatic or aro-matic ring system with one another;
Ar¹⁰ is on each occurrence, identically or differently, an aromatic or heteroaromatic ring system having 5 to 60 aromatic ring atoms, which may be substituted by one or more radicals R⁷;
R⁷ is on each occurrence, identically or differently, H, D or an aliphatic, aromatic and/or heteroaromatic hydrocarbon radical having 1 to 20 C atoms; or an aromatic or heteroaromatic ring system having 5 to 60 aromatic ring atoms, which may be substitu-ted by one or more radicals R;
R is on each occurrence, identically or differently, H, D, N(Ar¹⁰)₂, a straight-chain alkyl group having 1 to 5 C atoms or branched alkyl group having 3 to 5 C atoms, where in each case one or more non-adjacent CH₂ groups may be replaced by -R⁸C=CR⁸-, where R⁸ is as defined below, or -O- and where one or more H atoms may be replaced by F, or an aryl group having 6 to 16 C atoms or heteroaryl group having 2 to 16 C atoms or a spirobifluorene group, each of which may be substituted by one or more radicals R⁷, or a combination of two of these systems; two or more substituents R⁷ here may also form a mono- or polycyclic, aliphatic, aromatic or heteroaromatic ring system with one another;
u is on each occurrence, identically or dif-ferently, 0, 1, 2, 3 or 4;
v is on each occurrence, identically or dif-ferently, 0, 1, 2, 3 or 4; and
w is 1, 2, 3, 4 or 5; and/or
b) neutral compounds of the general formulae (XIV) or (XV) 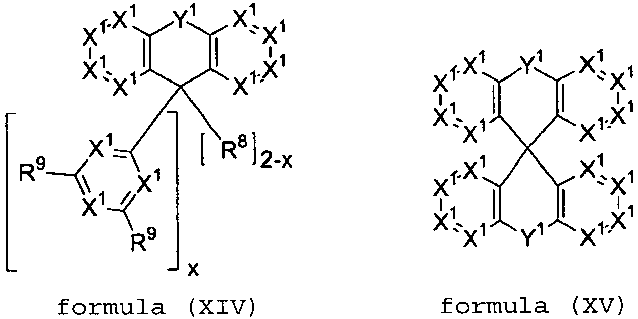 where the following applies to the symbols and indices used:
X¹ is on each occurrence, identically or differently, CR⁸; or two directly adjacent groups X¹ stand for a unit of the following formula (XVI), 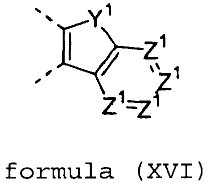
where the dashed bonds indicates the linking of the unit to the adjacent C atoms;
Y¹ is on each occurrence, identically or differently, a single bond or a group selected from C(R⁸)₂, C(=C(R₈)₂), Si(R⁸)₂, C(R⁸)₂-C(R⁸)₂, or CR⁸=CR⁸;
Z¹ is on each occurrence, identically or differently, CR⁸;
R⁸ is on each occurrence, identically or differently, H, D, a straight-chain alkyl, alkenyl or alkynyl group having 1 to 40 C atoms or a branched or cyclic alkyl, alkenyl or alkynyl group having 3 to 40 C atoms, each of which may be substituted by one or more radicals R¹⁰, or an aromatic or heteroaromatic ring system having 5 to 60 aromatic ring atoms, which may in each case be substituted by one or more radicals R⁹, or a combination of these systems; two or more adjacent substituents R⁸ here may also form a mono- or polycyclic, aliphatic or aromatic ring system with one another; or a unit of the general formula (XVII) 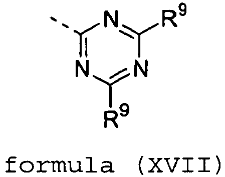
where the dashed bonds indicate the linking of the unit to the adjacent C atoms;
R⁹ is on each occurrence, identically or differently, H, D or an aromatic or hetero-aromatic ring system having 5 to 60 aro-matic ring atoms, which may be substituted by one or more radicals R⁸;
R¹⁰ is on each occurrence, identically or differently, H, D or an aliphatic, aromatic and/or heteroaromatic hydrocarbon radical having 1 to 20 C atoms, in which, in addi-tion, H atoms may be replaced by F; two or more adjacent substituents R¹⁰ here may also form a mono- or polycyclic, aliphatic or aromatic ring system with one another; and
x is 1 or 2; and/or
c) neutral compounds of the general formula (XXX) 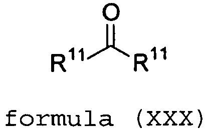 where
R¹¹ an aromatic or heteroaromatic ring system having 5 to 60 aromatic ring atoms, which may in each case be substituted by one or more radicals R⁹, or a combination of these systems; two or more adjacent sub-stituents R¹⁰ here may also form a mono- or polycyclic, aliphatic or aromatic ring sys-tem with one another; or a unit of the gen-eral formula (XXXI) 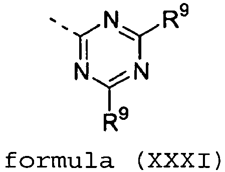
where the dashed bonds indicate the linking of the unit to the C atom of the keto group.

13. Blend according to one of the preceding claims, **characterised in that**
a) the at least one host molecule has electron-transporting functionality and is selected from the group consisting of the compounds depicted below 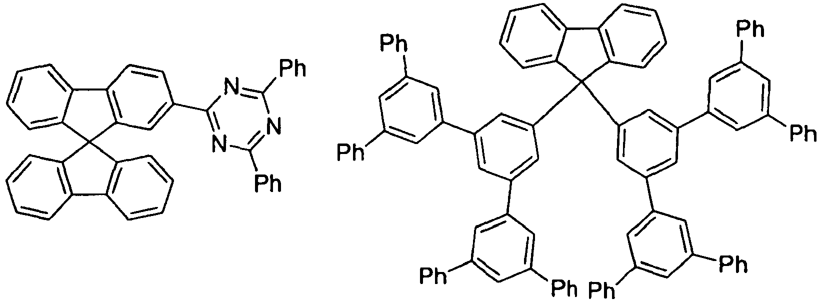
b) and/or the at least one host molecule has hole-transporting functionality and is selected from the group consisting of the compounds depicted below

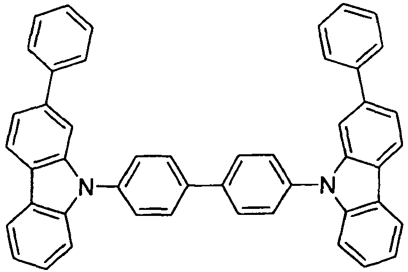

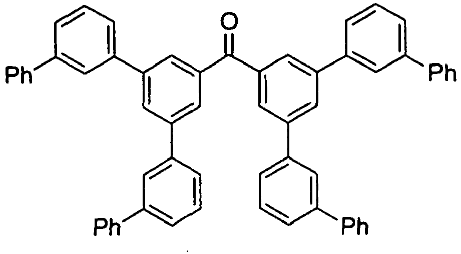

14. Blend according to one or more of the preceding claims, **characterised in that** the emitter molecule is a compound of the formulae (21) to (24), 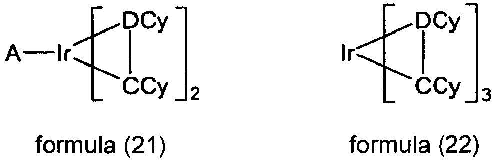 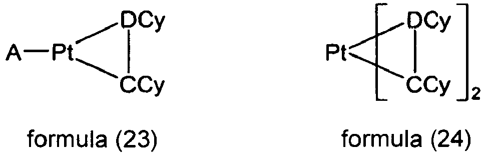 where the following applies to the symbols used:
DCy is, identically or differently on each occurrence, a cyclic group which contains at least one donor atom, preferably nitro-gen, carbon in the form of a carbene or phosphorus, via which the cyclic group is bonded to the metal, and which may in turn carry one or more substituents selected from the group consisting of R¹² or CN, borane radicals or silyl radicals, where R¹² is selected from the group consisting of H, D or an aliphatic or aromatic hydro-carbon radical having 1 to 20 C atoms; the groups DCy and CCy are connected to one another via a covalent bond;
CCy is, identically or differently on each occurrence, a cyclic group which contains a carbon atom via which the cyclic group is bonded to the metal and which may in turn carry one or more substituents selected from the group consisting of H, D, F, CN, secondary or tertiary amines, a straight-chain, branched or cyclic alkyl, alkoxy or thioalkoxy group having 1 to 40 C atoms, or an aromatic or heteroaromatic ring system having 1 to 60 C atoms;
A is, identically or differently on each occurrence, a monoanionic, bidentate-che-lating ligand, preferably a diketonate ligand; and
R¹² is on each occurrence, identically or dif-ferently, H, D, F, CN, N(R¹³)₂, a straight-chain, branched or cyclic alkyl, alkoxy or thioalkoxy group having 1 to 40 C atoms, which may be substituted by R¹⁴ or may also be unsubstituted, where one or more non-adjacent CH₂ groups may be replaced by - R¹⁵C=CR¹⁵-, -C=C-, Si(R¹⁵)₂, Ge(R¹⁵)₂, Sn(R¹⁵)₂, C=O, C=S, C=Se, C=NR¹⁵, -O-, -S-, -NR¹⁵ or -CONR¹⁵- and where one or more H atoms may be replaced by F, Cl, Br, I, CN or NO₂, or an aromatic or heteroaromatic ring system having 1 to 60 C atoms, which may be substituted by one or more radicals R¹⁴, where two or more substituents R¹² may also, together with the atoms to which they are bonded, form a mono- or polycyclic, aliphatic or aromatic ring system with one another; where at least one group R¹² has a bond to a further structural unit of the polymer;
R¹³ is on each occurrence, identically or dif-ferently, a straight-chain, branched or cyclic alkyl or alkoxy group having 1 to 22 C atoms, in which, in addition, one or more non-adjacent C atoms may be replaced by -R¹⁵C=CR¹⁵-, -C=C-, Si(R¹⁵)₂, Ge(R¹⁵)₂, Sn(R¹⁵)₂, -NR¹⁵-, -O-, -S-, -CO-O-, -O-CO-O-, where, in addition, one or more H atoms may be replaced by fluorine, an aryl, heteroaryl or aryloxy group having 1 to 40 C atoms, which may also be substituted by one or more radicals R¹⁴, or OH or N(R¹⁴)₂;
R¹⁴ is on each occurrence, identically or dif-ferently, R¹⁵ or CN, B(R¹⁵)₂ or Si(R¹⁵)₃;
R¹⁵ is on each occurrence, identically or dif-ferently, H, D or an aliphatic or aromatic hydrocarbon radical having 1 to 20 C atoms.

15. Blend according to one of the preceding claims, **characterised in that** the proportion of the emitter molecule in the mixture is 0.1 to 40% by weight.

16. Blend according to one of the preceding claims, **characterised in that**
a) the structural unit in the side chains of the at least one polymer or copolymer has electron-transporting functionality and the at least one host molecule has hole-transporting functionality, or
b) the structural unit in the side chains of the at least one polymer or copolymer has hole-transporting functionality and the at least one host molecule has electron-transporting functionality.

17. Blend according to one of the preceding claims, **characterised in that** the polymer backbone is a polyethylene structure.

18. Formulation comprising a blend according to one of the preceding claims, and at least one further component.

19. Formulation according to the preceding claim, **characterised in that** the at least one further component is selected from the group consisting of solvents, where the formulation in this case is preferably in the form of a solution, dispersion, suspension or slurry; light stabilisers; UV stabilisers; flameproofing agents; fillers and combinations thereof.

20. Compound of the following formula (Ia) 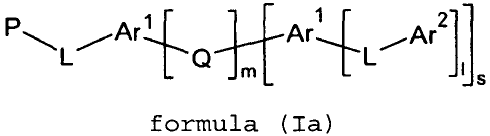 in which the symbols and indices used have the same meanings as in the above claims, and the symbol P is a polymerisable group.

21. Electronic device comprising an anode, a cathode and a layer, arranged between anode and cathode, comprising a blend according to one of Claims 1 to 17 or a formulation according to one of Claims 18 to 19.

22. Electronic device according to the preceding claim, comprising a layer, arranged between the cathode and the layer comprising the blend, comprising a conductive polymer, in particular PEDOT:PSS.

23. Electronic device according to the preceding claim, comprising a hole-injection layer, in particular comprising an arylamine polymer, arranged between the conductive polymer and the layer comprising the blend.

24. Electronic device according to one of Claims 22 to 23, **characterised in that**
a) the cathode is formed from a semiconducting mixed oxide, in particular ITO (indium tin oxide), and/or
b) the anode is formed from metals, in particular barium, aluminium and/or combinations or alloys thereof.

25. Electronic device according to one of Claims 22 to 24, **characterised in that**
a) the anode is applied to a substrate, in particular to a glass or plastic substrate, which is arranged on the side of the anode facing away from the layer comprising the blend, and/or
b) the cathode is provided with a cover glass or a transparent plastic, which is arranged on the side of the cathode facing away from the layer comprising the blend.

26. Electronic device according to one of Claims 22 to 25, **characterised in that** the layer thickness
a) of the layer comprising the blend is from 10 to 1000 nm, preferably from 30 to 300 nm, particularly preferably from 50 to 110 nm,
b) of the cathode is from 3 to 300 nm, preferably from 3 to 160 nm,
c) of the layer comprising the conductive polymer is from 10 to 500 nm, preferably from 20 to 200 nm, particularly preferably from 60 to 80 nm, and/or
d) of the hole-injection layer is from 5 to 500 nm, preferably from 10 to 100 nm, particularly preferably from 10 to 30 nm.

27. Electronic device according to one of Claims 22 to 26, **characterised in that** the electronic device is selected from the group consisting of organic electroluminescent devices, in particular OLEDs or PLEDs, organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs), organic light-emitting electrochemical cells (OECs) or organic laser diodes (O-lasers).

28. Use of a blend according to one of Claims 1 to 17 and/or a formulation according to one of Claims 18 to 19 for electronic devices, in particular electronic devices, selected from the group consisting of organic electroluminescent devices, in particular OLEDs or PLEDs, organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs), organic light-emitting electrochemical cells (OECs) or organic laser diodes (O-lasers).

## Revendications

1. Mélange comprenant :
a) au moins un polymère ou un copolymère ou une mixture d'une pluralité de polymères et/ou de copolymères, dans lequel l'au moins un polymère ou un copolymère contient au moins une unité structurelle de la formule (I) qui suit dans les chaînes latérale : 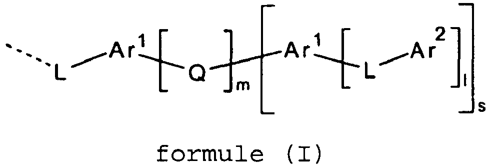 formule dans laquelle la ligne en pointillés représente la connexion sur l'ossature du polymère ou du copolymère, et les autres symboles et indices qui sont utilisés présentent les significations qui suivent :
L est, pour chaque occurrence, de manière identique ou différente, une unique liai-son covalente ou un groupe alkylène en chaîne droite qui comporte 1 à 20 atome(s) de C ou un groupe alkylène ramifié ou cyclique qui comporte 3 à 20 atomes de C, dont chacun peut être substitué par un radical ou plusieurs radicaux R¹, où un ou plusieurs groupe(s) CH₂ non adjacents peut/peuvent être remplacé(s) par R²C=CR², C=C, Si(R²)₂, Ge(R²)₂, Sn(R²)₂, C=O, C=S, C=Se, C=NR², P(=O)(R²), SO, SO₂, NR², O, S ou CONR² et où un ou plusieurs atome(s) de H peut/peuvent être remplacé(s) par F, Cl, Br, I, CN ou NO₂, de façon préférable une unique liaison covalente ;
Ar¹ est, pour chaque occurrence, de manière identique ou différente, un sys-tème de cycle aromatique ou hétéroaroma-tique divalent, monocyclique ou poly-cyclique qui comporte 5 à 60 atomes de cycle aromatique, lequel peut être substi-tué par un radical ou plusieurs radicaux R¹;
Ar² est, pour chaque occurrence, de manière identique ou différente, un sys-tème de cycle aromatique ou hétéroaroma-tique monocyclique ou polycyclique qui comporte 5 à 60 atomes de cycle aroma-tique, lequel peut être substitué par un radical ou plusieurs radicaux R¹ ;
Q est une unité qui est sélectionnée parmi le groupe qui est constitué par un groupe -X(=A)-, où A = O, S, Se ou Te, et des systèmes de cycle aromatique monocyclique ou polycyclique qui comportent 6 à 60 atomes de carbone aromatique ou des sys-tèmes de cycle hétéroaromatique mono-cyclique ou polycyclique qui comportent 2 à 50 atomes de carbone aromatique ;
m est 0, 1, 2 ou 3, de façon préférable 0 ou 1 ;
l est 0, 1, 2 ou 3 ;
s est 1 dans le cas où Q = -X(=A)- ; est 1 à 5, de façon préférable 1 à 3, dans le cas où Q est sélectionné parmi le groupe qui est constitué par des systèmes de cycle aromatique monocyclique ou polycyclique qui comportent 6 à 60 atomes de carbone aromatique ou des systèmes de cycle hété-roaromatique monocyclique ou polycyclique qui comportent 2 à 50 atomes de carbone aromatique ; et est 1 ou 2 dans le cas où m = 0 ;
R¹ est, pour chaque occurrence, de manière identique ou différente, D, F, Cl, Br, I, N(Ar³)₂, CN, NO₂, Si(R²)₃, B(OR²)₂, C(=O)Ar³, P(=O)(Ar³)₂, S(=O) Ar³, S(=O)₂Ar³, -CR²=CR²(Ar³), un système de cycle aroma-tique ou hétéroaromatique monocyclique ou polycyclique qui comporte 5 à 60 atomes de cycle aromatique, tosylate, triflate, OSO₂R², un groupe alkyle, alcoxy ou thio-alcoxy en chaîne droite qui comporte 1 à 40 atome(s) de C ou un groupe alkyle, alcoxy ou thioalcoxy ramifié ou cyclique qui comporte 3 à 40 atomes de C, dont cha-cun peut être substitué par un radical ou plusieurs radicaux R², où un ou plusieurs groupe(s) CH₂ non adjacents peut/peuvent être remplacé (s) par R²C=CR², C≡C, Si(R²)₂, Ge (R²)₂, Sn(R²)₂, C=O, C=S, C=Se, C=NR², P(=O)(R²), SO, SO₂, NR², O, S ou CONR² et où un ou plusieurs atome(s) de H peut/ peuvent être remplacé(s) par F, Cl, Br, I, CN ou NO₂, ou une combinaison de ces sys-tèmes ; où deux substituants R¹ adjacents ou plus peuvent également être liés l'un à l'autre ou les uns aux autres via une unique liaison covalente ou un groupe divalent Z ;
X est sélectionné parmi le groupe qui est constitué par C, P(Ar⁴), S et SO, de façon préférable C ou P(Ph) ;
R² est, pour chaque occurrence, de manière identique ou différente, un groupe alkyle en chaîne droite qui comporte 1 à 20 atome(s) de C ou un groupe alkyle rami-fié ou cyclique qui comporte 3 à 20 atomes de C, où un ou plusieurs groupe(s) CH₂ non adjacents peut/peuvent être remplacé(s) par NH, O ou S et où un ou plusieurs atome(s) de H peut/peuvent être rempla-cé(s) par F, ou un système de cycle aroma-tique ou hétéroaromatique monocyclique ou polycyclique qui comporte 5 à 20 atomes de cycle aromatique, lequel peut dans chaque cas être substitué par un radical ou plu-sieurs radicaux R³; où deux substituants R² ou plus peuvent également être liés l'un à l'autre ou les uns aux autres via une unique liaison covalente ou un groupe divalent Z ;
R³ est, pour chaque occurrence, de manière identique ou différente, un groupe alkyle en chaîne droite qui comporte 1 à 20 atome(s) de C ou un groupe alkyle rami-fié ou cyclique qui comporte 3 à 20 atomes de C, où un ou plusieurs groupe(s) CH₂ non adjacents peut/peuvent être remplacé(s) par NH, O ou S et où un ou plusieurs atomes de H peut/peuvent être remplacé(s) par F ; où deux substituants R³ ou plus peuvent également être liés l'un à l'autre ou les uns aux autres via une unique liai-son covalente ou un groupe divalent Z ;
Ar³ et Ar⁴ sont, pour chaque occurrence, de manière identique ou différente, un sys-tème de cycle aromatique ou hétéroaroma-tique monocyclique ou polycyclique qui comporte 5 à 60 atomes de cycle aroma-tique, lequel peut être substitué par un radical ou plusieurs radicaux R³ ;
Z représente un groupe divalent -(CR⁴₂)_{q}- ;
q est égal à 1, 2, 3, 4 ou 5 ;
R⁴ est, pour chaque occurrence, de manière identique ou différente, un groupe alkyle en chaîne droite qui comporte 1 à 20 atome(s) de C ou un groupe alkyle rami-fié ou cyclique qui comporte 3 à 20 atomes de C, où un ou plusieurs groupe(s) CH₂ non adjacents peut/peuvent être remplacé(s) par NH, O ou S et où un ou plusieurs atome(s) de H peut/peuvent être rempla-cé(s) par F ;
b) au moins une molécule hôte qui présente une fonctionnalité de transport d'électrons ou de transport de trous, et
c) au moins une molécule d'émetteur.

2. Mélange selon la revendication 1, **caractérisé en ce que** :
Q est sélectionné parmi le groupe qui est cons-titué par -X(=O)- ; 1,3,5-triazylène et/ou des radicaux qui sont dérivés à partir de benzène, naphtalène, anthracène, benzanthra-cène, phénanthrène, benzophénanthrène, pyrène, chrysène, pérylène, fluoranthène, benzofluoranthène, naphtacène, pentacène, benzopyrène, biphényle, biphénylène, terphé-nyle, terphénylène, fluorène, spirobifluo-rène, dihydrophénanthrène, dihydropyrène, tétrahydropyrène, cis- ou trans-indéno-fluorène, cis- ou trans-monobenzoindéno-fluorène, cis- ou trans-dibenzoindéno-fluorène, truxène, isotruxène, spirotruxène, spiroisotruxène, furane, benzofurane, isoben-zofurane, dibenzofurane, thiophène, benzo-thiophène, isobenzothiophène, dibenzothio-phène, pyrrole, indole, isoindole, carbazole, pyridine, quinoline, isoquinoline, acridine, phénanthridine, benzo-5,6-quinoline, benzo-6,7-quinoline, benzo-7,8-quinoline, phéno-thiazine, phénoxazine, pyrazole, indazole, imidazole, benzimidazole, naphtimidazole, phénanthrimidazole, pyridimidazole, pyrazini-midazole, quinoxalinimidazole, oxazole, ben-zoxazole, naphtoxazole, anthroxazole, phén-anthroxazole, isoxazole, 1,2-thiazole, 1,3-thiazole, benzothiazole, pyridazine, benzo-pyridazine, pyrimidine, benzopyrimidine, qui-noxaline, 1,5-diazaanthracène, 2,7-diaza-pyrène, 2,3-diazapyrène, 1,6-diazapyrène, 1,8-diazapyrène, 4,5-diazapyrène, 4,5,9,10-tétraazapérylène, pyrazine, phénazine, phé-noxazine, phénothiazine, fluorubine, naph-tyridine, azacarbazole, benzocarboline, phé-nanthroline, 1,2,3-triazole, 1,2,4-triazole, benzotriazole, 1,2,3-oxadiazole, 1,2,4-oxa-diazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-tri-azine, 1,2,4-triazine, 1,2,3-triazine, tétra-zole, 1,2,4,5-tétrazine, 1,2,3,4-tétrazine, 1,2,3,5-tétrazine, purine, ptéridine, indoli-zine et benzothiadiazole, où le 1,3,5-tri-azylène ou les radicaux peut/peuvent chacun être substitué(s) au niveau de n'importe quelle position souhaitée par un radical ou plusieurs radicaux R¹, R² et/ou R³ et/ou peut/ peuvent être lié(s) au système de cycle aro-matique ou hétéroaromatique via n'importe quelles positions souhaitées ; et
s est 1 dans le cas où Q = -X(=O)- ; est 1 ou 2 dans le cas où Q = 1,3,5-triazylène ; ou est 1, 2, 3, 4 ou 5 dans le cas où Q est sélec-tionné parmi les radicaux qui ont été indi-qués ci-avant.

3. Mélange selon l'une des revendications qui précèdent, **caractérisé en ce que** Ar¹ ou Ar² ou Ar¹ et Ar² est/sont sélectionné(s), pour chaque occurrence, de manière mutuellement indépendante, parmi le groupe qui est constitué par des radicaux qui sont dérivés à partir de benzène, naphtalène, anthracène, benzanthracène, phénanthrène, benzophénanthrène, pyrène, chrysène, pérylène, fluoranthène, benzofluoranthène, naphtacène, pentacène, benzopyrène, biphényle, biphénylène, terphényle, terphénylène, fluorène, spirobifluorène, dihydrophénanthrène, dihydropyrène, tétrahydropyrène, cis- ou trans-indénofluorène, cis- ou trans-monobenzoindénofluorène, cis- ou trans-dibenzoindénofluorène, truxène, isotruxène, spirotruxène, spiroisotruxène, furane, benzofurane, isobenzofurane, dibenzofurane, thiophène, benzothiophène, isobenzothiophène, dibenzothiophène, pyrrole, indole, isoindole, carbazole, pyridine, quinoline, isoquinoline, acridine, phénanthridine, benzo-5,6-quinoline, benzo-6,7-quinoline, benzo-7,8-quinoline, phénothiazine, phénoxazine, pyrazole, indazole, imidazole, benzimidazole, naphtimidazole, phénanthrimidazole, pyridimidazole, pyrazinimidazole, quinoxalinimidazole, oxazole, benzoxazole, naphtoxazole, anthroxazole, phénanthroxazole, isoxazole, 1,2-thiazole, 1,3-thiazole, benzothiazole, pyridazine, benzopyridazine, pyrimidine, benzopyrimidine, quinoxaline, 1,5-diazaanthracène, 2,7-diazapyrène, 2,3-diazapyrène, 1,6-diazapyrène, 1,8-diazapyrène, 4,5-diazapyrène, 4,5,9,10-tétraazapérylène, pyrazine, phénazine, phénoxazine, phénothiazine, fluorubine, naphtyridine, azacarbazole, benzocarboline, phénanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tétrazole, 1,2,4,5-tétrazine, 1,2,3,4-tétrazine, 1,2,3,5-tétrazine, purine, ptéridine, indolizine et benzothiadiazole, dont chacun peut être substitué au niveau de n'importe quelle position souhaitée par un radical ou plusieurs radicaux R¹, R² et/ou R³ et/ou peut être lié au système de cycle aromatique ou hétéroaromatique via n'importe quelles positions souhaitées.

4. Mélange selon l'une des revendications qui précèdent, **caractérisé en ce que** l'unité structurelle de la formule (I) est sélectionnée parmi le groupe qui est constitué par :
a) des unités structurelles qui comportent des substituants de transport d'électrons, des formules générales (II) et/ou (III) qui suivent : 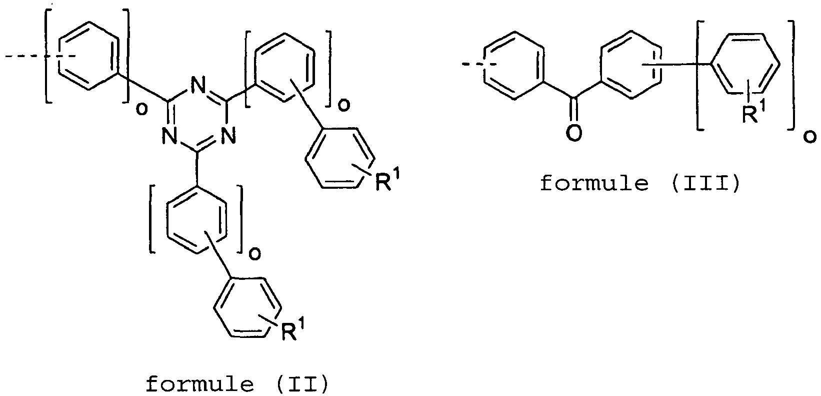
b) et/ou des unités structurelles qui comportent des substituants de transport de trous, des formules générales (IV) et/ou (V) qui suivent : 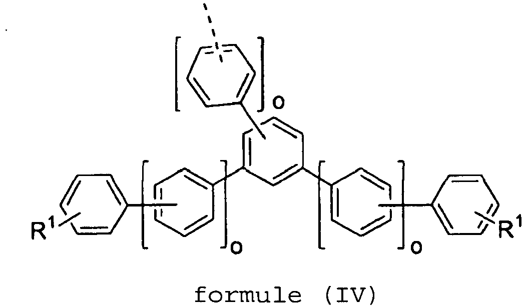 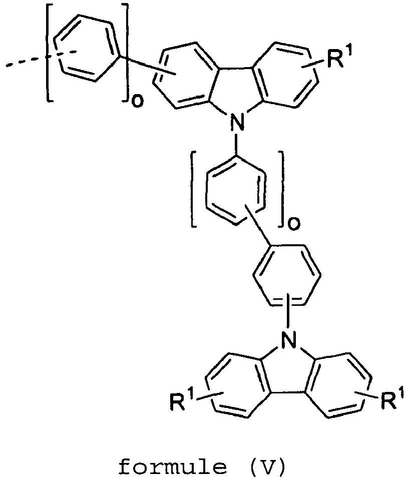
formules dans lesquelles la ligne en pointillés représente la connexion sur l'ossature du polymère ou du copolymère, R¹ présente la signification qui a été donnée ci-avant, et dans chaque cas, de manière mutuellement indépendante, o = 0 ou 1 à 10.

5. Mélange selon l'une des revendications qui précèdent, **caractérisé en ce que** :
a) l'unité structurelle qui comporte des substituants de transport d'électrons est sélectionnée parmi le groupe qui est constitué par les unités structurelles qui suivent : 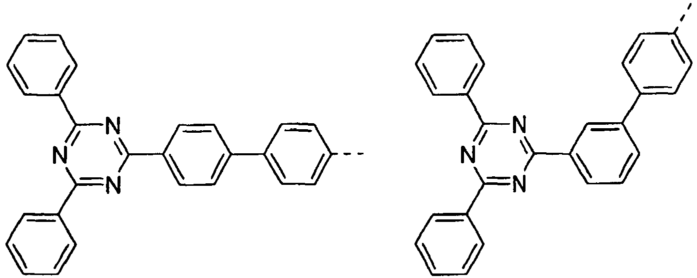 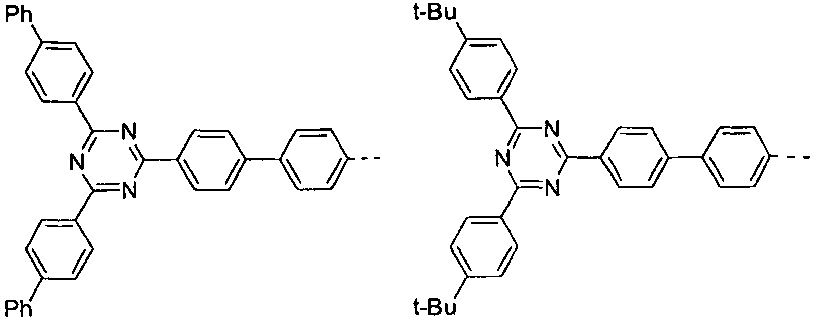 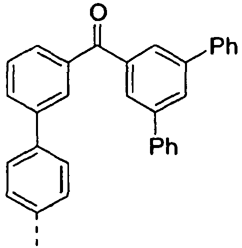
b) et/ou l'unité structurelle qui comporte des substituants de transport de trous est sélectionnée parmi le groupe qui est constitué par les unités structurelles qui suivent : 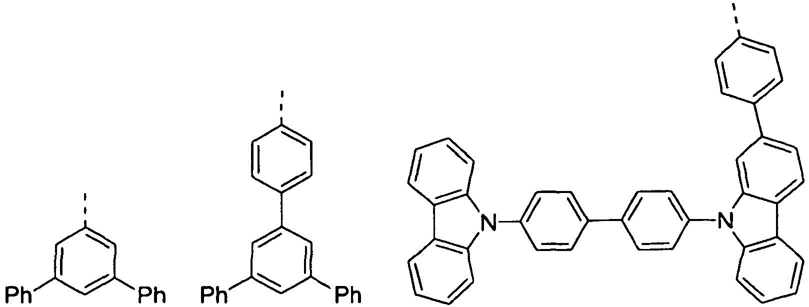
unités structurelles dans lesquelles la ligne en pointillés, dans chaque cas, représente la connexion sur l'ossature du polymère ou du copolymère.

6. Mélange selon l'une des revendications qui précèdent, **caractérisé en ce que**, en plus de la chaîne latérale qui contient l'unité structurelle de la formule (I), il inclut au moins une chaîne latérale supplémentaire qui contient une unité structurelle supplémentaire.

7. Mélange selon la revendication qui précède, dans lequel l'unité structurelle supplémentaire est une unité de la formule (VI) qui suit : 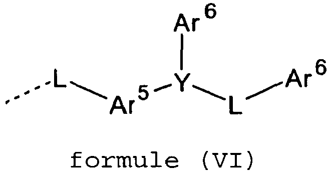 formule dans laquelle la ligne en pointillés représente la connexion sur l'ossature du polymère, et le symbole L présente les mêmes significations que selon les revendications qui précèdent, et les autres symboles qui sont utilisés présentent les significations qui suivent :
Y est une unité trivalente qui est sélectionnée parmi le groupe qui est constitué par N, B, Si(Ar⁴), SiR⁵, Ge(Ar⁴), GeR⁵, P et As ;
Ar⁵ est un système de cycle aromatique ou hétéroaromatique divalent, monocyclique ou polycyclique qui comporte 5 à 60 atomes de cycle aromatique, lequel peut être substitué par un radical ou plusieurs radicaux R¹ ;
Ar⁶ est un système de cycle aromatique ou hétéroaromatique monocyclique ou polycyclique qui comporte 5 à 60 atomes de cycle aroma-tique, lequel peut être substitué par un ra-dical ou plusieurs radicaux R¹ ;
R⁵ est pour chaque occurrence, de manière iden-tique ou différente, H, D, F, Cl, Br, I, N(Ar³)₂, CN, NO₂, Si(R²)₃, B(OR²)₂, C(=O)Ar³, P(=O)(Ar³)₂, S(=O)Ar³, S(=O)₂Ar³, -CR²=CR²(Ar³), tosylate, triflate, OSO₂R², un groupe alkyle, alcoxy ou thioalcoxy en chaîne droite qui comporte 1 à 40 atome(s) de C ou un groupe alkyle, alcoxy ou thioalcoxy rami-fié ou cyclique qui comporte 3 à 40 atomes de C, dont chacun peut être substitué par un radical ou plusieurs radicaux R², où un ou plusieurs groupe(s) CH₂ non adjacents peut/ peuvent être remplacé(s) par R²C=CR², C=C, Si(R²)₂, Ge(R²)₂, Sn(R²)₂, C=O, C=S, C=Se, C=NR², P(=O)(R²), SO, SO₂, NR², O, S ou CONR² et où un ou plusieurs atome(s) de H peut/ peuvent être remplacé(s) par F, Cl, Br, I, CN ou NO₂, ou un groupe aryloxy ou hétéroaryloxy qui comporte 5 à 60 atomes de cycle aroma-tique, lequel peut être substitué par un radical ou plusieurs radicaux R², ou une com-binaison de ces systèmes ; où deux substi-tuants R⁵ adjacents ou plus peuvent également être liés l'un à l'autre ou les uns aux autres via une unique liaison covalente ou un groupe divalent Z ;
où R¹, R², Ar³, Ar⁴ et Z présentent les mêmes significations que celles qui ont été définies selon les revendications qui précèdent.

8. Mélange selon l'une des deux revendications qui précèdent, **caractérisé en ce qu'**une unité structurelle supplémentaire est une unité de la formule (VII) qui suit : 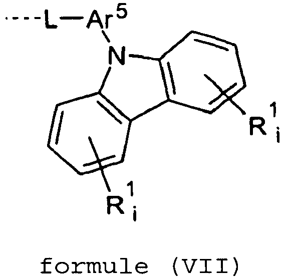 formule dans laquelle la ligne en pointillés représente la connexion sur l'ossature du polymère,
les liaisons non spécifiques qui se terminent au niveau du centre des cycles aromatiques indiquent que le radical R¹ peut être placé au niveau de chacune des positions 1 à 8 du carbazole,
les symboles L, R¹ et Ar⁵ présentent les mêmes significations que selon les revendications qui précèdent, et
l'indice i est égal à 0, 1, 2, 3 ou 4.

9. Mélange selon une ou plusieurs des revendications 6 à 8, **caractérisé en ce qu'**une unité structurelle supplémentaire est une unité de la formule (VIII) qui suit : 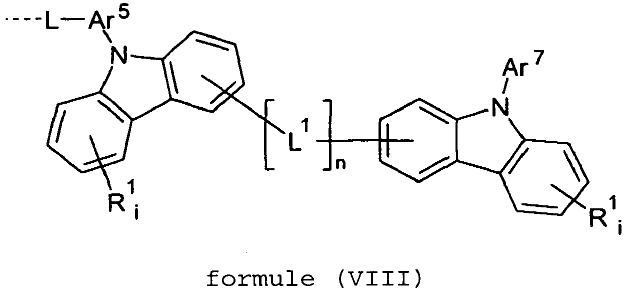 formule dans laquelle la ligne en pointillés représente la connexion sur l'ossature du polymère,
les liaisons non spécifiques qui se terminent au niveau du centre des cycles aromatiques indiquent que les symboles R¹ et L¹ peuvent chacun être placés au niveau de chacune de positions correspondantes 1 à 8 du carbazole,
les symboles L, R¹ et Ar⁵ et l'indice i présentent les mêmes significations que selon les revendications qui ont été mentionnées ci-avant, et les autres symboles et indices qui sont utilisés présentent les significations qui suivent
L¹ est, pour chaque occurrence, de manière identique ou différente, une unique liaison covalente ou un groupe alkylène en chaîne droite qui comporte 1 à 20 atome(s) de C ou un groupe alkylène ramifié ou cyclique qui comporte 3 à 20 atomes de C, dont chacun peut être substitué par un radical ou plu-sieurs radicaux R¹, où un ou plusieurs groupe(s) CH₂ non adjacents peut/peuvent être remplacé (s) par R²C=CR², C≡C, Si(R²)₂, Ge(R²)₂, Sn(R²)₂, C=O, C=S, C=Se, C=NR², P(=O)(R²), SO, SO₂, NR², O, S ou CONR² et où un ou plusieurs atome(s) H peut/peuvent être remplacé(s) par F, Cl, Br, I, CN ou NO₂ ;
n est égal à 0, 1, 2 ou 3, étant entendu que, si n > 1, un maximum d'un L¹ peut être un système de cycle aromatique ou hétéroaroma-tique ;
Ar⁷ est un système de cycle aromatique ou hétéroaromatique monocyclique ou poly-cyclique qui comporte 5 à 60 atomes de cycle aromatique, lequel peut être substi-tué par un radical ou plusieurs radicaux R¹.

10. Mélange selon une ou plusieurs des revendications 6 à 9, **caractérisé en ce qu'**une unité structurelle supplémentaire est une unité de la formule (IX) qui suit : 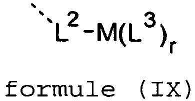 formule dans laquelle la ligne en pointillés représente une connexion sur l'ossature du polymère, et les symboles et indices qui sont utilisés présentent les significations qui suivent :
L² et L³ sont, indépendamment l'un de l'autre, pour chaque occurrence, de manière identi-que ou différente, un ligand monodenté ou polydenté ;
M est un métal de transition, un métal de groupe principal, un lanthanoïde ou un actinoïde ;
r est égal à 0, 1, 2, 3, 4, 5, 6 ou 7, en fonction de la denticité des ligands L² et L³ et du nombre de coordination du métal M.

11. Mélange selon une ou plusieurs des revendications 6 à 10, **caractérisé en ce qu'**une unité structurelle supplémentaire est une unité de la formule (XI) qui suit : 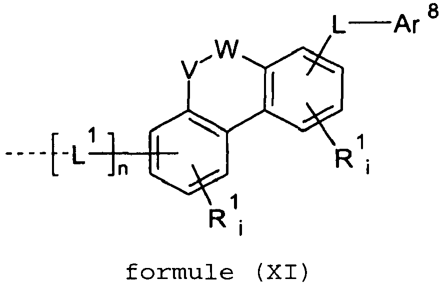 formule dans laquelle la ligne en pointillés représente une connexion sur l'ossature du polymère,
les liaisons non spécifiques qui se terminent au niveau du centre des cycles aromatiques indiquent que les symboles R¹, L et L¹ peuvent chacun être placés au niveau de chacune des positions libres des cycles aromatiques, les symboles R¹, L et L¹ et les indices i et n présentent les mêmes significations que selon les revendications qui ont été mentionnées ci-avant, et les autres symboles qui sont utilisés présentent les significations qui suivent :
V et W sont sélectionnés, indépendamment l'un de l'autre, parmi le groupe qui est consti-tué par C(Ar³)₂, C(R⁵)₂, Si(Ar³)₂, Si(R⁵)₂, Ge(Ar³)₂, Ge(R⁵)₂, C=O, O, S, Se, N(Ar⁴), N(R⁵), P(Ar^{4,}) P(R⁵), P=O(Ar³), P=O(R⁵), B et (R⁵)₂CO ;
Ar⁸ est un système de cycle aromatique ou hétéroaromatique monocyclique ou poly-cyclique qui comporte 5 à 60 atomes de cycle aromatique, lequel peut être substi-tué par un radical ou plusieurs radicaux R¹ ;
où les symboles R⁵, Ar³ et Ar⁴ présentent les mêmes significations que celles qui ont été définies dans les revendications qui ont été mentionnées ci-avant.

12. Mélange selon l'une des revendications qui précèdent, **caractérisé en ce que** l'au moins une molécule hôte est sélectionnée parmi le groupe qui est constitué par :
a) des composés carbazole de la formule générale (XIII) : 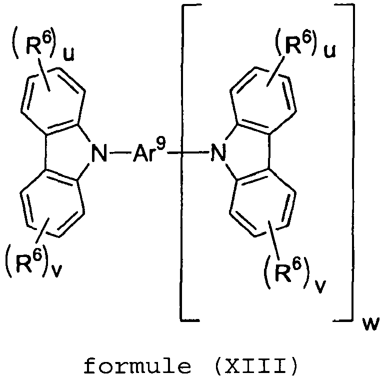 formule dans laquelle ce qui suit s'applique aux symboles et indices qui sont utilisés :
Ar⁹ est, pour chaque occurrence, un sys-tème de cycle aromatique ou hétéro-aromatique qui comporte 5 à 60 atomes de cycle aromatique, lequel peut être substi-tué par un radical ou plusieurs radicaux R⁶ ;
R⁶ est, pour chaque occurrence, de ma-nière identique ou différente, H, D, F, Cl, Br, I, N(Ar¹⁰)₂, CN, NO₂, Si(R⁷)₃, B(OR⁷)₂, C(=O)Ar¹⁰, P(=O)(Ar¹⁰)₂, S(=O)Ar¹⁰, S(=O)₂Ar¹⁰, CR⁷=CR⁷(Ar¹⁰), OSO₂R⁷, un groupe alkyle, alcoxy ou thioalcoxy en chaîne droite qui comporte 1 à 40 atome(s) de C ou un groupe alkyle, alcoxy ou thioalcoxy ramifié ou cyclique qui comporte 3 à 40 atomes de C, dont chacun peut être substi-tué par un radical ou plusieurs radicaux R⁷, où un ou plusieurs groupe(s) CH₂ non adjacents peut/peuvent être remplacé(s) par R⁷C=CR⁷, C≡C, Si(R⁷)₂, Ge(R⁷)₂, Sn(R⁷)₂, C=O, C=S, C=Se, C=NR⁷, P(=O)(R⁷), SO, SO₂, NR⁷, O, S ou CONR⁷ et où un ou plusieurs atome(s) de H peut/peuvent être remplacé(s) par F, Cl, Br, I, CN ou NO₂, ou un système de cycle aromatique ou hétéroaromatique qui comporte 5 à 60 atomes de cycle aromatique, lequel peut, dans chaque cas, être substi-tué par un radical ou plusieurs radicaux R⁷, ou un groupe aryloxy ou hétéroaryloxy qui comporte 5 à 60 atomes de cycle aroma-tique, lequel peut être substitué par un radical ou plusieurs radicaux R⁷, ou une combinaison de ces systèmes ; deux substi-tuants R⁶ et/ou R⁷ ou plus peuvent ici également former un système de cycle ali-phatique ou aromatique monocyclique ou polycyclique l'un avec l'autre ou les uns avec les autres ;
Ar¹⁰ est, pour chaque occurrence, de manière identique ou différente, un système de cycle aromatique ou hétéroaromatique qui comporte 5 à 60 atomes de cycle aromatique, lequel peut être substitué par un radical ou plusieurs radicaux R⁷;
R⁷ est pour chaque occurrence, de manière identique ou différente, H, D ou un radical hydrocarbone aliphatique, aromatique et/ou hétéroaromatique qui comporte 1 à 20 atome(s) de C ; ou un système de cycle aro-matique ou hétéroaromatique qui comporte 5 à 60 atomes de cycle aromatique, lequel peut être substitué par un radical ou plu-sieurs radicaux R ;
R est pour chaque occurrence, de manière identique ou différente, H, D, N(Ar¹⁰)₂, un groupe alkyle en chaîne droite qui comporte 1 à 5 atome(s) de C ou un groupe alkyle ramifié qui comporte 3 à 5 atomes de C, où, dans chaque cas, un ou plusieurs groupe(s) CH₂ non adjacents peut/peuvent être rempla-cé(s) par -R⁸C=CR⁸-, où R⁸ est comme défini ci-dessous, ou -O- et où un ou plusieurs atomes de H peut/peuvent être remplacé(s) par F, ou un groupe aryle qui comporte 6 à 16 atomes de C ou un groupe hétéroaryle qui comporte 2 à 16 atomes de C ou un groupe spirobifluorène, dont chacun peut être substitué par un radical ou plusieurs radi-caux R⁷, ou une combinaison de deux de ces systèmes ; deux substituants R⁷ ou plus peuvent ici également former un système de cycle aliphatique, aromatique ou hétéro-aromatique monocyclique ou polycyclique l'un avec l'autre ou les uns avec les autres ;
u est, pour chaque occurrence, de manière identique ou différente, 0, 1, 2, 3 ou 4 ;
v est, pour chaque occurrence, de manière identique ou différente, 0, 1, 2, 3 ou 4 ; et
w est 1, 2, 3, 4 ou 5 ; et/ou
b) des composés neutres des formules générales (XIV) ou (XV) : 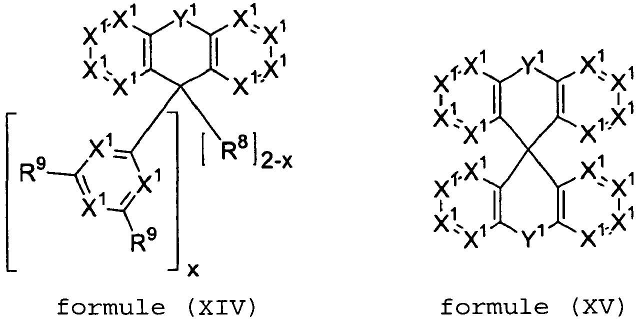 formules dans lesquelles ce qui suit s'applique aux symboles et indices qui sont utilisés
X¹ est, pour chaque occurrence, de manière identique ou différente, CR⁸ ; ou deux groupes directement adjacents X¹ représentent une unité de la formule (XVI) qui suit : 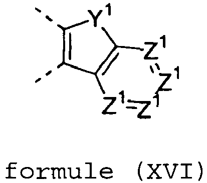
formule dans laquelle les liens en pointillés indiquent la liaison de l'unité sur les atomes de C adjacents ;
Y¹ est, pour chaque occurrence, de manière identique ou différente, une liai-son simple ou un groupe qui est sélectionné parmi C(R⁸)₂, C(=C(R⁸)₂), Si(R⁸)₂, C(R⁸)₂-C(R⁸)₂, ou CR⁸=CR⁸;
Z¹ est, pour chaque occurrence, de manière identique ou différente, CR⁸ ;
R⁸ est, pour chaque occurrence, de manière identique ou différente, H, D, un groupe alkyle, alkényle ou alkynyle en chaîne droite qui comporte 1 à 40 atome(s) de C ou un groupe alkyle, alkényle ou alkynyle ramifié ou cyclique qui comporte 3 à 40 atomes de C, dont chacun peut être substitué par un radical ou plusieurs radi-caux R¹⁰, ou un système de cycle aromatique ou hétéroaromatique qui comporte 5 à 60 atomes de cycle aromatique, lequel peut dans chaque cas être substitué par un radi-cal ou plusieurs radicaux R⁹, ou une combi-naison de ces systèmes ; deux substituants R⁸ adjacents ou plus peuvent ici également former un système de cycle aliphatique ou aromatique monocyclique ou polycyclique l'un avec l'autre ou les uns avec les autres ; ou une unité de la formule géné-rale (XVII) : 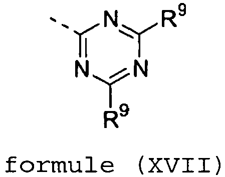
formule dans laquelle les liens en pointillés indiquent la liaison de l'unité sur les atomes de C adjacents ;
R⁹ est, pour chaque occurrence, de manière identique ou différente, H, D ou un système de cycle aromatique ou hétéro-aromatique qui comporte 5 à 60 atomes de cycle aromatique, lequel peut être substi-tué par un radical ou plusieurs radicaux R⁸ ;
R¹⁰ est, pour chaque occurrence, de manière identique ou différente, H, D ou un radical hydrocarbone aliphatique, aroma-tique et/ou hétéroaromatique qui comporte 1 à 20 atome(s) de C, où, en outre, des atomes de H peuvent être remplacés par F ; deux substituants R¹⁰ adjacents ou plus peuvent ici également former un système de cycle aliphatique ou aromatique mono-cyclique ou polycyclique l'un avec l'autre ou les uns avec les autres; et
x est 1 ou 2 ; et/ou
c) des composés neutres de la formule générale (XXX) : 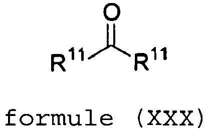 formule dans laquelle :
R¹¹ est un système de cycle aromatique ou hétéroaromatique qui comporte 5 à 60 atomes de cycle aromatique, lequel peut, dans chaque cas, être substitué par un radical ou plusieurs radicaux R⁹, ou une combinai-son de ces systèmes ; deux substituants R¹⁰ adjacents ou plus peuvent ici également former un système de cycle aliphatique ou aromatique monocyclique ou polycyclique l'un avec l'autre ou les uns avec les autres ; ou une unité de la formule géné-rale (XXXI) : 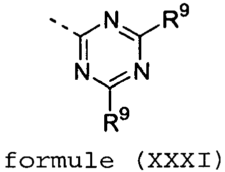
formule dans laquelle les liens en pointillés indiquent la liaison de l'unité sur l'atome de C du groupe céto.

13. Mélange selon l'une des revendications qui précèdent, **caractérisé en ce que** :
a) l'au moins une molécule hôte présente une fonctionnalité de transport d'électrons et est sélectionnée parmi le groupe qui est constitué par les composés qui sont représentés ci-dessous : 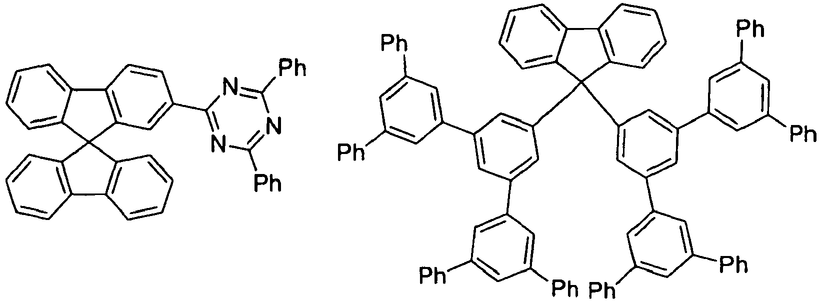
b) et/ou l'au moins une molécule hôte présente une fonctionnalité de transport de trous et est sélectionnée parmi le groupe qui est constitué par les composés qui sont représentés ci-dessous :

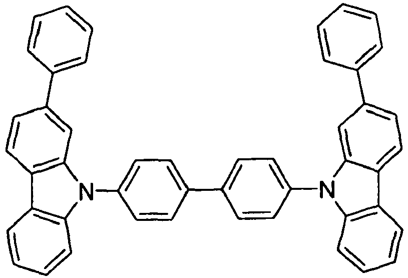

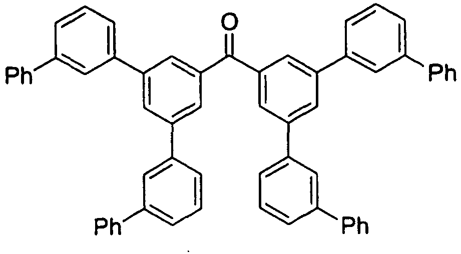

14. Mélange selon une ou plusieurs des revendications qui précèdent, **caractérisé en ce que** la molécule d'émetteur est un composé des formules (21) à (24) : 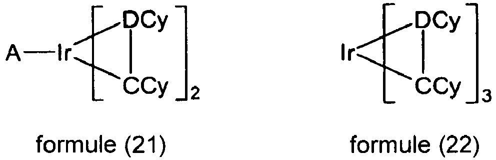 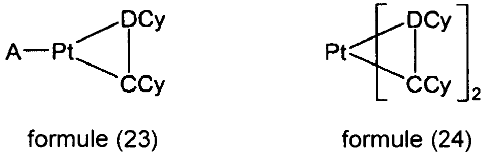 formules dans lesquelles ce qui suit s'applique aux symboles qui sont utilisés :
DCy est, de manière identique ou différente pour chaque occurrence, un groupe cyclique qui contient au moins un atome donneur, de façon préférable un atome d'azote, de car-bone sous la forme d'un carbène ou d'un phosphore, atome donneur via lequel le groupe cyclique est lié au métal, et lequel atome donneur peut à son tour être porteur d'un ou de plusieurs substituant(s) qui est/sont sélectionné(s) parmi le groupe qui est constitué par R¹² ou CN, des radicaux de borane ou des radicaux de silyle, où R¹² est sélectionné parmi le groupe qui est constitué par H, D ou un radical hydro-carbone aliphatique ou aromatique qui com-porte 1 à 20 atome(s) de C ; les groupes DCy et CCy sont connectés l'un à l'autre via une liaison covalente ;
CCy est, de manière identique ou différente pour chaque occurrence, un groupe cyclique qui contient un atome de carbone via lequel le groupe cyclique est lié au métal et qui peut à son tour être porteur d'un ou de plusieurs substituant(s) qui est/sont sélectionné(s) parmi le groupe qui est constitué par H, D, F, CN, des amines secondaires ou tertiaires, un groupe alkyle, alcoxy ou thioalcoxy en chaîne droite, ramifié ou cyclique qui comporte 1 à 40 atome(s) de C, ou un système de cycle aromatique ou hétéroaromatique qui comporte 1 à 60 atome(s) de C ;
A est, de manière identique ou différente pour chaque occurrence, un ligand mono-anionique bidenté-chélatant, de façon pré-férable un ligand dicétonate ; et
R¹² est pour, chaque occurrence, de manière identique ou différente, H, D, F, CN, N(R¹³)₂, un groupe alkyle, alcoxy ou thio-alcoxy en chaîne droite, ramifié ou cyclique qui comporte 1 à 40 atome(s) de C, lequel peut être substitué par R¹⁴ ou peut également être non substitué, où un ou plu-sieurs groupe(s) CH₂ non adjacents peut/ peuvent être remplacé(s) par -R¹⁵C=CR¹⁵-, -C=C-, Si(R¹⁵)₂, Ge(R¹⁵)₂, Sn(R¹⁵)₂, C=O, C=S, C=Se, C=NR¹⁵, -O-, -S-, -NR¹⁵ ou CONR¹⁵- et où un ou plusieurs atome(s) de H peut/ peuvent être remplacé(s) par F, Cl, Br, I, CN ou NO₂, ou un système de cycle aroma-tique ou hétéroaromatique qui comporte 1 à 60 atome(s) de C, lequel peut être substi-tué par un radical ou plusieurs radicaux R¹⁴, où deux substituants R¹² ou plus peu-vent également, en association avec les atomes auxquels ils sont liés, former un système de cycle aliphatique ou aromatique monocyclique ou polycyclique l'un avec l'autre ou les uns avec les autres ; où au moins un groupe R¹² comporte une liaison sur une unité structurelle supplémentaire du polymère ;
R¹³ est, pour chaque occurrence, de manière identique ou différente, un groupe alkyle ou alcoxy en chaîne droite, ramifié ou cyclique qui comporte 1 à 22 atome(s) de C, dans lequel, en outre, un ou plusieurs atome(s) de C non adjacents peut/peuvent être remplacé (s) par -R¹⁵C=CR¹⁵-, -C≡C-, Si(R¹⁵)₂, Ge(R¹⁵)₂, Sn(R¹⁵)₂, NR¹⁵-, -O-, -S-, -CO-O-, -O-CO-O-, où, en outre, un ou plusieurs atome(s) de H peut/peuvent être remplacé(s) par fluor, un groupe aryle, hétéroaryle ou aryloxy qui comporte 1 à 40 atome(s) de C, lequel peut également être substitué par un radical ou plusieurs radi-caux R¹⁴, ou OH ou N(R¹⁴)₂ ;
R¹⁴ est, pour chaque occurrence, de manière identique ou différente, R¹⁵ ou CN, B(R¹⁵)₂ ou Si(R¹⁵)₃;
R¹⁵ est, pour chaque occurrence, de manière identique ou différente, H, D ou un radical hydrocarbone aliphatique ou aromatique qui comporte 1 à 20 atome(s) de C.

15. Mélange selon l'une des revendications qui précèdent, **caractérisé en ce que** la proportion de la molécule d'émetteur dans la mixture est de 0,1 à 40 % en poids.

16. Mélange selon l'une des revendications qui précèdent, **caractérisé en ce que** :
a) l'unité structurelle dans les chaînes latérales de l'au moins un polymère ou copolymère présente une fonctionnalité de transport d'électrons et l'au moins une molécule hôte présente une fonctionnalité de transport de trous, ou
b) l'unité structurelle dans les chaînes latérales de l'au moins un polymère ou copolymère présente une fonctionnalité de transport de trous et l'au moins une molécule hôte présente une fonctionnalité de transport d'électrons.

17. Mélange selon l'une des revendications qui précèdent, **caractérisé en ce que** l'ossature du polymère est une structure polyéthylène.

18. Formulation comprenant un mélange selon l'une des revendications qui précèdent, et au moins un composant supplémentaire.

19. Formulation selon la revendication qui précède, **caractérisée en ce que** l'au moins un composant supplémentaire est sélectionné parmi le groupe qui est constitué par les solvants, où la formulation, dans ce cas, est de manière préférable sous la forme d'une solution, d'une dispersion, d'une suspension ou d'une boue ; les photostabilisants ; les stabiliseurs UV ; les agents d'ignifugation ; les agents de remplissage et des combinaisons afférentes.

20. Composé de la formula (Ia) qui suit : 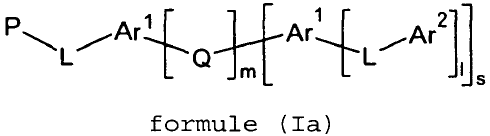 formule dans laquelle les symboles et indices qui sont utilisés présentent les mêmes significations que dans les revendications qui ont été mentionnées ci-avant, et le symbole P est un groupe polymérisable.

21. Dispositif électronique comprenant une anode, une cathode et une couche, qui est agencée entre l'anode et la cathode, comprenant un mélange selon l'une des revendications 1 à 17 ou une formulation selon l'une des revendications 18 à 19.

22. Dispositif électronique selon la revendication qui précède, comprenant une couche qui est agencée entre la cathode et la couche qui comprend le mélange, comprenant un polymère conducteur, en particulier PEDOT:PSS.

23. Dispositif électronique selon la revendication qui précède, comprenant une couche d'injection de trous, en particulier comprenant un polymère arylamine, qui est agencé entre le polymère conducteur et la couche qui comprend le mélange.

24. Dispositif électronique selon l'une des revendications 22 à 23, **caractérisé en ce que** :
a) la cathode est formée à partir d'un oxyde mixte de semiconduction, en particulier à partir d'ITO (oxyde d'indium et d'étain), et/ou
b) l'anode est formée à partir de métaux, en particulier le baryum, l'aluminium et/ou des combinaisons ou des alliages de ceux-ci.

25. Dispositif électronique selon l'une des revendications 22 à 24, **caractérisé en ce que** :
a) l'anode est appliquée sur un substrat, en particulier sur un substrat en verre ou en matière plastique, lequel substrat est agencé sur le côté de l'anode qui est éloigné de la couche qui comprend le mélange et qui lui fait face, et/ou
b) la cathode est munie d'un verre de recouvrement ou d'une matière plastique transparente de recouvrement, lequel verre ou laquelle matière plastique est agencé(e) sur le côté de la cathode qui est éloigné de la couche qui comprend le mélange et qui lui fait face.

26. Dispositif électronique selon l'une des revendications 22 à 25, **caractérisé en ce que** l'épaisseur de couche
a) de la couche qui comprend le mélange va de 10 à 1000 nm, de façon préférable de 30 à 300 nm, de façon particulièrement préférable de 50 à 110 nm,
b) de la cathode va de 3 à 300 nm, de façon préférable de 3 à 160 nm,
c) de la couche qui comprend le polymère conducteur va de 10 à 500 nm, de façon préférable de 20 à 200 nm, de façon particulièrement préférable de 60 à 80 nm, et/ou
d) de la couche d'injection de trous va de 5 à 500 nm, de façon préférable de 10 à 100 nm, de façon particulièrement préférable de 10 à 30 nm.

27. Dispositif électronique selon l'une des revendications 22 à 26, **caractérisé en ce que** le dispositif électronique est sélectionné parmi le groupe qui est constitué par les dispositifs électroluminescents organiques, en particulier les OLED ou les PLED, les circuits intégrés organiques (O-IC), les transistors à effet de champ organiques (O-FET), les transistors à film mince organiques (O-TFT), les transistors à émission de lumière organiques (O-LET), les cellules solaires organiques (O-SC), les détecteurs optiques organiques, les photorécepteurs organiques, les dispositifs à extinction de champ organiques (O-FQD), les cellules électrochimiques à émission de lumière organiques (OEC) ou les diodes laser organiques (O-laser).

28. Utilisation d'un mélange selon l'une des revendications 1 à 17 et/ou d'une formulation selon l'une des revendications 18 à 19 pour les dispositifs électroniques, en particulier les dispositifs électroniques qui sont sélectionnés parmi le groupe constitué par les dispositifs électroluminescents organiques, en particulier les OLED ou les PLED, les circuits intégrés organiques (O-IC), les transistors à effet de champ organiques (O-FET), les transistors à film mince organiques (O-TFT), les transistors à émission de lumière organiques (O-LET), les cellules solaires organiques (O-SC), les détecteurs optiques organiques, les photorécepteurs organiques, les dispositifs à extinction de champ organiques (O-FQD), les cellules électrochimiques à émission de lumière organiques (OEC) ou les diodes laser organiques (O-laser).
